(19) Europäisches Patentamt / European Patent Office / Office européen des brevets

(11) **EP 4 585 556 B1**

(12) **EUROPÄISCHE PATENTSCHRIFT**

(45) Veröffentlichungstag und Bekanntmachung des Hinweises auf die Patenterteilung:
**05.08.2026   Patentblatt 2026/32**

(21) Anmeldenummer: **24151989.1**

(22) Anmeldetag: **15.01.2024**

(51) Internationale Patentklassifikation (IPC):
**B81B 7/00** (2006.01)

(52) Gemeinsame Patentklassifikation (CPC):
**B81B 7/008**; B81B 2201/042

(54) **SCHALTUNG MIT EINEM EFFIZIENZ-OPTIMIERTEN SCHWINGKREIS ZUR ANSTEUERUNG EINES AKTUATORS ZUM ANTRIEB EINER SCHWINGUNGSBEWEGUNG IN EINEM MEMS**

CIRCUIT COMPRISING AN EFFICIENCY-OPTIMIZED RESONANT CIRCUIT FOR CONTROLLING AN ACTUATOR FOR DRIVING A VIBRATION MOVEMENT IN A MEMS

CIRCUIT COMPRENANT UN CIRCUIT OSCILLANT OPTIMISÉ EN TERMES DE RENDEMENT POUR COMMANDER UN ACTIONNEUR POUR ENTRAÎNER UN MOUVEMENT OSCILLANT DANS UN SYSTÈME MICROÉLECTROMÉCANIQUE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(43) Veröffentlichungstag der Anmeldung:
**16.07.2025   Patentblatt 2025/29**

(73) Patentinhaber: **OQmented GmbH**
**25524 Itzehoe (DE)**

(72) Erfinder: **POHL, Leon**
**24223 Schwentinental (DE)**

(74) Vertreter: **Platzöder Patentanwaltsgesellschaft mbH**
**Inselkammerstraße 10**
**82008 Unterhaching (DE)**

(56) Entgegenhaltungen:
• **CAGDASER B ET AL: "Resonant drive: sense and high voltage electrostatic drive using single mems capacitor and low voltage electronics",** IEEE INTERNATIONAL CONFERENCE ON MICRO ELECTRO MECHANICAL SYSTEMS, IEEE, US, 30 January 2005 (2005-01-30), pages 142 - 146, XP010811679, ISBN: 978-0-7803-8732-4, DOI: 10.1109/ MEMSYS.2005.1453887

# EP 4 585 556 B1

## Beschreibung

Die vorliegende Erfindung betrifft eine Schaltung zur Ansteuerung eines Aktuators, insbesondere eines MEMS-Aktuators, zum Antrieb einer Schwingungsbewegung in einem mikro-elektromechanischen System (MEMS), sowie ein damit ausgestattetes MEMS. Die Schaltung weist einen Schwingkreis mit variierbarer Schwingungsperiode auf. Das MEMS kann insbesondere ein Mikroscannersystem mit einem schwingungsfähig angeordneten Ablenkelement (Spiegel) sein, wobei der Aktuator zum Antrieb einer Schwingungsbewegung (Oszillation) des Ablenkelements eingerichtet ist.

Viele MEMS, d. h. Systeme mit mehreren Komponenten, deren Ausmaße typischerweise im Bereich von 1 $\mu$m bis 100 $\mu$m liegen, wobei die MEMS selbst typischerweise jeweils Ausmaße im Bereich von etwa 10 $\mu$m bis zu wenigen Millimetern aufweisen, verfügen über bewegliche mechanische Teile, die unter Nutzung elektrischer Energie antreibbar sind, sodass eine mikroskopisch kleine Maschine als elektromechanisches System vorliegt.

Schwingungsfähig angeordnete Massenelemente von MEMS, insbesondere Ablenkelemente von Mikroscannern, können auf verschiedene Art und Weise zum Schwingen gebracht werden. Dafür ist jedoch stets eine antreibende Kraft erforderlich, welche in der Lage ist, das Ablenkelement (z. B. Spiegelplatte) aus seiner Ruhelage auszulenken. Als eine derartige Kraft liefernde Antriebe für MEMS (insbesondere kleine Mikrofone, Lautsprecher oder Gyroskope, Mikroscanner oder mehrere Mikroscanner aufweisende Mikroscannersysteme) werden typischerweise ein oder mehrere Aktuatoren eingesetzt, die nach einem elektrostatischen, elektromagnetischen, piezoelektrischen, thermischen oder einem anderen Aktuatorprinzip oder nach einer Mischform von zwei oder mehr solcher Aktuatorprinzipien betrieben werden.

Unter dem Begriff "MEMS-Aktuator", wie hierin verwendet, ist insbesondere ein Aktuator zu verstehen, der elektrische und/oder magnetische Energie in mechanische Energie wandeln kann, und/oder umgekehrt, und sich dazu eines MEMS bedient oder selbst ein Bestandteil davon ist, insbesondere als dieses selbst oder als Komponente davon. Ein solcher MEMS-Aktuator kann insbesondere so ausgebildet sein, dass er auf Basis des direkten oder inversen piezoelektrischen Effekts arbeitet. Soweit hierin auf einen "Aktuator" Bezug genommen wird, kann dieser stets insbesondere ein MEMS-Aktuator sein.

Bei Mikroscannern, die in der Fachsprache insbesondere auch als "MEMS-Scanner", "MEMS-Spiegel" oder auch "Mikrospiegel" oder im Englischen insbesondere als "microscanner" bzw. "micro-scanning mirror" oder "MEMS mirror" bezeichnet werden, handelt es sich speziell um MEMS oder genauer um mikro-opto-elektro-mechanische Systeme (MOEMS) aus der Klasse der Mikrospiegelaktoren zur dynamischen Modulation von elektromagnetischer Strahlung, insbesondere von sichtbarem Licht. Je nach Bauart kann die modulierend wirkende Bewegung eines Einzelspiegels translatorisch oder um zumindest eine Achse rotatorisch erfolgen. Im ersten Fall wird eine phasenschiebende Wirkung, im zweiten Fall die Ablenkung der einfallenden elektromagnetischen Strahlung erzielt. Im Weiteren werden Mikroscanner betrachtet, bei denen die modulierend wirkende Bewegung eines Einzelspiegels, zumindest auch, rotatorisch erfolgt. In Abgrenzung zu Spiegelarrays, bei denen die Modulation von einfallendem Licht über das Zusammenwirken einer Vielzahl von einzelnen kleinen Spiegeln auf einem einzigen MEMS-Bauelement erfolgt, wird die Modulation bei Mikroscannern typischerweise über einen einzelnen Spiegel je MEMS-Bauelement (Mikroscanner) erzeugt.

Mikroscanner können somit insbesondere zur Ablenkung von elektromagnetischer Strahlung eingesetzt werden, um mittels eines Ablenkelements ("Spiegel") einen darauf einfallenden elektromagnetischen Strahl bezüglich seiner Ablenkrichtung zu modulieren. Das kann insbesondere dafür genutzt werden, eine Lissajous-Projektion des Strahls in ein Beobachtungsfeld bzw. Projektionsfeld zu bewirken. So lassen sich unter anderem bildgebende, sensorische Aufgaben lösen oder auch Display-Funktionalitäten realisieren. Ferner können solche Mikroscanner auch dazu eingesetzt werden, Materialien in vorteilhafter Weise zu bestrahlen, insbesondere zu deren Bearbeitung. Mögliche andere Anwendungen liegen im Bereich der Beleuchtung oder Ausleuchtung bestimmter offener oder geschlossener Räume oder Raumbereiche mit elektromagnetischer Strahlung, beispielsweise im Rahmen von Scheinwerferanwendungen.

In vielen Fällen weisen Mikroscanner als Ablenkelement eine Spiegelplatte ("Spiegel") auf, die seitlich an elastisch dehnbaren Federn aufgehängt ist. Man unterscheidet einachsige Spiegel, die vorzugsweise nur um eine einzige Achse drehbar aufgehängt sein sollen, von zweiachsigen und mehrachsigen Spiegeln, bei denen Rotationen, insbesondere rotatorische Schwingungsbewegungen, um eine entsprechende Anzahl verschiedener Achsen möglich sind, insbesondere simultan.

Ein Mikroscannersystem zum Ablenken eines elektromagnetischen Strahls kann somit insbesondere einen zweiachsigen Mikroscanner, also einen Mikroscanner mit zwei verschiedenen nicht-parallelen, insbesondere zueinander orthogonalen, Schwingungsachsen oder eine Kombination von mehreren einzelnen, insbesondere zwei, einachsigen Mikroscannern aufweisen, die so angeordnet sind, dass der einfallende Strahl nacheinander durch die verschiedenen einzelnen Mikroscanner des Mikroscannersystems abgelenkt werden kann um ein zweidimensionales Ablenkungsmuster, insbesondere eine Lissajous-Figur, zu erzeugen. Bei einem Mikroscannersystem mit einer Kombination aus zwei oder drei einachsigen Mikroscannern können deren nicht parallele Schwingungsachsen insbesondere paarweise orthogonal zueinander liegen.

Speziell bei sogenannten Lissajous-Mikroscannern bzw. Lissajous-Mikroscannersystemen, werden zwei nicht-parallele, insbesondere zueinander orthogonale Schwingungsachsen simultan, insbesondere in Resonanz, betrieben, um dabei eine Trajektorie der vom Ablenkelement abgelenkten Strahlung in Form einer Lissajous-Figur zu erzeugen. Auf diese Weise lassen sich in beiden Achsen große Amplituden erreichen.

Aus der EP 2 514 211 B1 ist eine solche Ablenkeinrichtung für ein Projektionssystem zum Projizieren von Lissajous-Figuren auf ein Beobachtungsfeld bekannt, die ausgebildet ist, einen Lichtstrahl, insbesondere Laserstrahl, um mindestens eine erste und eine zweite Ablenkachse zur Erzeugung von Lissajous-Figuren umzulenken.

Als Antriebe für MEMS, wie insbesondere kleine Mikrofone, Lautsprecher oder Gyroskope, und insbesondere auch für Mikroscanner bzw. Mikroscannersysteme werden typischerweise elektrostatische, elektromagnetische, piezoelektrische, thermische und andere Aktuatorprinzipien eingesetzt. Speziell bei piezoelektrischen Aktuatoren ("Piezoaktuator") wird dabei ein piezoelektrisches Material in einem durch eine (elektrische) Kapazität erzeugtes elektrisches Feld unter Nutzung des inversen piezoelektrischen Effekts in Abhängigkeit von der Stärke des Felds verformt. Ist das Feld zeitlich variabel, insbesondere aufgrund einer an der Kapazität anliegenden variablen Spannung, so ergibt sich in der Folge eine durch die Feldvariation steuerbare variable Verformung des Piezomaterials, die als kleiner Motor zum Antrieb einer mechanischen Bewegung, speziell bei Mikroscannern einer Schwingungsbewegung des Spiegels, genutzt werden kann.

Insbesondere bei resonant betriebenen, schwingungsfähigen MEMS-Komponenten, wie dem Ablenkelement bei einem Mikroscanner, sind der bzw. die Aktuatoren oftmals jedoch insgesamt nicht stark genug, um die schwingungsfähigen MEMS-Komponente im Rahmen einer einzigen Aktivierung des Aktuators bzw. der Aktuatoren bis hin zu einer im Betrieb angestrebten Zielamplitude statisch auszulenken. Um trotzdem die Zielauslenkung zu erreichen, muss daher der zumindest ein Aktuator, im Falle eines Piezoaktuators dessen piezoelektrische Material, mit einer periodischen Wechselspannung beaufschlagt werden, deren Frequenz zumindest in guter Näherung, idealerweise genau der mechanischen Resonanzfrequenz der schwingungsfähigen MEMS-Komponente entspricht. Daraus resultieren dann kleine, aber immer zum richtigen Zeitpunkt auftretende Antriebskräfte, die nach einer gewissen Zeit in der Lage sind, den durch die schwingungsfähige MEMS-Komponente nebst ihrer Aufhängung oder Lagerung gebildeten mechanischen Oszillator signifikant aufzuschwingen und somit nach und nach mit mechanischer Energie "aufzuladen", bis die Zielamplitude erreicht ist (und ggf. über einen längeren Zeitraum auch gehalten werden kann).

Aus elektrischer Sicht entspricht dieser Antriebsvorgang bei einem kapazitiven Aktuator, insbesondere einem Piezoaktuator, einem ständigen Umladen seines Kondensators. Speziell im Falle eines Mikroscanners mit piezoelektrischem Antrieb beeinflusst die Amplitude der Wechselspannung über dem Kondensator des Piezoaktuators wesentlich den sich einstellenden bzw. im eingeschwungenen Zustand maximal erreichbaren Scanwinkel (Zielamplitude) des Mikroscanners.

Insbesondere dann, wenn ein MEMS in einem Gerät zum Einsatz kommen soll, dem nur eine eng begrenzte elektrische Energiemenge oder elektrische Leistung zur Energieversorgung im Betrieb zur Verfügung steht, wie dies etwa bei einem batteriebetriebenen, insbesondere tragbaren Gerät (etwa bei einem mobilen, insbesondere portablen Endgerät, z. B. Smartphone, oder einem sog. "Wearable", oder einer AR/VR-Brille oder einem in Kleidung integrierten MEMS) meist der Fall ist, sind energieeffiziente Antriebe für die MEMS vorteilhaft oder gar notwendig, um eine möglichst lange, insbesondere eine applikationsbezogen ausreichend lange autarke Nutzungsdauer der Geräte zu ermöglichen.

Zur Reduktion der Leistungsaufnahme der MEMS ist es daher erstrebenswert, die Umladevorgänge am Kondensator des Aktuators so effizient wie möglich zu gestalten. So kann die resultierende Gesamt-Leistungsaufnahme für den Antrieb des MEMS minimiert und insbesondere die Lebensdauer der Batterie(en) bzw. des/der Akkus erhöht werden.

Oftmals liegt zudem das dem Gerät zur Verfügung stehende Spannungsniveau, insbesondere eine Batteriespannung, unterhalb eines von dem Aktuator benötigten Spannungsniveau, sodass eine Spannungswandlung benötigt wird, um es zu erreichen.

Aus FR 2 829 314 A1 sind eine Vorrichtung und ein Verfahren zur Steuerung eines elektronisch gesteuerten Piezoaktuators, insbesondere einer piezoelektrischen Stufenkraftstoffeinspritzdüse, bekannt, die vom elektronischen Einspritzcomputer eines Verbrennungsmotors in einem Kraftfahrzeug gesteuert wird.

Aus US 2005/0029905 A12 ist eine Vorrichtung zur Steuerung eines piezoelektrischen Ultraschallaktors bekannt, die elektronisch von einem Rechner überwacht wird, der eine Gleichstromspannungsquelle steuert. Die Vorrichtung umfasst einen Gleichspannungswandler, der von der Spannungsquelle gespeist wird und zumindest am Ausgang eine Gleichspannung zwischen zwei Endklemmen liefert, zu denen mindestens ein Arm parallel geschaltet ist, der aus zwei abwechselnd steuerbaren, in Reihe geschalteten Brückenschaltern besteht und dessen Mittelpunkt abwechselnd mit den beiden Ausgangsklemmen des Gleichspannungswandlers durch eine Last verbunden ist, die aus mindestens einem mit einer Resonanzinduktivität in Reihe geschalteten Aktor besteht.

Aus WO 03/038918 A2 sind für ultraschall-piezoelektrische Injektoren für die Kraftstoffeinspritzung in einem Kraftfahrzeug-Wärmemotor eine Vorrichtung und ein damit ausführbares Verfahren zur Ansteuerung mindestens eines piezoelektrischen Ultraschallaktors bekannt, der von einem Steuerrechner und einer Gleichspannungsquelle elektronisch überwacht wird. Die Vorrichtung umfasst einen von der Gleichspannungsquelle gespeisten Gleich-/Wechselspannungswandler-Verstärker, der aus einer Brücken- oder Gegentaktschaltung besteht, dessen Hochspannungsausgang mit einem Schwingkreis verbunden ist, der aus dem Aktor und einer Resonanzinduktivität besteht, wobei der Wandler aus einer Verbindung mit mindestens einem Transformator besteht, dessen Primärwicklung über mindestens einen steuerbaren Schalter mit der Spannungsquelle verbunden ist und dessen einzige Sekundärwicklung ein Hochspannungs- und Hochfrequenz-Wechselsignal liefert, das den piezoelektrischen Aktor erregt.

Aus DE 198 54 789 A1 sind ein Verfahren und eine Vorrichtung zum Laden und Entladen eines piezoelektrischen Elements beschrieben. Das Verfahren und die Vorrichtung zeichnen sich dadurch aus, dass der das piezoelektrische Element ladende Ladestrom bzw. der das piezoelektrische Element entladende Entladestrom unter Berücksichtigung der Kapazität des piezoelektrischen Elements eingestellt wird. Dadurch kann erreicht werden, dass das Laden und das Entladen von piezoelektrischen Elementen unter allen Umständen wunschgemäß schnell und weit durchgeführt werden kann.

Aus DE 10 102 286 A1 ist eine Schaltungsanordnung zur Ansteuerung von piezoelektrischen Materialien zur Gewinnung von Hochspannung und der Kurvenformgenerierung bekannt. Sie besteht aus einer Spannungsquelle, einer Spule mit einem elektronischen Schalter und einer Diode, wobei zwischen zwei Anschlusspunkten in Form einer Brückenschaltung mindestens 4 elektronische Schalter angeordnet und zwischen den Brückenabgleichpunkten ein Piezoelement angeschlossen und parallel zu zwei elektronischen Schaltern mindestens je eine Stromsenke angeordnet sind.

Aus DE 10 2013 208 870 A1 ist eine Schaltung zur bipolaren Ladungsrückgewinnung eines piezoelektrischen oder elektrostatischen Antriebs bekannt, bei der ein Piezo-Aktor mit einer Spule in Serie geschaltet ist. Ein erster Anschluss des Piezo-Aktors ist mit einem ersten und einem zweiten Schalter verbunden, wobei ein erster Anschluss der Spule mit einem dritten und einem vierten Schalter verbunden ist. Ein zweiter Anschluss des Piezo-Aktors ist mit einem zweiten Anschluss der Spule verbunden, wobei der erste Schalter und der dritte Schalter mit einem ersten Anschluss einer Spannungsversorgung verbunden sind. Der zweite Schalter und der vierte Schalter sind mit einem zweiten Anschluss der Spannungsversorgung verbunden.

Aus US 2021/0099105 A1 ist eine piezoelektrisch angetriebenen MEMS-Pumpe bekannt.

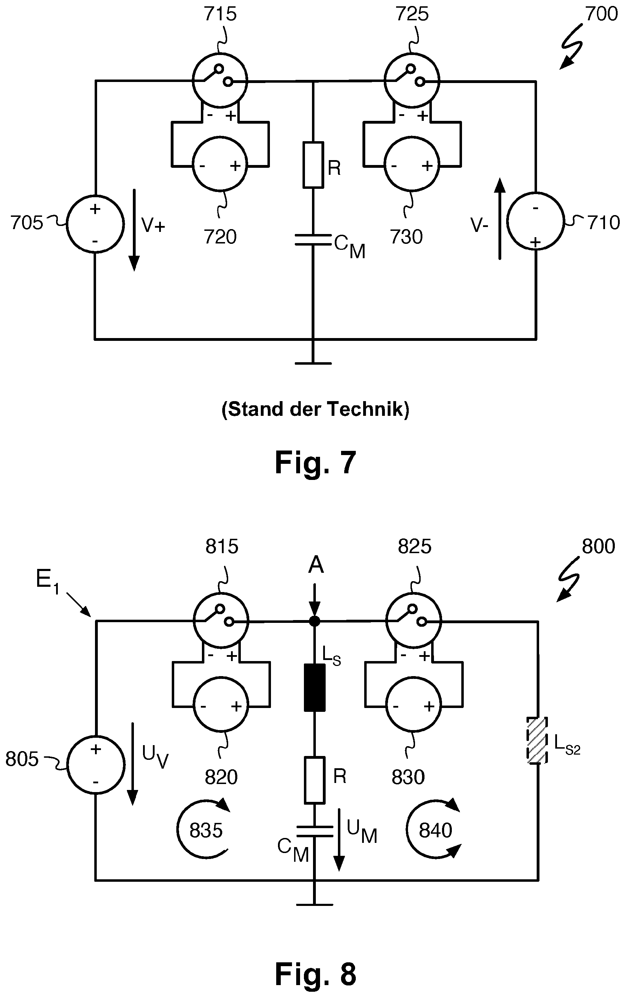

"Resonant drive: sense and high voltage electrostatic drive using single mems capacitor and low voltage electronics", CAGDASER B et al. IEEE INTERNATIONAL CONFERENCE ON MICRO ELECTRO MECHANICAL SYSTEMS, IEEE, US, 30. Januar 2005 (2005-01-30), Seiten 142-146 offenbart eine Schaltung (Figur 7) zur Ansteuerung eines Aktuators zum Antrieb einer Schwingungsbewegung eines Massenelements in einem MEMS ("mirror chip" von Figur 8) wo die Schwingungsfrequenz des Schwingkreises kann so angepasst werden, dass sie unter der Resonanzfrequenz des Schaltkreises liegt.

Es ist eine Aufgabe der vorliegenden Erfindung, eine verbesserte Schaltung zur Ansteuerung eines Aktuators zum energieeffizienten und/oder platzsparenden Antrieb einer Schwingungsbewegung in einem MEMS sowie ein mit einer solchen Schaltung ausgestattetes MEMS, insbesondere Mikroscannersystem, anzugeben.

Die Lösung dieser Aufgabe wird gemäß der Lehre der unabhängigen Ansprüche erreicht. Verschiedene Ausführungsformen und Weiterbildungen der Erfindung sind Gegenstand der Unteransprüche und/oder der nachfolgenden Beschreibung, die der besseren Übersichtlichkeit halber in jeweils von einer Überschrift eingeleitete Abschnitte strukturiert ist, die jedoch nicht als inhaltliche Beschränkung der unter sie fallenden Textabschnitte oder darin beschriebener Figuren aufzufassen ist.

Begrifflichkeiten

Unter dem Begriff "MEMS-Kapazität", wie hierin verwendet, ist eine elektrische Kapazität, insbesondere ein einzelner elektrischer Kondensator, zu verstehen, die bzw. der zumindest anteilig als ein Bestandteil eines MEMS-Aktuators ausgebildet und konfiguriert ist, für den Betrieb des Aktuators eingesetzte elektrische Energie für deren (anteilige) Wandlung in mechanische Energie zumindest temporär zu speichern. Insbesondere kann eine solche MEMS-Kapazität einen Kondensator, insbesondere Plattenkondensator, eines Piezoaktuators mit einem piezoelektrischen Material als Dielektrikum aufweisen. Eine MEMS-Kapazität kann insbesondere als integriertes Bauelement eines MEMS ausgebildet sein, insbesondere so, dass die Elektroden und das Dielektrikum der MEMS-Kapazität jeweils als eine Schicht einer in oder auf einem Halbleitersubstrat erzeugten Schichtfolge bilden.

Unter dem Begriff "Steuerung", wie hierin verwendet, ist insbesondere ein Vorgang oder eine zum Ausführen eines solchen Vorgang konfigurierte Vorrichtung (Steuerungseinrichtung) zu verstehen, der bzw. die eingerichtet ist, eine oder mehrere Komponenten einer Schaltung, darunter insbesondere eine oder mehrere von deren Schalteinrichtungen, im Sinne einer Steuerung (engl. "open-loop") oder Regelung (engl. "closed-loop") über entsprechende Signale anzusteuern. Sie kann insbesondere einen computerprogrammgesteuerten Mikrocontroller oder eine fest verdrahtete Steuerschaltung sein oder aufweisen. Eine solche Steuerungseinrichtung kann insbesondere selbst Teil der Schaltung sein.

Unter dem Begriff "Hochsetzstellerschaltung" (engl. "Boost-Converter" oder "Step-Up-Converter"), wie hierin verwendet, ist eine Form eines Gleichspannungswandlers zu verstehen, der konfiguriert ist, bei der Wandlung eine Eingangsspannung derart in eine Ausgangsspannung zu wandeln, dass Betrag der Ausgangsspannung größer ist als der Betrag der Eingangsspannung. Der Begriff ist nicht auf eine bestimmte Topologie oder Art eines solchen Gleichspannungswandlers beschränkt.

Unter dem Begriff "Schalteinrichtung", wie hierin verwendet, ist eine Schaltung oder Komponente davon zu verstehen, die zumindest eine als Schalter wirkende Schaltung oder Komponente ist bzw. aufweist. Insbesondere kann die Schalteinrichtung einen oder mehrere Schalter aufweisen. Sie kann insbesondere mittels eines oder mehrere Halbleiterbauelemente wie Transistoren oder Dioden implementiert sein. Beispielsweise kann ein einzelner Transistor oder ein CMOS-Gate bei entsprechender Ansteuerung als Schalter wirken. Auch eine Diode kann, insbesondere in Vorwärtsrichtung, als Schalter wirken, wenn eine über ihr anliegende Spannung wahlweise oberhalb ihrer Schwellspannung (in Durchlassrichtung) oder unterhalb ihrer Durchbruchspannung (in Sperrrichtung) liegt.

Unter dem Begriff "kapazitiv-ungepuffert", wie hierin verwendet, ist in Bezug auf einen Strompfad zu verstehen, dass dieser Strompfad nicht über eine Kapazität im Sinne eines Spannungspuffers, insbesondere nicht im Sinne eines Pufferkondensators, gepuffert ist. Es liegt somit (von etwaigen parasitären Kapazitäten abgesehen) kein kapazitives Bauelement (insbesondere Kondensator) zur Pufferung (d. h. Stützung) der Eingangsspannung bzw. des Eingangsstroms eines über den Strompfad angesteuerten Bauelements oder Schaltungsteils, insbesondere des Aktuators, vor. Insbesondere kann eine etwaige verbleibende parasitäre Kapazität des Strompfads im Bereich von kleiner oder gleich 40 pF, insbesondere kleiner oder gleich 10 pF liegen.

Unter dem Begriff "Stromquelle", wie hierin verwendet, ist ein aktiver Zweipol zu verstehen, der an seinen Anschlusspunkten einen elektrischen Strom liefert. Als wesentliche Eigenschaft hängt die Stärke dieses Stroms nur gering ("reale" Stromquelle) oder gar nicht ("ideale" Stromquelle) von der elektrischen Spannung an seinen Anschlusspunkten ab.

Unter dem Begriff "eine auf einen dauerhaft geschlossenen Zustand des Schwingkreises bezogene Resonanzfrequenz", wie hierin verwendet, ist eine Resonanzfrequenz des Schwingkreises zu verstehen, die dieser im eingeschwungenen Zustand aufweist, wenn er dauerhaft, d. h. zumindest über den Einschwingvorgang hinaus, durchgängig geschlossen ist, d. h. insbesondere nicht durch die erste Schalteinrichtung unterbrochen ist. Bei einem idealen Schwingkreis (d. h., wenn ohmsche Widerstände R vernachlässigbar klein sind), beträgt die Resonanzfrequenz $f_0$:

$$f_0 = \frac{1}{2\pi\sqrt{LC}} \qquad\qquad (1)$$

wobei C die Kapazität und L die Induktivität des Schwingkreises sind. Beim realen Schwingkreis ist die Resonanzfrequenz aufgrund der ohmschen Verluste in den Widerständen R je nach Stärke dieser Dämpfung niedriger.

Unter dem Begriff "Aufwärtswandler", wie hierin verwendet, ist ein Spannungswandler beliebiger Art und/oder Topologie zu verstehen, der aus einer Eingangsspannung per Spannungswandlung eine Ausgangsspannung erzeugt bzw. in zumindest einem Betriebsmodus erzeugen kann, sodass der Betrag der Ausgangsspannung größer ist als der Betrag der Eingangsspannung. Ein Aufwärtswandler kann zu diesem Zweck insbesondere einen oder mehrere Hochsetzsteller und/oder eine oder mehrere Ladungspumpen aufweisen.

Die hierin gegebenenfalls verwendeten Begriffe "umfasst", "beinhaltet", "schließt ein", "weist auf", "hat", "mit", oder jede andere Variante davon sollen eine nicht ausschließliche Einbeziehung abdecken. So ist etwa ein Verfahren oder eine Vorrichtung, die eine Liste von Elementen umfasst oder aufweist, nicht notwendigerweise auf diese Elemente beschränkt, sondern kann andere Elemente einschließen, die nicht ausdrücklich aufgeführt sind oder die einem solchen Verfahren oder einer solchen Vorrichtung inhärent sind.

Ferner bezieht sich "oder", sofern nicht ausdrücklich das Gegenteil angegeben ist, auf ein inklusives oder und nicht auf ein exklusives "oder". Zum Beispiel wird eine Bedingung A oder B durch eine der folgenden Bedingungen erfüllt: A ist wahr (oder vorhanden) und B ist falsch (oder nicht vorhanden), A ist falsch (oder nicht vorhanden) und B ist wahr (oder vorhanden), und sowohl A als auch B sind wahr (oder vorhanden).

Die Begriffe "ein" oder "eine", wie sie hier verwendet werden, sind im Sinne von "ein/eine oder mehrere" definiert. Die Begriffe "ein anderer" und "ein weiterer" sowie jede andere Variante davon sind im Sinne von "zumindest ein Weiterer" zu verstehen.

Unter dem Begriff "konfiguriert" oder "eingerichtet" eine bestimmte Funktion zu erfüllen, (und jeweiligen Abwandlungen davon), wie er hier gegebenenfalls verwendet wird, ist zu verstehen, dass eine diesbezügliche Vorrichtung oder Komponente davon bereits in einer Ausgestaltung oder Einstellung vorliegt, in der sie die Funktion ausführen kann oder sie zumindest so einstellbar - d. h. konfigurierbar - ist, dass sie nach entsprechender Einstellung die Funktion ausführen kann. Die Konfiguration kann dabei beispielsweise über eine entsprechende Einstellung von Parametern eines Prozessablaufs oder von Schaltern oder ähnlichem zur Aktivierung bzw. Deaktivierung von Funktionalitäten bzw. Einstellungen erfolgen. Insbesondere kann die Vorrichtung mehrere vorbestimmte Konfigurationen oder Betriebsmodi aufweisen, sodass das Konfigurieren mittels einer Auswahl einer dieser Konfigurationen bzw. Betriebsmodi erfolgen kann.

Die Begriffe "erste/r/s", "zweite/r/s", "dritte/r/s" und ähnliche Begriffe in der Beschreibung und in den Ansprüchen werden zur Unterscheidung zwischen ähnlichen bzw. ansonsten gleich benannten Elementen und nicht unbedingt zur Beschreibung einer sequenziellen, räumlichen oder chronologischen Reihenfolge verwendet. Es versteht sich, dass die so verwendeten Begriffe unter geeigneten Umständen austauschbar sind und dass die hierin beschriebenen Ausführungsformen auch in anderen als den hier beschriebenen oder dargestellten Reihenfolgen funktionieren können.

Schaltung mit Hochsetzsteller ("erste Schaltung")

Ein erster Aspekt der hier vorgestellten Lösung betrifft eine erste Schaltung zur Ansteuerung eines Aktuators, insbesondere MEMS-Aktuators, zum Antrieb einer Schwingungsbewegung zumindest einer beweglichen Komponente eines mikro-elektromechanischen Systems, MEMS. Die erste Schaltung kann insbesondere zur Ansteuerung eines Aktuators zum Antrieb einer Spiegelbewegung in einem Mikroscannersystem eingesetzt werden.

Sie weist eine Hochsetzstellerschaltung mit einer Induktivität (nachfolgend zur Unterscheidung von anderen im Weiteren genannten Induktivitäten als "Booster-Induktivität" bezeichnet, insbesondere eine oder mehrere Spulen aufweisend), eine elektrische MEMS-Kapazität und eine mittels einer Steuerung ansteuerbare Schalteinrichtung auf. Die MEMS-Kapazität ist derart als Bestandteil eines Aktuators ausgebildet, dass sie einen Bestandteil eines elektromechanischen Wandlers des Aktuators bildet, wobei der Wandler konfiguriert ist, in der MEMS-Kapazität gespeicherte elektrische Energie in zumindest eine mechanische Größe zum Antrieb einer Bewegung des Aktuators (insbesondere zumindest einer Komponente davon) zu wandeln. Die Schalteinrichtung ist eingerichtet, in Abhängigkeit von der Steuerung eine erste Schaltungskonfiguration und sequenziell nachfolgend, insbesondere mit der ersten Schaltungskonfiguration mehrfach alternierend, eine zweite Schaltungskonfiguration einzunehmen. Dabei ist (i) in der ersten Schaltungskonfiguration ein erster Strompfad durch die Booster-Induktivität freigeschaltet, um einen von einer Versorgungsspannung gespeisten ansteigenden Stromfluss durch die Booster-Induktivität zu bewirken, und (ii) in der zweiten Schaltungskonfiguration ein (von möglichen parasitären Kapazitäten abgesehen) kapazitiv-ungepufferter zweiter Strompfad zwischen einem ersten Pol der Booster-Induktivität und der MEMS-Kapazität freigeschaltet, um die MEMS-Kapazität mittels eines zumindest anteilig durch die Booster-Induktivität (insbesondere als Stromquelle) gespeisten Stromflusses auf eine erste Spannung aufzuladen, die betragsweise gleich oder höher ist als die Versorgungsspannung.

Die Versorgungsspannung kann insbesondere von der Schaltung selbst erzeugbar oder dieser von extern zuführbar sein.

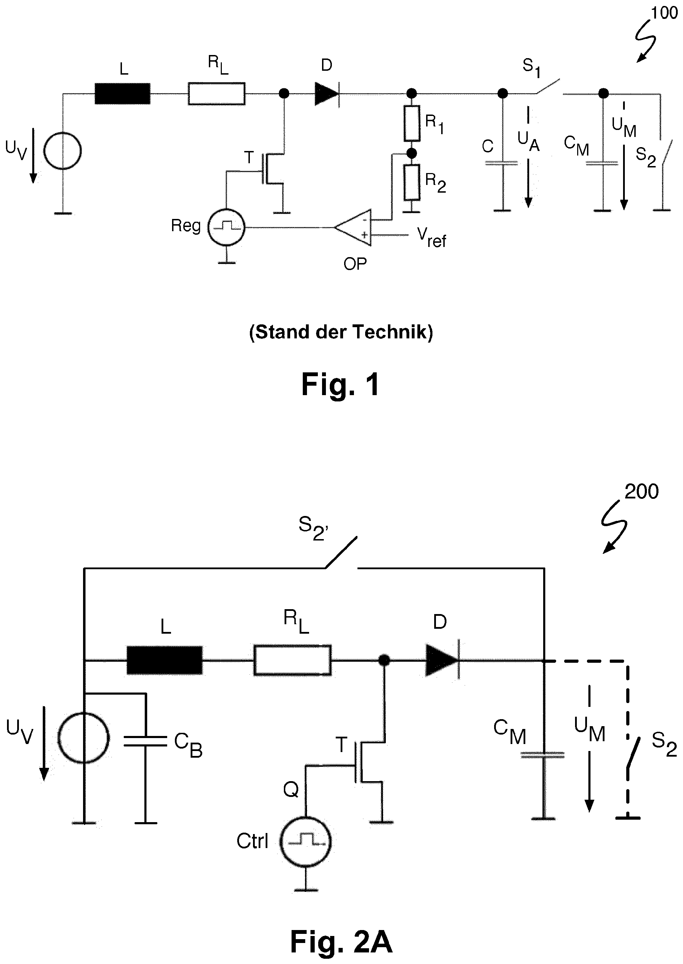

Bei der ersten Schaltung steht die über den zweiten Strompfad zwischen einem ersten Pol der Booster-Induktivität und der MEMS-Kapazität gelieferte elektrische Energie weitgehend unvermindert zur Verfügung, um die MEMS-Kapazität des Aktuators und damit dessen Funktion mittels eines zumindest anteilig durch die Booster-Induktivität gespeisten Stromflusses auf einem gegenüber der Versorgungsspannung hochgesetzten Spannungsniveau zu laden und damit zu versorgen. Das bei herkömmlichen Hochsetzstellern (vgl. Fig. 1 und Figurenbeschreibung dazu) auftretende sog. "Kondensator-Paradoxon" oder "Zwei-Kondensatoren-Paradoxon", welches dort den Wirkungsgrad schon theoretisch auf maximal 50 % begrenzt (vgl. https://en.wikipedia.org/wiki/Two capacitor paradox), kann hier vermieden werden, da hier keine Konstellation mit zwei über einen Schalter parallel schaltbaren Kapazitäten im Spannungsverstärkungspfad des Hochsetzstellers erforderlich sind.

Auf diese Weise ergibt sich bei der ersten Schaltung eine deutlich reduzierte elektrische Leistungsanforderung für die Ansteuerung des Aktuators, sodass die erste Schaltung einschließlich des Aktuators insbesondere auch in Geräten zum Einsatz kommen kann, denen nur eine eng begrenzte elektrische Energiemenge oder elektrische Leistung zur Energieversorgung im Betrieb zur Verfügung steht.

Nachfolgend werden zunächst verschiedene beispielhafte Ausführungsformen der ersten Schaltung beschrieben, die jeweils, soweit dies nicht ausdrücklich ausgeschlossen wird oder technisch unmöglich ist, beliebig miteinander sowie mit den im Weiteren beschriebenen anderen Aspekten der vorliegenden Lösung kombiniert werden können.

Bei einigen Ausführungsformen ist die Steuerung ungeregelt. Es findet folglich keine Regelung im Rahmen der Ansteuerung statt, sondern nur eine reine Steuerung (im Sinne von "open loop") ohne Regelkreis. Dementsprechend kann die erste Schaltung gegenüber einer geregelten Ansteuerung vereinfacht werden, da insbesondere kein Regler und keine Rückkopplung (Regelschleife) erforderlich sind und die dafür benötigten Schaltungskomponenten somit entfallen können. Damit lassen sich insbesondere auch besonders platzsparende Lösungsvarianten implementieren. Dies ist insbesondere deshalb möglich, weil bei einem periodischen Betrieb, d.h. einem periodischen alternierenden Wechsel zwischen den beiden Schaltungskonfigurationen der Schalteinrichtung, die Spannung über der MEMS-Kapazität im Wesentlichen, d.h. in guter Näherung, als eine lineare Funktion der Periodendauer oder genauer der Dauer der ersten Schaltungskonfiguration modelliert werden kann. So kann auch eine reine Steuerung ohne Regelung für eine ausreichend genaue Einstellung der Spannung über der MEMS-Kapazität und somit einer Ansteuerung des Aktuators mit guter Genauigkeit genügen. Zudem entfallen auch mit einer Regelung einhergehende Energieverluste, sodass die Leistungsaufnahme der ersten Schaltung weiter gesenkt und somit ihr Wirkungsgrad bzw. ihre Effizienz weiter gesteigert werden kann.

Bei einigen Ausführungsformen ist die Schalteinrichtung des Weiteren eingerichtet, einen dritten Strompfad wiederholt temporär derart freizuschalten, insbesondere in Abhängigkeit von der Steuerung, dass über diesen dritten Strompfad die MEMS-Kapazität wiederholt, zumindest teilweise, entladen werden kann, um an der MEMS-Kapazität eine ihrer Höhe nach zeitlich variable Versorgungsspannung des elektromechanischen Wandlers zu erzeugen. Das Durchgängigschalten und das dadurch bedingte Entladen können insbesondere periodisch erfolgen. Durch das Entladen lässt sich ein Ladungszustand der MEMS-Kapazität herstellen, der zu einer betragsmäßig niedrigeren Spannung über der MEMS-Kapazität und somit zu einer entsprechend niedrigeren Eingangsspannung am Aktuator führt als im geladenen Ladungszustand (der während der zweiten Konfiguration der Schalteinrichtung erreicht wird). So lässt sich der Aktuator zumindest zwischen zwei Zuständen (geladen/entladen) schalten, die über die elektromechanische Wandlung zu zwei verschiedenen mechanischen Zuständen des Aktuators korrespondieren. Bei einem alternierenden, insbesondere periodischen, Wechsel zwischen den beiden Ladungszuständen lässt sich somit eine korrespondierende, insbesondere periodische, mechanische Bewegung am Aktuator bewirken, die zum Antrieb einer Bewegung, insbesondere Schwingungsbewegung, in einem MEMS (wie einer Spiegelbewegung, insbesondere Spiegeloszillation eines Mikroscannersystems) genutzt werden kann.

Bei einigen Ausführungsformen ist dabei der dritte Strompfad zu einer Pufferkapazität zur Pufferung der Versorgungsspannung geführt, um Ladung von der MEMS-Kapazität bei deren Entladen in die Pufferkapazität zu überführen. So kann die beim Laden der MEMS-Kapazität in diese eingebrachte Ladung zumindest teilweise rückgewonnen und für einen nachfolgenden weiteren Ladevorgang genutzt werden. Auf diese Weise lässt sich die Leistungsaufnahme der ersten Schaltung weiter reduzieren und somit deren Wirkungsgrad und damit Effizienz weiter steigern. In dieser Variante wird der dritte Strompfad, zur Unterscheidung von einem alternativen Strompfad gemäß einer anderen Variante zur Entladung ohne Ladungsrückführung bzw. Pufferung, auch als vierter Strompfad bezeichnet.

Bei einigen Ausführungsformen ist die Schalteinrichtung des Weiteren eingerichtet, insbesondere in Abhängigkeit von der Steuerung, wiederholt und jeweils temporär in einem Zeitraum, in dem der zweite Strompfad nicht freigeschaltet ist, einen vierten Strompfad zwischen der MEMS-Kapazität und einem zum dem ersten Pol elektrisch gegenpoligen zweiten Pol der Booster-Induktivität derart freizuschalten, dass die MEMS-Kapazität dabei auf eine zweite Spannung mit einer zur Polarität der ersten Spannung entgegengesetzten Polarität aufgeladen wird. Auf diese Weise lässt sich ein bipolarer Betrieb ermöglichen, bei dem sich die Polarität über der MEMS-Kapazität ändert, insbesondere alternierend. Dementsprechend können bei Verwendung eines Aktuators, wie eines Piezoaktuators, der polarisationsabhängig arbeitet, verschiedene Aktuatorzustände in Abhängigkeit von, insbesondere im zeitlichen Einklang mit, dem Wechsel der Polarität der Spannung über der MEMS-Kapazität bewirkt werden. Durch einen solchen bipolaren Antrieb mit positiven und negativen Spannungen kann insbesondere zudem - im Vergleich zu einem unipolaren Antrieb - unter Nutzung lediglich einer positiven und einer negativen Spannung die Leistungsaufnahme erneut halbiert werden, wenn die gleiche Spannungsamplitude ($V_{max}$ - $V_{min}$) betrachtet wird.

Bei einigen dieser Ausführungsformen weist die Schaltungseinrichtung auf: (i) einen ersten Schalter, $S_1$, zum Schalten einer elektrischen Verbindung zwischen der Versorgungsspannung und dem zweiten Pol der Booster-Induktivität; (ii) einen mit dem ersten Pol der Booster-Induktivität elektrisch verbundenen zweiten Schalter, $S_2$, zum Durchgängigschalten bzw. Unterbrechen des ersten Strompfads; (iii) einen mit dem ersten Pol der Booster-Induktivität elektrisch verbundenen dritten Schalter, $S_3$, zum Durchgängigschalten bzw. Unterbrechen des zweiten Strompfads; und (iv) einen mit dem zweiten Pol der Booster-Induktivität und der MEMS-Kapazität elektrisch verbundenen vierten Schalter, $S_4$, zum Durchgängigschalten bzw. Unterbrechen des vierten Strompfads. So lässt sich auf sehr effiziente, insbesondere komponenten- und somit platz- und energiesparende Weise unter Verwendung von nur vier Schaltern in der Schalteinrichtung eine im o.g. Sinne bipolare Implementierung der ersten Schaltung erreichen.

Unter dem Begriff "elektrisch verbunden" ist hier eine unmittelbare elektrische Verbindung ohne dazwischenliegenden Schaltungskomponenten (d.h. Bauelemente) oder aber eine mittelbare Verbindung über eine oder mehrere dazwischenliegenden Schaltungskomponenten (d.h. Bauelemente), z.B. Widerstände, zu verstehen, wobei die Verbindung insbesondere die Charakteristik eines (kleinen) Ohm'schen Widerstands R haben kann, z. B. mit $R \leq 10\ \Omega$.

Bei einigen Ausführungsformen weist die Schaltung des Weiteren einen fünften Schalter, $S_5$, zum Durchgängigschalten bzw. Unterbrechen eines zwischen dem zweiten Pol der Induktivität und Masse liegenden Strompfads auf.

Insbesondere kann dabei gemäß einiger der Ausführungsformen die Steuerung konfiguriert sein, die Schaltungseinrichtung schrittweise gemäß der nachfolgenden Sequenz in verschiedene Schaltzustände zu versetzen, wobei die Sequenz wenigstens einmal, vorzugsweise mehrfach, insbesondere periodisch, durchlaufen wird:

(a) $S_1$ und $S_2$ geschlossen, $S_3$ und $S_4$ offen;
(b) $S_1$ und $S_3$ geschlossen, $S_2$ und $S_4$ offen;
(c) $S_2$ und $S_3$ geschlossen, $S_1$ und $S_4$ offen;
(d) $S_1$ und $S_2$ geschlossen, $S_3$ und $S_4$ offen;

(e) $S_2$ und $S_4$ geschlossen, $S_1$ und $S_3$ offen;

(f) $S_2$ und $S_3$ geschlossen, $S_1$ und $S_4$ offen.

Bei einigen dieser Ausführungsformen weist die erste Schaltung eine Pufferkapazität, insbesondere einen Kondensator, zur kapazitiven Pufferung der Versorgungsspannung auf. Die Sequenz weist zudem zusätzlich einen weiteren Schaltzustand (b1) auf, der zwischen den Schaltzuständen (b) und (c) liegt und dadurch gekennzeichnet ist, dass in ihm $S_1$ und $S_4$ geschlossen und $S_2$ und $S_3$ offen sind. So kann beim Entladen der MEMS-Kapazität Ladung aus der MEMS-Kapazität in die Pufferkapazität überführt werden, um für eine weiteren Schaltzyklus zur Verfügung zu stehen, ohne dass die entsprechende Ladungsmenge von der Versorgungsspannungsquelle zur Verfügung gestellt werden muss. So wird auch auf diese Weise die Leistungsaufnahme reduziert und der Wirkungsgrad bzw. die Effizienz der (bipolaren) ersten Schaltung weiter gesteigert.

Bei einigen Ausführungsformen weist die Sequenz zusätzlich (zu den Zuständen (a) bis (f) und optional auch zu (b1)) einen weiteren Schaltzustand (b2) auf, der zwischen den Schaltzuständen (b) und (c) liegt, und dadurch gekennzeichnet ist, dass in ihm $S_2$ und $S_4$ geschlossen und $S_1$ und $S_3$ offen sind. So kann beim Entladen der MEMS-Kapazität Ladung aus der MEMS-Kapazität durch die Booster-Induktivität geleitet werden, um sie für einen weiteren Schaltzyklus bereits zumindest anteilig mit Energie (in ihrem Magnetfeld) zu laden, ohne dass die aus diesem Strom resultierende Energieaufladung der Booster-Induktivität nachfolgend stattdessen von der Versorgungsspannungsquelle zur Verfügung gestellt werden muss. So kann auch auf diese Weise die Leistungsaufnahme reduziert und somit der Wirkungsgrad bzw. die Effizienz der (bipolaren) ersten Schaltung weiter gesteigert werden.

Bei einigen Ausführungsformen weist die Sequenz zusätzlich einen weiteren Schaltzustand (e1) auf, der dem Schaltzustand (g) folgt und dem Schaltzustand (f) vorausgeht und der dadurch gekennzeichnet ist, dass in ihm $S_4$ und $S_5$ geschlossen und $S_1$, $S_2$ und $S_3$ offen sind. Dies ermöglicht eine Rückgewinnung von Energie auch aus negativen Spannungen über der MEMS-Kapazität $C_M$ (anschließend an Schaltzustand (e1)).

Bei einigen Ausführungsformen weist die Steuerung (genauer die entsprechende Steuerungseinrichtung) eine mehrstufige Verzögerungskette und einen Multiplexer zum zeitlich gestaffelten Abgreifen der jeweiligen Ausgangssignale der Stufen der Verzögerungskette auf, um ein zeitlich variables Steuerungssignal zur Ansteuerung der Schalteinrichtung zu erzeugen. Die Verzögerungsglieder der Verzögerungskette können hierbei insbesondere aus Standardzellen oder auch als speziell definierte ("customized") analoge Komponenten oder Schaltungsteile ausgeführt sein, wobei die benötigte Verzögerung der einzelnen Stufen sich aus dem Quotienten der maximal notwendigen Einschaltzeit (Dauer der ersten Schaltungskonfiguration) und der Anzahl der Stufen errechnen lässt. Die analoge Ausführung hätte den Vorteil, dass über eine Einstellung eines Treiberstroms für die Verzögerungsglieder (Stromsteuerung, vgl. "current-starved" Inverter) die Verzögerungszeit jedes einzelnen Verzögerungsgliedes eingestellt werden kann, und somit für beliebige MEMS-Kondensatoren (mit unterschiedlichen Kapazitätswerten und Ausgangsspannungen) optimal einstellbar wäre.

Insbesondere kann gemäß einiger dieser Ausführungsformen die Schalteinrichtung mittels des Steuerungssignals derart ansteuerbar sein, dass mittels des Steuerungssignals ein Umschalten zwischen der ersten Schaltkonfiguration und der zweiten Schaltkonfiguration, oder umgekehrt, bewirkt werden kann.

So lässt sich auf einfache und energieeffiziente Weise eine Steuerung für die Schaltung, insbesondere von deren Schalteinrichtung, realisieren.

Schaltung mit einem pausierbaren effizienzoptimierten Schwingkreis ("zweite Schaltung")

Ein zweiter Aspekt der Lösung betrifft eine zweite Schaltung zur Ansteuerung eines Aktuators, insbesondere MEMS-Aktuators, zum Antrieb einer Schwingungsbewegung eines Massenelements in einem MEMS. Die Ansteuerung kann insbesondere geregelt oder ungeregelt sein.

Diese zweite Schaltung weist auf:

(i) einen elektrischen Schwingkreis, aufweisend:

- eine erste Induktivität (nachfolgend zur Unterscheidung von anderen im Weiteren genannten Induktivitäten als "Schwingkreis-Induktivität" bezeichnet, insbesondere eine oder mehrere Spulen aufweisend),

- eine erste elektrische MEMS-Kapazität,

- einen Ladeanschluss zur temporären Zufuhr von elektrischer Energie von einer schwingkreisexternen Energieversorgung in den Schwingkreis, um die MEMS-Kapazität temporär nachzuladen; und

- eine, insbesondere mittels eines Steuersignals, ansteuerbare erste Schalteinrichtung (nachfolgend auch als "Schwingkreis-Schalter" bezeichnet) zum selektiven Unterbrechen bzw. Schließen des Schwingkreises in Abhängigkeit von einer Ansteuerung der ersten Schalteinrichtung; und

- eine auf einen dauerhaft geschlossenen Zustand des Schwingkreises bezogene Resonanzfrequenz; und

(ii) eine Steuerung zur Ansteuerung der ersten Schalteinrichtung.

Die erste Induktivität ist derart im Schwingkreis angeordnet, dass sie sowohl beim Umladen der ersten MEMS-Kapazität während eines elektrischen Schwingens des Schwingkreises im geschlossenen Zustand der ersten Schalteinrichtung als auch beim temporären Nachladen der ersten MEMS-Kapazität im unterbrochenen Zustand der ersten Schalteinrichtung in einem dabei jeweils stromdurchflossenen und durch die erste MEMS-Kapazität verlaufenden Strompfads des Schwingkreises liegt.

Die Steuerung ist konfiguriert, die erste Schalteinrichtung während einer jeweiligen im geschlossenen Zustand der ersten Schalteinrichtung ablaufenden Schwingungsperiode des Schwingkreises durch eine entsprechende Ansteuerung temporär, insbesondere für ein bestimmten Anteil der Schwingungsperiode, zu einem Zeitpunkt, an dem die Spannung über der ersten MEMS-Kapazität betragsmäßig ein Maximum innerhalb der jeweiligen Schwingungsperiode erreicht, in einen Zustand zu versetzen, in dem sie den Schwingkreis unterbricht, sodass eine tatsächliche Schwingungsfrequenz des Schwingkreises bewirkt wird, die kleiner ist als die Resonanzfrequenz.

Unter dem Begriff "Ladeanschluss" oder "Ladeanschlusspunkt", wie hierin verwendet, kann jegliche Art von Anschluss des Schwingkreises an eine schwingkreisexterne Energieversorgung zu verstehen sein, über die dem Schwingkreis Energie zugeführt wird, um dessen Schwingung damit zu versorgen. Insbesondere kann dieser Anschluss mittels direkter elektrischer Verbindung, induktiv oder kapazitiv ausgestaltet sein, um jeweils Energie in Form von elektrischer und/oder magnetischer Energie in den Schwingkreis einzuspeisen.

Mit der zweiten Schaltung lässt sich die effektive Schwingungsfrequenz des Schwingkreises mittels der ersten Schalteinrichtung variabel einstellen. Das temporäre Unterbrechen des Schwingkreises bewirkt ein dazu korrespondierendes Pausieren der elektrischen Schwingung im Schwingkreis ("pausierter Schwingkreis"), was zu einer effektiven Schwingungsfrequenz unterhalb der Resonanzfrequenz des Schwingkreises (in einem dauerhaft geschlossenen Zustand) führt.

Somit lässt sich die geringere effektive Schwingungsfrequenz erreichen, ohne gemäß der Beziehung (1) (vgl. Abschnitt "Begrifflichkeiten" oben) die Werte der (ersten) MEMS-Kapazität C oder der (ersten) Induktivität L vergrößern zu müssen. Wenn schwingungsfähige Komponenten eines MEMS bezüglich ihrer Schwingungsfrequenz eine bestimmte obere Grenzfrequenz nicht überschreiten können oder sollen, dann lassen sich mithilfe des o.g. Konzepts des pausierbaren Schwingkreises effektive Schwingungsfrequenzen erreichen, insbesondere auch variabel einstellen, die bei oder unterhalb der Grenzfrequenz liegen, obwohl dazu Werte für C und L verwendet werden, aus denen sich per Beziehung (1) eine oberhalb der Grenzfrequenz liegende Resonanzfrequenz $f_0$ ergibt. Insbesondere lassen sich somit kleinere und somit platzsparende Induktivitäten L und/oder MEMS-Kapazitäten (insbesondere kapazitive Lasten) C nutzen und so der Platzbedarf für die Schaltung zur Ansteuerung des Aktuators verringern bzw. klein halten.

Die Möglichkeit, die effektive Schwingungsfrequenz bei gegebenen Werten für C und L anhand der Steuerung mittels der ersten Schalteinrichtung variabel einstellen zu können, kann zudem vorteilhaft dazu genutzt werden, Bauteiltoleranzen, insbesondere im Rahmen einer Massenfertigung, zu kompensieren.

Die im Schwingkreis befindliche Energie wird somit, zumindest größtenteils, während der durch die Unterbrechung bedingten Pausierung der Schwingung in der MEMS-Kapazität in Form von elektrischer Energie gespeichert gehalten, bis durch Schließen des Schwingkreises die Schwingung fortgesetzt wird. Diese Speicherung während der Pausierung des Schwingkreises kann, jedenfalls bei einer verlustarmen MEMS-Kapazität, über einen langen Zeitraum weitgehend aufrechterhalten werden, so dass sich ohne signifikante (insbesondere anwendungsbezogen inakzeptable) Energieverluste ein entsprechend großer Wertebereich für die variable einstellbare effektive Schwingungsfrequenz des Schwingkreises erreichen lässt.

Des Weiteren wird zum Umladen der MEMS-Kapazität und somit zum Betrieb des dadurch gespeisten Aktuators die periodisch temporär in der ersten Induktivität gespeicherte Energie verwendet bzw. mitverwendet, so dass sich eine besonders verbrauchsarme (periodische) Ansteuerung des Aktuators realisieren lässt. Aufgrund ihres geringen Platzbedarfs als auch ihrer hohen Energieeffizienz ist die Schaltung insbesondere für den Einsatz in mobilen Anwendungen, vor allem auch in tragbaren Geräten mit geringen Abmessungen (z.B. in sog. "Wearables'"), geeignet.

Da die erste Induktivität derart im Schwingkreis angeordnet ist, dass sie nicht nur beim Umladen der MEMS-Kapazität während eines elektrischen Schwingens des Schwingkreises, sondern auch beim temporären Nachladen der MEMS-Kapazität in einem dabei jeweils stromdurchflossenen und durch die MEMS-Kapazität verlaufenden Strompfads des Schwingkreises liegt, wird auch beim Nachladen Energie in der ersten Induktivität zwischengespeichert. Die zwischengespeicherte Energie entspricht dabei in erster Näherung derjenigen Energie, welche bei einem Nachladevorgang ohne Nutzung einer Induktivität normalerweise durch das Kondensator-Paradoxon ungenutzt bleiben würde. Nach Beginn des Nachladens baut sich direkt nach dem Verbinden des Ladeanschlusses mit der Energieversorgungsschaltung in der ersten Induktivität Energie in Form eines magnetischen Feldes so lange auf, bis das Spannungsniveau am Ausgang der Energieversorgungsschaltung und der ersten MEMS-Kapazität im Gleichgewicht ist. Hier würde der Nachladevorgang ohne Nutzung einer Induktivität normalerweise enden. Die in der Induktivität zwischengespeicherte Energie wird jetzt jedoch wieder abgebaut und führt dazu, dass das Spannungsniveau über der ersten MEMS-Kapazität über das der Energieversorgungsschaltung angehoben wird, bis die Energie in der ersten Induktivität vollständig abgebaut ist. Das unmittelbare Öffnen des Strompfads zwischen Energieversorgungsschaltung und erster MEMS-Kapazität nach Beendigung des Ladevorgangs/Stromflusses verhindert ein ungewolltes Abfließen der in der ersten MEMS-Kapazität nun zusätzlich gespeicherten Energie zurück in die Energieversorgungsschaltung durch das dortige geringere Spannungsniveau. Für das nachfolgende Schwingen des Schwingkreises, d. h. wenn die erste Schalteinrichtung wieder geschlossen ist, steht somit auch diese zusätzliche Energie bzw. Ladung für das Schwingen zur Verfügung. Somit ergibt sich eine weitere Effizienzoptimierung der (zweiten) Schaltung.

Nachfolgend werden verschiedene beispielhafte Ausführungsformen der zweiten Schaltung beschrieben, die jeweils, soweit dies nicht ausdrücklich ausgeschlossen wird oder technisch unmöglich ist, beliebig miteinander sowie mit den hierin beschriebenen anderen Aspekten der Lösung kombiniert werden können.

Bei einigen Ausführungsformen ist die MEMS-Kapazität derart als Bestandteil des Aktuators ausgebildet, dass sie einen Bestandteil eines elektro-mechanischen Wandlers des Aktuators bildet. Der Wandler ist dabei konfiguriert, in der MEMS-Kapazität gespeicherte elektrische Energie in zumindest eine mechanische Größe zum Antrieb einer Bewegung des Aktuators zu wandeln. Der Aktuator kann insbesondere ein MEMS-Aktuator sein, z.B. ein Piezoaktuator. Die über der MEMS-Kapazität im Rahmen der elektrischen Schwingung im Schwingkreis abfallende Spannung kann somit direkt und ohne weitere kapazitive Pufferung dem Aktuator zur Verfügung gestellt werden, so dass ein hoher Wirkungsgrad der zweiten Schaltung erreicht werden kann.

Bei einigen Ausführungsformen kann die Steuerungsschaltung insbesondere dazu konfiguriert sein, in einer jeweiligen Schwingungsperiode des Schwingkreises die erste Schalteinrichtung in einen Zustand zu versetzen, in dem sie den Schwingkreis unterbricht, wenn die Spannung über der MEMS-Kapazität innerhalb der Schwingungsperiode nach einer während der Schwingungsperiode erfolgenden Umladung der MEMS-Kapazität betragsmäßig ein Maximum erreicht. So kann erreicht werden, dass die maximal zur Verfügung stehende Energie zum Umladen des Kondensators verwendet wurde und der Resonanzschwingkreis die gesamte Leistungsaufnahme optimal reduziert.

Auch kann so erreicht werden, dass der Strom in der Induktivität ein Minimum erreicht hat bzw. gegen null geht und somit keine Spannungsspitzen durch die Induktivität auftreten.

Bei einigen Ausführungsformen weist der Schwingkreis zusätzlich zur MEMS-Kapazität eine davon separat ausgebildete zweite MEMS-Kapazität mit (bezüglich der ersten MEMS-Kapazität) gleichem oder verschiedenen Kapazitätswert auf. Die MEMS-Kapazität und die zweite MEMS-Kapazität sind in dem Schwingkreis so verschaltet, dass ein erster Pol der MEMS-Kapazität mit einem ersten Pol der zweiten MEMS-Kapazität über zumindest einen Schalter der ersten Schalteinrichtung und die Schwingkreis-Induktivität elektrisch verbunden ist und die jeweiligen zweiten Pole der beiden MEMS-Kapazitäten so miteinander elektrisch verbunden sind, dass sie bei Betrieb des Schwingkreises auf einem selben (konstanten oder zeitlich variablen) elektrischen Potenzial gehalten werden.

Auf diese Weise können an den beiden MEMS-Kapazitäten zueinander bezüglich ihres Vorzeichens komplementäre Spannungen abgegriffen werden. Um auf eine gewünschte Differenzspannung zwischen den potenzialmäßig am weitesten auseinanderliegenden Polen dieser Kombination aus MEMS-Kapazitäten zu kommen, genügt es daher die beiden einzelnen MEMS-Kapazitäten auf eine betragsmäßig geringere Spannung zu laden, da sich die beiden Spannungen addieren. Das o.g. genannte Prinzip des pausierbaren Schwingkreises bleibt dabei, zumindest im Wesentlichen, unberührt. Eine solche Konfiguration kann insbesondere vorteilhaft genutzt werden, um einen differentiellen Antrieb eines schwingungsfähigen MEMS, insbesondere einen Antrieb einer Schwingungsbewegung eines Ablenkelements eines Mikroscanners, zu bewerkstelligen.

Ein solcher Antrieb ist dabei vor allem im Hinblick auf das Erreichen einer möglichst gleichförmigen, ruckfreien Schwingung des Ablenkelements (Spiegels) des Mikroscanners und/oder zur Verringerung der Leistungsaufnahme vorteilhaft. Die zweite MEMS-Kapazität kann dann ebenfalls als MEMS-Kapazität eines (insbesondere zweiten) Aktuators ausgebildet sein und dabei Teil eines Wandlers bilden, der konfiguriert ist, in der zweiten MEMS-Kapazität gespeicherte elektrische Energie in zumindest eine mechanische Größe zum Antrieb einer Bewegung dieses Aktuators zu wandeln.

Bei einigen Ausführungsformen weist die zweite Schaltung des Weiteren eine Energieversorgungsschaltung zur temporären Zufuhr von elektrischer Energie in den Schwingkreis über den Ladeanschluss auf. So lässt sich trotz der in der Realität unvermeidlichen Verluste (z.B. durch Wärmeentwicklung in parasitären, insbesondere ohmeschen, Widerständen der realen Schaltung), Abstrahlungen von elektromagnetischen Wellen bei höheren Frequenzen oder Reibungen im MEMS oder Luftreibungen von bewegten Teilen des MEMS) ein längerer, insbesondere sogar dauerhafter Betrieb des MEMS realisieren, in dem die Energieversorgungsschaltung die Energieverluste zumindest teilweise ausgleichen kann. So lässt sich die Energie im Schwingkreis aufrechterhalten oder jedenfalls deren Abbau verlangsamen.

Bei einigen Ausführungsformen weist die Energieversorgungsschaltung eine zweite Schalteinrichtung auf, die konfiguriert ist, in Abhängigkeit von einer Ansteuerung, insbesondere durch die Steuerung, einen ersten Einspeisungspunkt für elektrische Energie temporär mit dem Ladeanschluss des Schwingkreises zu verbinden, um den Schwingkreis mit am ersten Einspeisungspunkt zugeführter bzw. zuführbarer elektrischer Energie zu versorgen. Damit lässt sich die Energiezufuhr in den Schwingkreis, insbesondere um diesen anfänglich aufzuschwingen bzw. im nachfolgenden Betrieb dessen Energieverluste zu kompensieren, anhand der Ansteuerung genau einstellen, insbesondere deren zeitlicher Verlauf optimieren.

Speziell kann dazu die zweite Schaltung gemäß einigen Ausführungsformen konfiguriert sein, insbesondere durch eine entsprechende Ansteuerung, in einer jeweiligen Schwingungsperiode des Schwingkreises die zweite Schalteinrichtung (i) dann temporär zu schließen, wenn die Spannung über der MEMS-Kapazität betragsmäßig ein Maximum innerhalb der Schwingungsperiode erreicht und die gleiche Polung wie eine von der Energieversorgungsschaltung am ersten Einspeisungspunkt zur Verfügung gestellte Spannung aufweist. Die MEMS-Kapazität wird dementsprechend nachgeladen, wenn sie gerade im Rahmen der bereits erfolgenden elektrischen Schwingung im Schwingkreis gerade maximal aufgeladen ist, so dass nur noch eine Zusatzladung zum Auffüllen der Ladung der MEMS-Kapazität auf eine Sollspannung von der Energieversorgungsschaltung geliefert werden muss. Im vorgenannten Falle, dass im Schwingkreis auch eine zweite MEMS-Kapazität vorgesehen ist, kann dies dort unter Berücksichtigung der entgegengesetzten Polung entsprechend implementiert sein. Die zweite Schaltung kann (ii), insbesondere zusätzlich, konfiguriert sein, insbesondere durch eine entsprechende Ansteuerung, in einer jeweiligen Schwingungsperiode des Schwingkreises die zweite Schalteinrichtung zu öffnen, sobald während des temporären Nachladens der ersten MEMS-Kapazität im geschlossenen Zustand der zweiten Schalteinrichtung der Stromfluss durch die erste Induktivität auf einen bestimmten Wert abgefallen ist, der höchstens 10% (insbesondere höchstens 5% oder höchstens 1%) seines zuvor während des Nachladens erreichten Maximalwerts entspricht. Der Wert kann insbesondere so bestimmt sein oder werden, dass er einem vollständigen Versiegen des Stromflusses (d.h. auf null Ampere) entspricht. Insbesondere im Zusammenspiel mit dem vorausgehend unter Punkt (i) bestimmten Zeitpunkt zum Schließen der zweiten Schalteinrichtung, lässt sich so ein insbesondere hinsichtlich seiner Energieeffizienz optimierter Betrieb der Schaltung erreichen.

Bei einigen Ausführungsformen ist die zweite Schaltung konfiguriert, in der jeweiligen Schwingungsperiode mittels der zweiten Schalteinrichtung den ersten Einspeisungspunkt temporär mit dem Ladeanschluss des Schwingkreises zu einem Zeitpunkt zu verbinden, vor dem in der Schwingungsperiode bereits zwei aufeinanderfolgende Umladevorgänge der MEMS-Kapazität des Schwingkreises erfolgt sind, seit zuletzt mittels der zweiten Schalteinrichtung der erste Einspeisungspunkt temporär mit dem Schwingkreis verbunden wurde. Dies kann insbesondere im Hinblick auf eine effiziente und kompakte Realisierung vorteilhaft sein, denn es reicht dann aus, lediglich eine einzige Hochspannungsquelle, wahlweise mit positiver oder negativer Polung der Ausgangsspannung, vorzusehen. Insbesondere dann, wenn eine solche Hochspannungsquelle herkömmliche spulenbasierte Hochsetzsteller zur Spannungserhöhung aufweist, kann auf einer Platine entsprechend eine Spule eingespart werden. Gerade bei der Umsetzung der Schaltung unter Verwendung einer integrierten Schaltung (IC, z.B. ASIC), bei der kaum zusätzliche IC-externe Bauelemente notwendig sind, kann dies ein Vorteil sein.

Bei einigen Ausführungsformen ist die zweite Schaltung dahingehend konfigurierbar, dass die Menge der dem Schwingkreis in zumindest einer Schwingungsperiode über den Ladeanschluss von der Energieversorgungsschaltung zugeführten elektrischen Energie einstellbar ist. Dies kann auf verschiedene Weise erreicht werden. Beispielsweise kann die Dauer der Nachladung zeitlich variiert werden, die Stromstärke des Nachladestroms (insbesondere über Einstellen der ihn treibenden Spannung) eingestellt werden oder die Frequenz, mit der nachgeladen wird angepasst werden, beispielsweise so, dass die Nachladung nur jede m-te Periode der elektrischen Schwingung im Schwingkreis erfolgt, wobei m > 0 eine natürliche Zahl ist.

Die zweite Schaltung kann hierbei insbesondere dahingehend konfigurierbar sein, dass die Menge der dem Schwingkreis über den Ladeanschluss von der Energieversorgungsschaltung zugeführten elektrische Energie für jede Schwingungsperiode individuell (z.B. mittels einer Regelung) oder global für alle m-ten Schwingungsperioden gleich einstellbar ist, wobei m > 0 wieder eine natürliche Zahl ist.

Bei einigen Ausführungsformen weist die Energieversorgungsschaltung eine induktive Kopplungseinrichtung, insbesondere ein induktiv gekoppeltes Spulenpaar, zur temporären induktiven Einspeisung von elektrischer Energie in den Schwingkreis auf. Dies kann zusätzlich oder alternativ zu einer leitungsgebundenen Stromeinspeisung in den Schwingkreis vorgesehen sein. So kann die Energieversorgungsschaltung, jedenfalls bei Wegfall einer leitungsgebundenen Stromeinspeisung, galvanisch vom Schwingkreis entkoppelt werden.

Bei einigen Ausführungsformen weist die Energieversorgungsschaltung eine dritte Schalteinrichtung auf, die konfiguriert ist, in Abhängigkeit von einer Ansteuerung einen zweiten Einspeisungspunkt für elektrische Energie temporär mit dem Schwingkreis zu verbinden, um den Schwingkreis derart mit am zweiten Einspeisungspunkt zugeführter bzw. zuführbarer mit elektrischer Energie zu versorgen, dass die Polung einer dabei am ersten Einspeisungspunkt anliegenden ersten elektrischen Versorgungsspannung der Polung einer zugleich am zweiten Einspeisungspunkt anliegenden zweiten elektrischen Versorgungsspannung entgegengesetzt ist und so eine bipolare Energieversorgung des Schwingkreises ermöglicht ist.

**EP 4 585 556 B1**

Die Erzeugung und/oder Einspeisung der zweiten Versorgungsspannung kann insbesondere gemäß einer oder mehrerer hierin im Hinblick auf die dem ersten Einspeisungspunkt zugeführten Versorgungsspannung entsprechen, insbesondere (bis auf die unterschiedliche Polung) identisch damit sein.

Kombinierte Schaltung mit Hochsetzsteller und pausierbarem Schwingkreis

Die vorgenannten Prinzipien der ersten Schaltung und der zweiten Schaltung können im Rahmen der Lösung auch in Kombination genutzt werden.

Eine derart kombinierte Schaltung ergibt sich gemäß einer ersten Betrachtungsweise insbesondere, indem ausgehend von der ersten Schaltung (insbesondere ausgehend von einer ihrer hierin beschriebenen Ausführungsformen), des Weiteren ein Schwingkreis vorgesehen ist bzw. wird, der eine Kapazität, die zumindest anteilig durch die MEMS-Kapazität definiert ist, eine Schwingkreis-Induktivität und eine ansteuerbaren zweite Schalteinrichtung zum selektiven Unterbrechen bzw. Schließen des Schwingkreises in Abhängigkeit von einer Ansteuerung der zweiten Schalteinrichtung aufweist. Dabei weist der Schwingkreis eine auf einen dauerhaft geschlossenen Zustand des Schwingkreises bezogene Resonanzfrequenz auf. Die erste Induktivität ist derart im Schwingkreis angeordnet, dass sie sowohl beim Umladen der MEMS-Kapazität während eines elektrischen Schwingens des Schwingkreises im geschlossenen Zustand der zweiten Schalteinrichtung als auch beim temporären Nachladen der MEMS-Kapazität im unterbrochenen Zustand der zweiten Schalteinrichtung in einem dabei jeweils stromdurchflossenen und durch die MEMS-Kapazität verlaufenden Strompfads des Schwingkreises liegt. Zudem ist die Steuerung des Weiteren zur Ansteuerung der zweiten Schalteinrichtung derart konfiguriert, dass sie die zweite Schalteinrichtung während einer jeweiligen Schwingungsperiode des Schwingkreises temporär für ein bestimmten Anteil der Schwingungsperiode öffnet, um dadurch eine Unterbrechung des Schwingkreises und somit eine tatsächliche Schwingungsfrequenz des Schwingkreises zu bewirken, die kleiner ist als die Resonanzfrequenz.

Die Schaltung kann insbesondere jede, insbesondere eine oder mehrere der hierin beschriebenen Ausführungsformen der zweiten Schaltung aufweisen.

Die im Schwingkreis erzeugten elektrischen Schwingungen führen somit zu einer zeitlich veränderlichen, insbesondere alternierenden, Ladung und somit Spannung der MEMS-Kapazität, so dass auch die mechanische Größe zum Antrieb einer Bewegung des Aktuators, zu dem die MEMS-Kapazität gehört, entsprechend variiert.

Eine derart kombinierte Schaltung ergibt sich zudem gemäß einer zweiten Betrachtungsweise insbesondere, indem ausgehend von der zweiten Schaltung mit Energieversorgungsschaltung, diese Energieversorgungsschaltung einen Aufwärtswandler aufweist, der konfiguriert ist, eine am Einspeisungspunkt angelegte Eingangsspannung in eine demgegenüber betragsmäßig höhere Ausgangsspannung zu wandeln, um den Schwingkreis anhand dieser Ausgangsspannung mit elektrischer Energie zu versorgen, wenn die zweite Schalteinrichtung sich in einem Zustand befindet, in dem sie den Einspeisungspunkt temporär mit dem Schwingkreis elektrisch verbindet. Auf diese Weise kann auf eine Hochvoltquelle verzichtet werden und stattdessen nur eine Niedervoltspannungsquelle zur Bereitstellung einer Versorgungsspannung für die zweite Schaltung eingesetzt werden. Der Aufwärtswandler kann insbesondere eine Hochsetzstellerschaltung gemäß der ersten Schaltung aufweisen, wobei die Schwingkreis-Kapazität zumindest anteilig durch die MEMS-Kapazität der Hochsetzstellerschaltung gebildet wird.

Die Schaltung kann, insbesondere im Falle von mehr als einem Einspeisungspunkt je Einspeisungspunkt individuell oder gleich, jede, insbesondere eine oder mehrere, der hierin beschriebenen Ausführungsformen der Hochsetzstellerschaltung aus der ersten Schaltung als Hochsetzstellerschaltung aufweisen.

MEMS, insbesondere Mikroscannersystem

Ein dritter Aspekt der vorliegenden Lösung betrifft ein MEMS, aufweisend: (i) ein schwingungsfähig konfiguriertes Massenelement; (ii) einen Aktuator zum Antrieb einer Schwingungsbewegung des Massenelements; und (iii) eine Schaltung nach dem ersten Aspekt oder dem zweiten Aspekt oder eine daraus kombinierte Schaltung, jeweils zur Ansteuerung des Aktuators derart, dass dieser dadurch veranlasst wird, das schwingungsfähige Massenelement in einer Schwingungsbewegung zu bewegen.

Dabei ist die MEMS-Kapazität derart als Bestandteil des Aktuators ausgebildet, dass sie selbst einen Bestandteil eines elektro-mechanischen Wandlers des Aktuators bildet, und der Wandler konfiguriert ist, in der MEMS-Kapazität gespeicherte elektrische Energie in zumindest eine mechanische Größe zum Antrieb einer Bewegung des Aktuators zu wandeln, um damit die Schwingungsbewegung des Massenelements anzutreiben.

Bei einigen Ausführungsformen weist das MEMS ein Mikroscannersystem auf und das Massenelement ist als schwingungsfähig konfiguriertes Ablenkelement des Mikroscannersystems zum Ablenken von auf das Ablenkelement einfallender elektromagnetischer Strahlung ausgebildet. So lässt sich ein besonders energieeffizienter Antrieb der Bewegung, insbesondere des Ablenkelements, insbesondere zum Scannen eines elektromagnetischen Strahls (z.B. Laserstrahl) erreichen.

Die in Bezug auf den ersten bzw. zweiten Aspekt der Lösung erläuterten Merkmale und Vorteile gelten entsprechend auch für das Mikroscannersystem gemäß dem dritten Aspekt der Lösung.

Weitere Vorteile, Merkmale und Anwendungsmöglichkeiten der vorliegenden Lösung ergeben sich aus der nachfolgenden detaillierten Beschreibung im Zusammenhang mit den Figuren.

Dabei zeigt:

**Fig. 1** als Ausgangspunkt für die Erläuterung der ersten Schaltung aus Fig. 2A: eine herkömmliche Schaltung zum Ansteuern eines kapazitiven Aktuators mit einem geregelten Hochsetzsteller;

**Fig. 2A** eine erste beispielhafte Ausführungsform der ersten Schaltung, die ein unipolares Ansteuern des Aktuators ermöglicht;

**Fig. 2B** einen Vergleich der Schaltungen aus den Figuren 1 und 2A;

**Fig. 3** ein Diagramm zur Darstellung eines zeitlichen Stromverlaufs durch die Induktivität der Schaltung aus Fig. 2A/2B bei deren Betrieb, während in der Induktivität die magnetische Energie aufgebaut wird;

**Fig. 4** eine beispielhafte Ausführung einer Steuerungseinrichtung zur Steuerung einer ersten Schaltung, insbesondere gemäß Fig. 2A.

**Fig. 5** eine zweite beispielhafte Ausführungsform der ersten Schaltung, die ein bipolares Ansteuern des Aktuators ermöglicht;

**Fig. 6** einen beispielhaften zeitlichen Verlauf der Konfiguration der Schalteinrichtung der Schaltung aus Fig. 5, insbesondere der Schaltzustände ihrer einzelnen Schalter; und

**Fig. 7** als Ausgangspunkt für die Erläuterung der zweiten Schaltung aus Fig. 8: eine herkömmliche Schaltung zur Ansteuerung eines MEMS-Aktuators zum Antrieb eines schwingungsfähigen MEMS, bei der ein Umladen einer MEMS-Kapazität des MEMS-Aktuators anhand einer Halbbrücke unter Verwendung zweier gegenpoliger Versorgungsspannungen erfolgt;

**Fig. 8** eine erste beispielhafte Ausführungsform der zweiten Schaltung, mit einem effizienz-optimierten, pausierbaren Schwingkreis sowie mit einer Hochspannungsquelle zur Bereitstellung einer Versorgungsspannung für die Schaltung;

**Fig. 9** eine qualitative Darstellung der Verläufe der Spannung an der MEMS-Kapazität des Schwingkreises und des von der Hochspannungsquelle zu liefernden Ladestroms bei der Schaltung aus Fig. 8;

**Fig. 9A** eine vergrößerte Ansicht der Verläufe von Spannung und Strom an der MEMS-Kapazität der Schaltung aus Fig. 8 während des Nachladevorgangs;

**Fig. 9B** zur Illustration von besonderen Wirkungen der Schaltung aus Fig. 8 auf Basis eines Vergleichs von Fig. 9A mit Fig. 9B: eine vergrößerte Ansicht der Verläufe von Spannung und Strom an der MEMS-Kapazität während des Nachladevorgangs bei einer beispielhaften Abwandlung der Schaltung aus Fig. 8, bei der die Schwingkreisinduktivität im Schwingkreis außerhalb eines Nachlade-Stromkreises für den Schwingkreis angeordnet ist;

**Fig. 10** eine zweite beispielhafte Ausführungsform der zweiten Schaltung mit einem pausierbaren Schwingkreis sowie mit einer über ein gekoppeltes Spulenpaar induktiv an den Schwingkreis gekoppelten Hochspannungsquelle zur Bereitstellung einer Versorgungsspannung für die Schaltung;

**Fig. 11** eine dritte beispielhafte Ausführungsform der zweiten Schaltung mit einem pausierbaren Schwingkreis sowie mit einer auf zwei separate MEMS-Kapazitäten aufgeteilten Schwingkreiskapazität;

**Fig. 12** eine erste beispielhafte Ausführungsform einer Schaltung, in der die Konzepte der ersten Schaltung und der zweiten Schaltung kombiniert sind, um eine Schaltung mit unipolarem Hochsetzsteller und pausierbarem Schwingkreis zu bilden;

**Fig. 13** eine zweite beispielhafte (bipolare) Ausführungsform einer Schaltung in der die Konzepte der ersten Schaltung und der zweiten Schaltung kombiniert sind, um eine Schaltung mit bipolarem Hochsetzsteller und pausierbarem Schwingkreis zu bilden; und

**Fig. 14** eine dritte beispielhafte (bipolare) Ausführungsform einer Schaltung in der die Konzepte der ersten Schaltung und der zweiten Schaltung kombiniert sind, um eine Schaltung zum differentiellen und bipolaren Ansteuern eines MEMS-Aktuators zu bilden.

**Fig. 15** eine beispielhafte Ausführungsform eines MEMS, hier speziell als Mikroscanner.

In den Figuren bezeichnen gleiche Bezugszeichen regelmäßig gleiche, ähnliche oder einander entsprechende Elemente (außer in einigen Fällen bei der Benennung von Schalteinrichtungen). In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und genereller Zweck dem Fachmann verständlich werden. In den Figuren dargestellte Verbindungen und Kopplungen zwischen funktionellen Einheiten und Elementen können, soweit nicht ausdrücklich anders angegeben, auch als indirekte Verbindung oder Kopplung implementiert werden. Die Steuerung bzw. Steuerungseinrichtung, kann insbesondere mittels Hardware, Software oder mittels einer Kombination aus Hardware und Software implementiert werden.

Beispielhafte Ausführungsformen der ersten Schaltung

Es folgen nun zunächst Erläuterungen zu beispielhaften Ausführungsformen der ersten Schaltung, wobei zunächst von der herkömmliche Schaltung 100 aus **Fig. 1** ausgegangen wird:
Die Schaltung 100 aus Fig. 1 entspricht einem typischen Aufbau eines asynchronen Hochsetzstellers (engl. DC/DC-Converter) aus dem Stand der Technik und wird hier zu Referenzzwecken erläutert, insbesondere um wichtige Unterschiede gegenüber lösungsgemäßen Schaltungen kenntlich zu machen.
Eine Spannungsquelle stellt eine Versorgungsspannung $U_V$ als Gleichspannung zur Verfügung und speist damit eine Induktivität (Spule) L wenn ein Stromkreis durch die Induktivitäten geschlossen wird. Der Widerstand $R_L$ stellt im Sinne eines Ersatzschaltbilds den ohmschen Widerstand der Induktivität dar und ist im Rahmen der weiteren Diskussion der Schaltung(en) nicht relevant.
In einer ersten Phase des Betriebs der Schaltung wird der Stromkreis durch die Induktivität L geschlossen, indem der Feldeffekt-Transistor T leitend geschaltet wird. Dies erfolgt über einen Regler Reg, der den Transistor T entsprechend über dessen Gate ansteuert. Durch den Stromfluss durch die Induktivität L baut diese ein Magnetfeld auf, in dem von der Versorgungsspannung $U_V$ zur Verfügung gestellte Energie gespeichert ist (in Form von magnetischer Energie).
Wird nun in einer zweiten Phase durch den Regler Reg der Transistor T sperrend geschaltet, so versucht die Induktivität L trotz Unterbrechung des bisherigen Stromkreises, ihren magnetischen Fluss gemäß der Lenz'schen Regel bzw. dem Induktionsgesetz aufrechtzuerhalten, indem eine Spannung induziert wird, sodass er dadurch generierte Strom ein Magnetfeld erzeugt, welches der Änderung des magnetischen Flusses entgegenwirkt. Die induzierte Spannung führt insbesondere dazu, dass die Diode D oberhalb ihrer Schwellspannung in Durchlassrichtung geschaltet wird und der (zumindest anteilig zusätzlich zur Versorgungsspannung $U_V$) aus dem magnetischen Feld der Induktivität L gespeiste generierte Strom in die Pufferkapazität C abfließen kann, sodass sich dort eine Ausgangsspannung $U_A$ über der Pufferkapazität C aufbaut. Die Diode wirkt hier somit ähnlich einem Schalter.
Die Erzeugung der Ausgangsspannung $U_A$ ist dabei geregelt, wozu eine Regelschleife mit einem Spannungsteiler aus den Widerständen $R_1$ und $R_2$ sowie einem Operationsverstärker OP vorgesehen ist, dessen Ausgang zum Schließen der Regelschleife mit einem Eingang des Reglers Reg elektrisch leitend verbunden ist. Zur Ansteuerung des Reglers Reg wird die an der Mittelabzapfung des Spannungsteilers auftretende Spannung anhand des Operationsverstärkers OP mit einer festgelegten Referenzspannung $V_{ref}$ verglichen und in Abhängigkeit vom Ergebnis des Vergleichs eine variable Frequenz oder ein variabler Duty Cycle (alternative deutsche Begriffe sind "Tastgrad" und "Aussteuergrad") eines Ausgangssignals des Reglers Reg bestimmt, mit dem der Transistor T angesteuert wird. So lässt sich mit der Regelung die Ausgangsspannung $U_A$ am Pufferkondensator C auf einen im Wesentlichen konstanten Wert auslegen, der insbesondere von der Referenzspannung $V_{ref}$ abhängt.
Die Ausgangsspannung $U_A$ kann nun als Treiberspannung verwendet werden, um durch Schließen eines Schalters $S_1$ eine elektrische Verbindung zu einem MEMS-Aktuator freizuschalten, um diesen zu treiben. Der MEMS-Aktuator kann - wie dargestellt - insbesondere eine MEMS-Kapazität $C_M$ aufweisen und insbesondere ein Piezoaktuator sein, bei dem die MEMS-Kapazität $C_M$ zusammen mit einem zwischen ihren beiden verschiedenpoligen Elektroden angeordneten Piezomaterial als Piezoelement wirkt. Mittels eines parallel zur MEMS-Kapazität $C_M$ geschalteten Schalters $S_2$ kann die MEMS-Kapazität $C_M$ wieder entladen werden, insbesondere auf 0V. Über eine entsprechende Ansteuerung der Schalter $S_1$ und $S_2$ kann somit eine Anregungsfrequenz für den MEMS-Aktuator festgelegt werden mit der die MEMS-Kapazität $C_M$ zwischen einem geladenen und einem ungeladenen Zustand hin und her schwingt und entsprechend den MEMS-Aktuator in eine oszillierende mechanische Bewegung versetzt, die wiederum zum Antrieb einer mechanischen Bewegung einer weiteren Komponente genutzt werden kann. Die Schalter $S_1$ und $S_2$ können insbesondere auch durch Transistoren realisiert sein.

Die durch die Schaltung 100 erzeugbare Hochspannung kann insbesondere bis zu 200 V bei einer Frequenz von bis zu 100 kHz betragen, sodass die Schalter $S_1$ und $S_2$ dann entsprechend als Hochspannungsschalter auszulegen sind. Wird die Pufferkapazität C mit einer Konstantspannungsquelle für die Versorgungsspannung $U_V$ geladen, wie dies bei der Schaltung 100 der Fall ist, so beträgt der theoretische Wirkungsgrad aufgrund der Speisung der MEMS-Kapazität $C_M$ aus der Pufferkapazität C und dem daraus resultierenden Auftreten des sogenannten "Kondensator-Paradoxons" jedoch maximal nur 50 %. Der verbleibende Teil der aufgebrachten Energie fällt als Verlustleistung an, insbesondere im Widerstand des (Hochspannung-) Schalters S1, dem ohmschen Widerstand RL der Spule und den Zuleitungen als Verlustleistung.

Typische Eigenschaften einer solchen herkömmlichen Schaltung 100 sind daher:

- Geringer Wirkungsgrad aufgrund des Kondensator-Paradoxons
- Permanentes Schalten des Transistors T, zum Nachliefern der im Mittel verbrauchten Ladung zum periodischen Umladen der MEMS Kapazität $C_M$ (Führt zu höherer Gesamtleistungsaufnahme durch Schaltverluste und kann außerdem zu Rauschen in anderen Schaltungsteilen führen)
- Verhältnismäßig hohe Leistungsaufnahme aufgrund der permanenten Regelung der Ausgangsspannung
- Großes Systemvolumen (Benötigt eine Regelung der Ausgangsspannung und einen Hochspannungsschalter $S_1$, was zu hohen Regel- und Schaltverlusten führt)
- Hohe Schaltungskomplexität insgesamt
- Benötigt analoge Baugruppen zur Gewährleistung der Regelstabilität des Hochsetzstellers
- Benötigt einen Hochspannungsschalter $S_1$, welcher aufwendig aufgebaut werden muss (z.B. Bootstrap-Schaltung o.Ä.) und somit nicht energieeffizient ist.

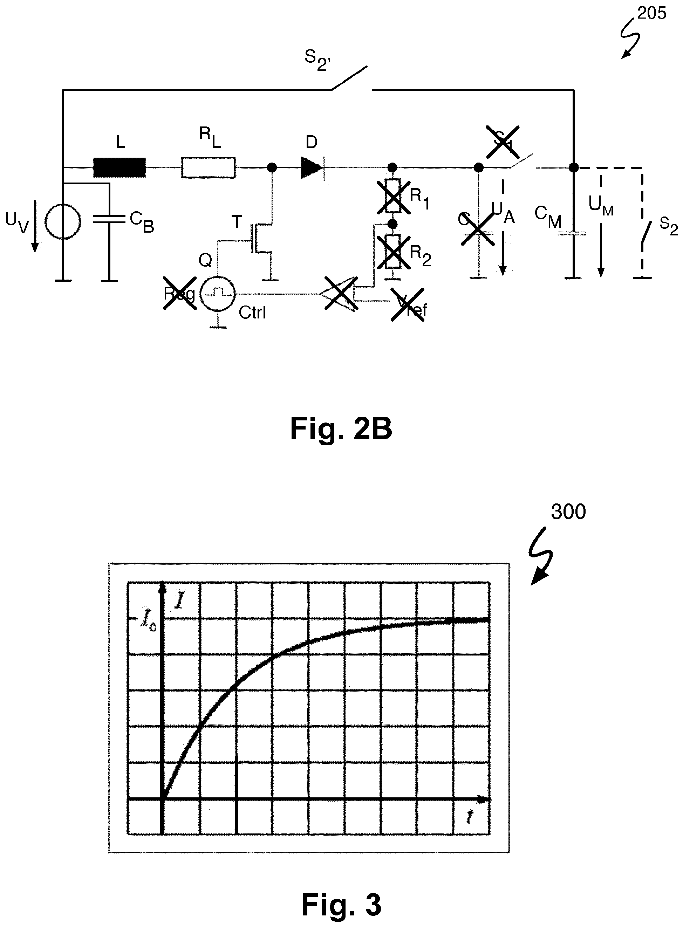

**Fig. 2A** zeigt dagegen eine erste beispielhafte Ausführungsform 200 einer ersten Schaltung, mit der einer oder mehrere der vorgenannten Nachteile reduziert oder sogar vermieden werden können. In **Fig. 2B** ist im Rahmen eines Vergleichs 205 der Schaltungen 100 und 200 illustriert, welche Schaltungskomponenten bei der Schaltung 200 eingespart werden können.

Im Unterschied zur Schaltung 100, wird der Transistor T nicht mehr durch einen Regler (closed-loop) sondern durch eine Steuerung (open-loop) Ctrl mittels eines Steuersignals Q angesteuert und der Ladestrom fließt nicht in eine Pufferkapazität C, von der aus dann zeitlich nachfolgend die MEMS-Kapazität $C_M$ geladen wird, sondern er fließt direkt ohne kapazitive Pufferung in die MEMS-Kapazität $C_M$ des Aktuators, insbesondere MEMS-Aktuators, um dort eine Antriebsspannung $U_M$ über der MEMS-Kapazität $C_M$ aufzubauen.

Die MEMS-Kapazität $C_M$ ist als Bestandteil des Aktuators ausgebildet, sodass sie einen Bestandteil eines elektro-mechanischen Wandlers des Aktuators bildet, wobei der Wandler konfiguriert ist, in der MEMS-Kapazität $C_M$ gespeicherte elektrische Energie in zumindest eine mechanische Größe zum Antrieb einer Bewegung des Aktuators zu wandeln. Der Aktuator kann insbesondere ein Piezo-Aktuator bzw. Piezoelement sein, bei dem ein piezoelektrisches Material zwischen den Elektroden der MEMS-Kapazität $C_M$ so angeordnet ist, dass es beim Auftreten einer elektrischen Spannung $U_M$ zwischen den Elektroden im zugehörige elektrischen Feld liegt und sich gemäß dem inversen Piezoeffekt verformt, wodurch elektrische Energie in mechanische Energie gewandelt wird.

Die Schaltung 200 weist eine Schalteinrichtung auf, zu welcher der Transistor T, die Diode D und der Schalter $S_2$, gehören. Optional kann der schon aus Fig. 1 bekannte weitere Schalter $S_2$ vorhanden sein, um die MEMS-Kapazität $C_M$ darüber optional direkt gegen Masse entladen zu können, insbesondere nach erfolgter Energierückgewinnung in einen versorgungsseitigen Pufferkondensator $C_B$. Angenommen, die Versorgungsspannung sei x, z.B. 3V, dann könnte unter Verwendung des Schalters $S_2$ unterm Strich zusätzlich eine um x erhöhte Spannungsänderung über der MEMS-Kapazität $C_M$ erzeugt werden. Allerdings sollte hierzu der Schalter $S_2$ nur kurzzeitig geschlossen werden, um währenddessen ein "Aufladen" der Induktivität L durch einen aus der Versorgungsspannung $U_V$ gespeisten Strom zu vermeiden. Alternativ kann dafür stattdessen die Versorgungsspannung $U_V$ während der Entladung der MEMS-Kapazität $C_M$ durch einen optional vorhandenen weiteren Schalter (nicht dargestellt) von der Induktivität L entkoppelt werden.

Wie sich insbesondere mit Blick auf **Fig. 2B** ergibt, weist die Schaltung 200 gegenüber der Schaltung 100 eine deutlich geringere Komplexität bei signifikant höherem Wirkungsgrad auf, insbesondere aufgrund der Vermeidung des (Hochspannungs-) Schalters $S_1$, des Pufferkondensators C und des damit verbundenen Kondensator-Paradoxons sowie der Regelung einschließlich der zugehörigen Regelungsschleife mit dem Spannungsteiler $R_1$, $R_2$, dem Operationsverstärker OP, dem Regler Reg und dessen Schaltfrequenzerzeugungsfunktion für den Transistor T.

Die Funktionsweise der Schaltung aus Fig. 2A/2B kann wie folgt beschrieben werden:

Ist der Transistor T mittels einer entsprechenden Ansteuerung durch die Steuerung Ctrl durchgeschaltet ("erste" Schaltungskonfiguration), so ist dadurch ein erster Strompfad durch die Induktivität L freigeschaltet, um einen von der Versorgungsspannung $U_V$ gespeisten ansteigenden Stromfluss durch die Induktivität L zu bewirken. Dabei steigt der Strom durch die Induktivität L (zunächst näherungsweise linear) an. Der Widerstand $R_L$ soll hierbei (im Sinne eines Ersatzschaltbilds) den Wicklungswiderstand der Induktivität L (Spule) repräsentieren.

Nach der Zeit $t_L$ wird der Transistor T sperrend geschaltet ("zweite" Schaltungskonfiguration), sodass ein kapazitiv-ungepufferter zweiter Strompfad zwischen einem ersten Pol der Induktivität L und der MEMS-Kapazität $C_M$ freigeschaltet ist, über den die MEMS-Kapazität $C_M$ direkt mittels eines zumindest anteilig durch die Induktivität L gespeisten Stromflusses durch die dann in Durchlassrichtung gepolte Diode D hindurch auf eine erste Spannung aufgeladen wird, die betragsweise gleich oder höher ist als die Versorgungsspannung $U_V$. Dabei wird die in der Induktivität L gespeicherte magnetische Energie abgebaut und in die sich in der MEMS-Kapazität $C_M$ aufbauende elektrische Energie direkt umgewandelt.

Betrachtet man den zeitlichen Verlauf 300 des durch die Induktivität L fließenden Stroms während der ersten Schaltungskonfiguration, so kann dieser, wie in Fig. 3 illustriert, durch die folgende Beziehung angegeben werden:

$$I(t) = I_0 \left( 1 - e^{-\frac{R}{L}t} \right) \qquad (2)$$

Hierbei entspricht R der Summe der parasitären Serienwiderstände der Induktivität L und des Bahnwiderstands des durchgeschalteten Transistors T (die dazwischenliegenden Leitungsbahnen werden hier idealisiert als nur einen vernachlässigbaren Widerstand aufweisend betrachtet) und $U_V$ ist wieder die Versorgungsspannung, die zugleich dem Spannungsabfall über dieser Serienschaltung entspricht. $I_0$ ist eine maximale Stromstärke (Grenzstrom), der sich der Ladestrom $I(t)$ mit der Zeit asymptotisch näher. Der Grenzstrom berechnet sich zu:

$$I_0 = \frac{U_V}{R} \qquad (3)$$

Zur Vereinfachung der Gleichung (2) kann diese im Ursprung zum Zeitpunkt Zeit t = 0 durch deren Ableitung linearisiert werden:

$$\frac{dI(t)}{dt} = \frac{I_0 R}{L} e^{-\frac{R}{L}t} \qquad (4)$$

Zum Zeitpunkt t = 0 vereinfacht sich diese Beziehung zu:

$$\frac{dI(0)}{dt} = \frac{I_0 R}{L} \qquad (5)$$

Mit dem Einsetzen von (3) in (5) ergibt sich mit der Linearisierung zum Zeitpunkt $t_L$, an dem in die zweite Schaltungskonfiguration umgeschaltet wird, für den Strom I durch die Induktivität:

$$I(t_L) \approx \frac{U_V}{L} t_L \qquad (6)$$

Die gespeicherte Energie $E_L$ in der Induktivität L zum Zeitpunkt t = $t_L$ ergibt sich zu:

$$E_L(t_L) = \frac{1}{2} L I^2(t_L) \qquad (7)$$

Korrespondierend dazu gilt für die Energie $E_M$ der MEMS-Kapazität $C_M$, wobei $U_M$ die über $C_M$ liegende Kondensatorspannung ist:

$$E_M = \frac{1}{2} C_M U_M^2 \qquad (8)$$

Setzt man die beiden Gleichungen (7) und (8) gleich und ersetzt $I(t_L)$ durch den Ausdruck aus der Gleichung (6), so ergibt sich für die Spannung $U_M$, auf welche die MEMS-Kapazität $C_M$ aufgrund des Energietransfers von der Induktivität L aufgeladen wird, zu:

$$U_M \approx \sqrt{\frac{1}{L C_M}} \, U_V \, t_L \qquad\qquad (9)$$

So skaliert die Spannung $U_M$ über der MEMS-Kapazität $C_M$ in guter Näherung proportional zu der Zeitdauer, in der der Transistor durchgeschaltet ist, ebenso proportional mit der Versorgungsspannung $U_V$, und wurzelförmig mit dem Kehrwert von Werten für die Induktivität L und die MEMS-Kapazität $C_M$. Diese Näherung ist insbesondere dann gültig, wenn die Summe aller parasitären Widerstände (z.B. Serienwiderstand der Spule, Serienwiderstand der MEMS-Kapazität $C_M$ und Bahnwiderstände) absolut betrachtet vergleichsweise klein sind. Ansonsten führten diese zu einer schlussendlich geringeren Ladespannung der MEMS-Kapazität $C_M$, da die in der Spule gespeicherte Energie nicht nur in die MEMS-Kapazität transferiert, sondern zum Teil auch in Wärme umgewandelt wird.

Die Spannung $U_M$ über der MEMS-Kapazität $C_M$ kann somit zumindest näherungsweise als lineare Funktion der Zeitspanne $t_L$ betrachtet werden. Da alle Komponenten innerhalb der Schaltung, insbesondere L und $C_M$, bekannt sind, kann somit die Ausgangsspannung $U_M$ allein über die steuerbare Einschaltzeit $t_L$ des Transistors T eingestellt werden. Dadurch kann der Regler Reg wegfallen, was zu einer deutlichen Vereinfachung der Schaltung 200 gegenüber der herkömmlichen Schaltung 100 führt.

Der Schalter $S_2$ zum Entladen der MEMS-Kapazität $C_M$ kann entweder entsprechend Fig. 1 parallel zu $C_M$ geschaltet sein (dritter Strompfad) oder - wie abgebildet - in einem zur Versorgungsspannungsquelle zurückführenden vierten Strompfad (dann zur Kennzeichnung dieser unterschiedlichen Anordnung als Schalter $S_{2'}$ bezeichnet). Die Versorgungsspannungsquelle (nicht aber der zweite Strompfad zwischen Induktivität und MEMS-Kapazität $C_M$) ist über einen Pufferkondensator $C_B$ gepuffert, in dem die über den Schalter $S_{2'}$ beim Entladen von $C_M$ zurückfließenden Ladungen zwischengespeichert und für einen weiteren Aktivierungszyklus des Aktuators wiederverwendet werden können. So lässt sich der Wirkungsgrad der Schaltung 200 weiter steigern.

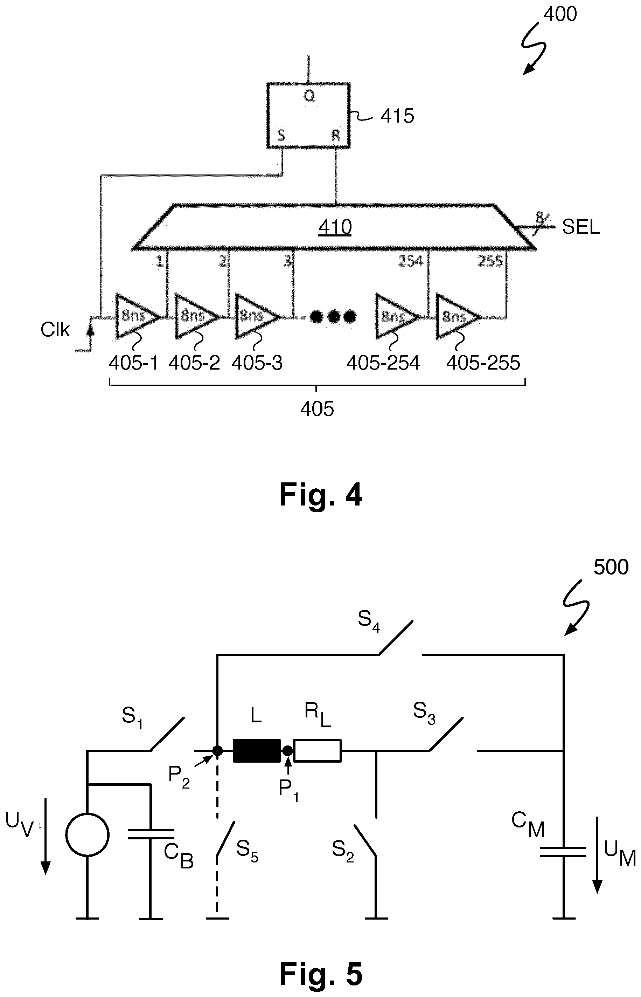

**Fig. 4** zeigt eine beispielhafte Ausführung 400 der Steuerungseinrichtung Ctrl zur Steuerung einer lösungsgemäßen Schaltung, insbesondere gemäß Fig. 2A. Sie dient dazu, die Einschaltzeit bzw. -dauer des Transistors T und somit auch die Ausgangsspannung $U_M$ zu steuern und ist mit einer Verzögerungskette 405 mit mehreren hintereinander geschalteten Verzögerungsgliedern 405-1, ..., 405-n, einem Multiplexer 410 und einem Flip-Flop realisiert.

Im vorliegenden Beispiel ist n = 255 gewählt. Die Verzögerungsglieder 405-1,...,405-255 können hierbei aus Standardzellen oder auch "customized", insbesondere anwendungsspezifisch, in analoger Schaltungstechnik ausgeführt werden. Die erforderliche Verzögerungsdauer jedes einzelnen Verzögerungsglieds lässt sich aus dem Quotienten der maximalnotwendigen Einschaltzeit und der Anzahl der Verzögerungsglieder errechnen. Im Beispiel wurde der Einfachheit halber für alle Verzögerungsglieder 405-1,...,405-255 die gleiche Verzögerungsdauer von 8 ns gewählt.

Eine analoge Ausführung hat speziell den Vorteil, dass über eine Stromsteuerung die Verzögerungszeit jedes einzelnen Verzögerungsgliedes individuell eingestellt werden kann und somit für beliebige MEMS-Kondensatoren (mit unterschiedlichen Kapazitätswerten und Ausgangsspannungen) optimal einstellbar ist.

Jeder Takt eines an die Steuerungseinrichtung 400 angelegten Taktsignals CLK wird somit gleichmäßig entsprechend der Anzahl der Verzögerungsglieder 405-1,...,405-255 unterteilt.

Durch ein an den Multiplexer 410 angelegtes Auswahlsignal SEL kann die gewünschte Stufe der Verzögerungskette ausgewählt werden, die auf den R-Eingang des RS-FlipFlops 415 ausgegeben wird. Wenn das Taktsignal CLK auf dem Pegel "1" bzw. "high" liegt, schaltet das Ausgangssignal Q (z.B. mit dem Pegel "1") den Transistor T leitend. Sobald jedoch nachfolgend gemäß der ausgewählten Verzögerung das Ausgangssignal des Multiplexers 410 wechselt (z.B. auf den Pegel "1"), ändert sich das Ausgangssignal Q so (z.B. auf den Pegel "0"), dass damit der Transistor T gesperrt wird. Über die Auswahl der Verzögerung mittels des Auswahlsignals SEL lässt sich somit die Zeitdauer $t_L$ einstellen, während der die Induktivität L mit magnetischer Energie "aufgeladen" wird. Da die Höhe der Spannung $U_M$ über MEMS-Kapazität $C_M$ wiederum von der Zeitdauer $t_L$ abhängt, lässt sich mittels des Auswahlsignals SEL die die Höhe der Spannung $U_M$ und somit die Aktivität des Aktuators steuern.

In **Fig. 5** ist als eine zweite beispielhafte Ausführungsform eine Schaltung 500 zum bipolaren Ansteuern eines Aktuators mit einem gesteuerten Hochsetzsteller dargestellt.

Bei der Schaltung 500, die eine Abwandlung bzw. Fortentwicklung der Schaltung 200 darstellt, ist die Schalteinrichtung des Weiteren eingerichtet, wiederholt und jeweils temporär in einem Zeitraum, in dem der zwischen einem ersten Pol der Induktivität L und der MEMS-Kapazität $C_M$ liegende zweite Strompfad nicht freigeschaltet ist, einen vierten Strompfad zwischen der MEMS-Kapazität und einem zum dem ersten Pol $P_1$ elektrisch gegenpoligen zweiten Pol $P_2$ der Induktivität L derart freizuschalten, dass die MEMS-Kapazität $C_M$ dabei auf eine zweite Spannung mit einer zur Polarität der ersten Spannung entgegengesetzten Polarität aufgeladen wird.

Die Schalteinrichtung der Schaltung 500 weist zu diesem Zweck vier Schalter $S_1$ bis $S_4$ auf. Der Schalter $S_1$ liegt im Strompfad zwischen der Versorgungsspannung $U_V$ und dem zweiten Pol $P_2$ der Induktivität L. Der Schalter $S_2$ liegt im ersten Strompfad zwischen dem ersten Pol $P_1$ der Induktivität L und Masse. Er kann insbesondere - wie in Fig 2A - durch einen Transistor T (oder mehrere Transistoren und/oder Dioden) realisiert sein. Dasselbe gilt auch für alle anderen Schalter. Der dritte Schalter $S_3$ liegt im zweiten Strompfad zwischen dem ersten Pol $P_1$ der Induktivität L und der MEMS-Kapazität $C_M$. Der vierte Schalter $S_4$ liegt in einem weiteren ("vierten") Strompfad zwischen der MEMS-Kapazität $C_M$ und der Versorgungsspannung $U_V$ bzw. deren Pufferkondensator $C_B$ und entspricht dem Schalter $S_{2'}$ aus Fig. 2B.

Optional kann ein weiterer Schalter $S_5$ zwischen dem zweiten Pol $P_2$ und Masse vorgesehen sein.

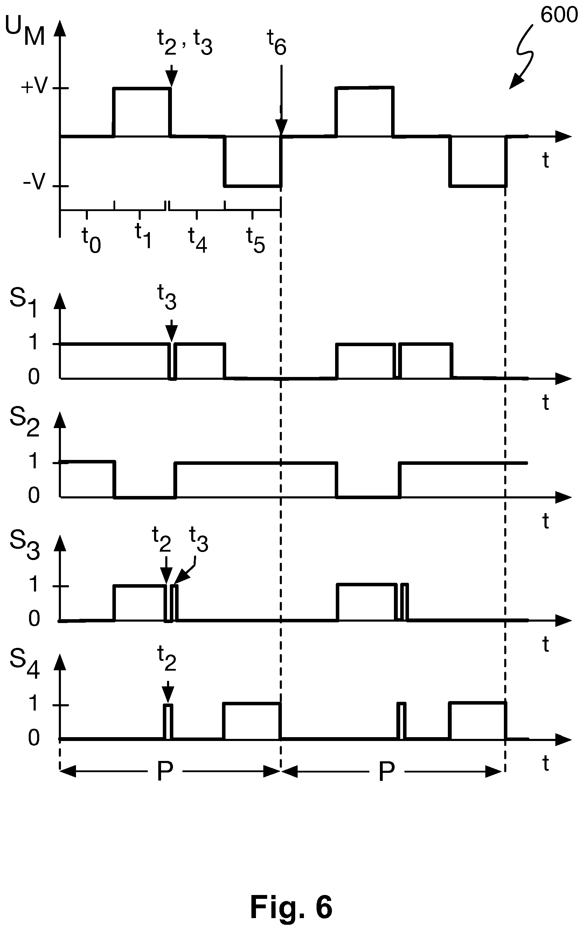

Die Funktionsweise der Schaltung 500 ist in Fig. 6 anhand des zeitlichen Verlaufs 600 der Konfiguration der Schalteinrichtung der Schaltung 500, insbesondere der Schaltzustände ihrer einzelnen Schalter $S_1$ bis $S_4$, illustriert.

Die Schaltzustände der Schalteinrichtung werden durch eine Steuerung (nicht dargestellt) im zeitlichen Verlauf schrittweise gemäß der nachfolgenden Sequenz mit den aufeinanderfolgenden Zeitintervallen $t_0$ bis $t_6$ in verschiedene Schaltzustände zu versetzt, wobei in den Diagrammen "1" einen geschlossenen Schalter und "0" einen geöffneten Schalter anzeigt und die Sequenz wenigstens einmal durchlaufen wird:

| Zeitintervall | $U_M$ | $S_1$ | $S_2$ | $S_3$ | $S_4$ |
|---|---|---|---|---|---|
| vor $t_0$ | Idle | 0 | 0 | 0 | 0 |
| $t_0$ | 0 (Ladevorgang Spule) | 1 | 1 | 0 | 0 |
| $t_1$ | +V | 1 | 0 | 1 | 0 |
| | Idle | 0 | 0 | 0 | 0 |
| $t_2$ | $+V \mapsto +V_1$ | 1 | 0 | 0 | 1 |
| $t_3$ | $+V_1 \mapsto 0$ | 0 | 1 | 1 | 0 |
| | Idle | 0 | 0 | 0 | 0 |
| $t_4$ | 0 (Ladevorgang Spule) | 1 | 1 | 0 | 0 |
| $t_5$ | -V | 0 | 1 | 0 | 1 |
| | Idle | 0 | 0 | 0 | 0 |
| $t_6$ | $-V \mapsto 0$ | 0 | 1 | 1 | 0 |

In Fig. 6 ist ein spezieller Fall gezeigt, bei dem diese Sequenz periodisch wiederholt wird (die Übergänge zwischen den aufeinander folgenden Perioden P sind durch vertikale gestrichelte Linien gekennzeichnet). Wie in der Tabelle dargestellt (aber in Fig. 6 nicht illustriert) wird nach jeder erfolgten Auf- oder Entladung der MEMS-Kapazität $C_M$ bis zu einem Zeitpunkt, an dem die Induktivität L wieder geladen werden muss, ein Ruhezustand hergestellt, in dem alle Schalter geöffnet sind ("Idle"-Zustand) und die MEMS-Kapazität $C_M$ "floatend" ist, d.h. dass sie mangels Verbindung mit einem definierten elektrischen Potenzial selbst kein definiertes elektrisches Potenzial aufweist. Dies dient dazu, zu verhindern, dass die in der MEMS-Kapazität $C_M$ beim Aufladen gespeicherte Ladung wieder, insbesondere zur Versorgungsquelle hin, abfließt bzw. die gerade entladene MEMS-Kapazität $C_M$ gleich wieder (teil-)geladen wird. Das heißt im Umkehrschluss auch, dass die Steuerungseinrichtung so ausgelegt sein sollte, dass der bzw. die relevanten Schalter (z.B. $S_3$) sofort geöffnet wird bzw. werden, sobald die Energie der Spule vollständig aufgebraucht wurde. Alternativ kann diese Funktion durch einen entsprechenden Aufbau des Schalters selbst mit übernommen werden.

Vor dem Zeitintervall $t_0$ sind alle Schalter geöffnet ("Idle"-Zustand) und die MEMS-Kapazität $C_M$ hat daher kein definiertes elektrisches Potenzial (schwebend bzw. floating). Im Zeitintervall $t_0$ liegt die "erste" Schaltungskonfiguration vor, bei der nur die Schalter $S_1$ und $S_2$ geschlossen sind, sodass der erste Strompfad durch die Induktivität L geschlossen ist und aufgrund eines von der Versorgungsspannung $U_V$ gespeisten Stroms entlang des ersten Strompfads in der Induktivität L ein Magnetfeld mit der zugehörigen magnetischen Energie aufgebaut wird. Die Spule wird somit mit Energie "aufgeladen".

Beim Übergang zum nachfolgenden Zeitintervall $t_1$ wird bei weiterhin geschlossenem Schalter $S_1$ der Schalter $S_2$ geöffnet und stattdessen der Schalter $S_3$ geschlossen, sodass dann eine "zweite" Schaltungskonfiguration vorliegt, bei der der zweite Strompfad von einem ersten Pol der Induktivität L über den geschlossenen Schalter $S_3$ bis zur MEMS-Kapazität $C_M$ freigeschaltet ist, sodass die in der Induktivität L inzwischen gespeicherte magnetische Energie einen Stromfluss entlang des zweiten Strompfads bewirkt, mittels dem die MEMS-Kapazität $C_M$ auf die positive Spannung $U_M = +V$ aufgeladen wird.

Es folgt ein (nicht in Fig. 6 illustrierter) Idle-Zustand, bei dem alle Schalter geöffnet sind, um zu vermeiden, dass die in der MEMS-Kapazität $C_M$ nun gespeicherte Ladung wieder zur Spannungsquelle für die Versorgungsspannung $U_V$ abfließen kann.

Im weiter nachfolgenden Zeitintervall $t_2$ (welches optional ist) ist der Schalter $S_3$ wieder geöffnet und stattdessen der Schalter $S_4$ geschlossen, sodass über den Schalter $S_4$ ein weiterer Strompfad freigeschaltet ist (entspricht insbesondere dem anspruchsgemäßen "vierten" Strompfad), über den die MEMS-Kapazität $C_M$ zumindest anteilig in die Pufferkapazität $C_B$ (zur Pufferung der Versorgungsspannung $U_V$) auf eine niedriger Spannung $U_M = +V_1$ entladen wird. So kann ein "Ladungsrecycling" in dem Sinne betrieben werden, dass ein Teil der Ladung der Pufferkapazität $C_B$ für den nächsten Aufbau eines Magnetfelds in der Induktivität L erneut genutzt werden kann und so der Wirkungsgrad der Schaltung 500 erhöht werden kann.

Alternativ dazu kann durch Schließen der Schalter $S_2$ und $S_4$ bei geöffneten Schaltern $S_1$ und $S_3$ eine Ladungsrückgewinnung aus der MEMS-Kapazität $C_M$ unmittelbar durch Bewirken eines entsprechenden Stroms durch die Induktivität L zum Aufbau magnetischer Energie in der Induktivität L genutzt werden (nicht illustriert).

Im Zeitintervall $t_3$ sind nur die Schalter $S_2$ und $S_3$ geschlossen, sodass die MEMS-Kapazität $C_M$ darüber vollständig gegen Masse entladen werden kann (dieser Schritt kann bei der vorgenannten Alternative entfallen, das die MEMS-Kapazität $C_M$ dort bereits im Zeitintervall $t_2$ entladen wird).

Es folgt wieder ein (nicht in Fig. 6 illustrierter) "Idle-Zustand, bei dem alle Schalter geöffnet sind, um zu vermeiden, dass die in der MEMS-Kapazität $C_M$ nun wieder unkontrolliert (teil-)geladen wird.

Während des nachfolgenden Zeitintervalls $t_4$ sind nur die Schalter $S_1$ und $S_2$ geschlossen, so dass wie im Zeitintervall $t_0$ die Induktivität über den ersten Strompfad mit magnetischer Energie aufgeladen wird. Der Stromfluss durch die Induktivität L wird dabei aus der Versorgungsspannung $U_V$ und anteilig aus der Pufferkapazität $C_B$ gespeist.

Im Zeitintervall $t_5$ wird bei weiterhin geschlossenem Schalter $S_2$ der Schalter $S_1$ geöffnet und der Schalter $S_4$ geschlossen, sodass Ladung aus der MEMS-Kapazität $C_M$ über S4 durch die Induktivität L und über $S_2$ abfließt, wobei aufgrund des Bestrebens der Induktivität L, den ursprünglichen Stromfluss durch sie aufrecht zu erhalten (Lenz'sche Regel), der Stromfluss anhält, bis die MEMS-Kapazität $C_M$ auf einen negativen Spannungswert geladen wird, der betragsmäßig insbesondere dem positiven Spannungswert +V entsprechen und somit bei -V liegen kann.

Es folgt wieder ein (nicht in Fig. 6 illustrierter) Idle-Zustand, bei dem alle Schalter geöffnet sind, um zu vermeiden, dass die in der MEMS-Kapazität $C_M$ nun gespeicherte Ladung wieder zur Spannungsquelle für die Versorgungsspannung $U_V$ abfließen kann.

Im Zeitintervall $t_6$ sind schließlich wieder nur die Schalter $S_2$ und $S_3$ geschlossen, sodass die MEMS-Kapazität $C_M$ darüber vollständig gegen Masse auf 0V entladen werden kann. Dann kann ein neuer Zyklus mit einem erneuten Durchlauf der Sequenz erfolgen.

Der optionale Schalter $S_5$ kann insbesondere wie folgt eingesetzt werden, um analog zur vorausgehend beschriebenen Ladungsrückgewinnung bei positiven Spannungen auch bei negativen Spannungen Ladungen zurückgewinnen zu können: Soll die MEMS-Kapazität $C_M$ beispielsweise von -V auf 0 entladen werden, so können z.B. $S_5$ und $S_3$ geschlossen werden. Jetzt baut sich wieder ein Strom in der Induktivität L auf.

Ist die MEMS-Kapazität $C_M$ leer, so können sofort $S_5$ und $S_3$ geöffnet und stattdessen $S_1$ und $S_2$ geschlossen werden, um den Strom in der Induktivität L weiter ansteigen zu lassen. Dann nimmt alles den oben bereits beschriebenen weiteren Verlauf.

Beispielhafte Ausführungsformen der zweiten Schaltung

Es folgen nun des Weiteren Erläuterungen zu beispielhaften Ausführungsformen der zweiten Schaltung, wobei zunächst von der herkömmliche Schaltung 700 aus Fig. 7 ausgegangen wird:

Die Schaltung 700 aus Fig. 7 stellt eine sogenannte Halbbrückenschaltung dar. Sie verfügt über zwei Versorgungsspannungsquellen 705 und 710, die zueinander komplementäre Spannungen liefern. Der zentrale Schaltungsast der Schaltung 700 weist eine mittels der Halbbrückenschaltung zu treibende Komponente auf, im vorliegenden Beispiel einen kapazitiven MEMS-Aktuator, wie etwa einen Piezoaktuator. Die MEMS-Kapazität des MEMS-Aktuators ist hier als $C_M$ bezeichnet. Ein in der Realität auftretender Ohm'scher Widerstand des zentralen Schaltungsasts ist, hier im Sinne eines Ersatzschaltbilds, durch den Widerstand R repräsentiert, der im Rahmen der weiteren Erläuterungen jedoch keine Rolle spielt.

Des Weiteren weist die Schaltung zwei Schalteinrichtungen 715 und 725 auf, die jeweils durch eine zugeordnete Steuerspannungsquelle 720 bzw. 730 variabler Steuerspannung ansteuerbar sind, so dass in Abhängigkeit von dieser jeweiligen Steuerspannung die dieser zugeordnete Schalteinrichtung (z.B. Schalter oder Schalttransistor) 715 bzw. 725 einen Strompfad zwischen der zugeordneten Versorgungsspannungsquelle 705 bzw. 715 und der MEMS-Kapazität $C_M$ durchgängig schaltet oder unterbricht. Durch alternierendes temporäres Durchgängigschalten der beiden Strompfade durch die Schalteinrichtungen 715 und 725 kann somit die MEMS-Kapazität $C_M$ abwechselnd auf eine positive bzw. eine negative Spannung V+ bzw. V-umgeladen werden, wodurch der MEMS-Aktuator entsprechend eine korrespondierende alternierende Bewegung ausführen bzw. antrieben kann.

Diese Art der Schaltung ist aber nicht sehr energieeffizient. Im Mittel muss bei der Schaltung 700 bei ihrem Betrieb insgesamt die Leistung

$$P_{total} = C_M \cdot U^2 \cdot f \qquad (10)$$

durch die Versorgungsspannungsquellen 705 und 710 aufgebracht werden.

Dabei beschreibt hier $C_M$ den Kapazitätswert der MEMS-Kapazität, U die Spitze-zu-Spitze-Spannung über der MEMS-Kapazität und $f$ die Frequenz der sich einstellenden Rechteckspannung. Beim Beispiel eines Mikroscanners als MEMS mit einer typischen MEMS-Kapazität seines Aktuators zum Antrieb des Ablenkelements von 100 pF, einem Spannungshub von 200 V ($\pm$100 V) und einer Frequenz von 25 kHz ergäbe sich somit eine theoretische Leistungsaufnahme von 100 mW.

Ein erster Grund für die eher geringe Energieeffizienz der Schaltung 700 liegt darin, dass aufgrund des hier auftretenden, aus der allgemeinen Schaltungstechnik bekannten sog. "Kondensator-Paradoxons" oder "Zwei-Kondensatoren-Paradoxons" (vgl. https://en.wikipedia.org/wiki/Two_capacitor_paradox) zumindest 50% der aufgenommenen Leistung beim Auf- bzw. Umladen der MEMS Kapazität $C_M$ direkt in Wärme umgesetzt werden. Das ist auch dann der Fall, wenn der Leitungswiderstand (z.B. aber auch R) infinitesimal klein wird.

Ein zweiter Grund liegt darin, dass der verbleibende Anteil der zugeführten Leistung für den Aufbau der unterschiedlichen Energieniveaus in der MEMS-Kapazität $C_M$, d.h. für das alternierende Umladen, benötigt wird, wobei jedoch beim Umladen aus der MEMS-Kapazität $C_M$ abfließende Ladung gegen Masse bzw. durch die Spannungsquellen abgeleitet wird, ohne zur weiteren Verwendung zurückgewonnen zu werden.

**Fig. 8** zeigt eine erste beispielhafte Ausführungsform 800 der zweiten Schaltung, die ein bipolares Ansteuern des Aktuators, genauer der MEMS-Kapazität $C_M$, ermöglicht. Hier genügt jedoch eine einzige Versorgungsspannungsquelle 805, die in ihrem Aufbau insbesondere der Versorgungsspannungsquelle 705 entsprechen kann und eine Gleichspannung als Versorgungsspannung $U_V$ der Schaltung 800 liefert, insbesondere an einem Einspeisungspunkt $E_1$. Typischerweise handelt es sich hierbei angesichts des Spannungsbedarfs des Aktuators um eine Hochspannungsquelle (im vorliegenden Kontext also um eine Spannungsquelle, die eine Versorgungsspannung liefern kann, die über den typischen Versorgungsspannungen von Logikschaltungen, insbesondere Halbleiterschaltungen, liegt). Die Versorgungsspannung kann betragsmäßig insbesondere größer als 10 V sein, insbesondere auch bei oder oberhalb von 100 V liegen.

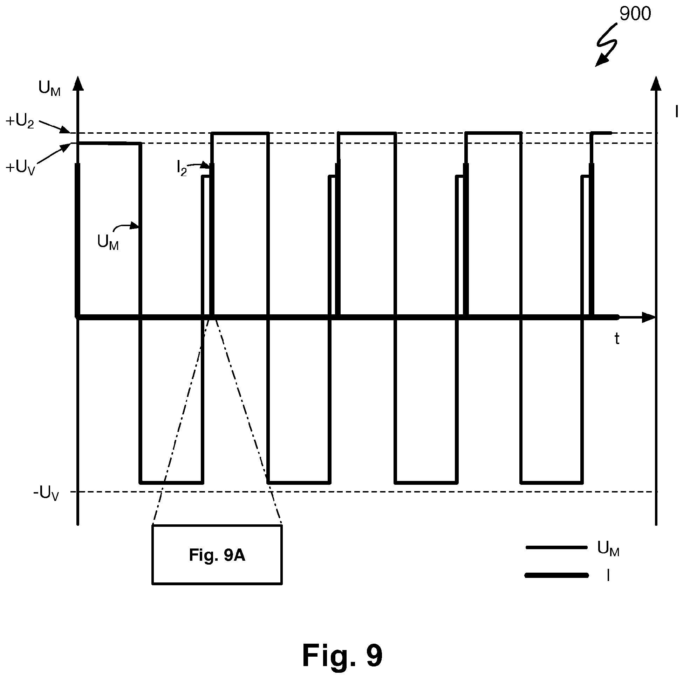

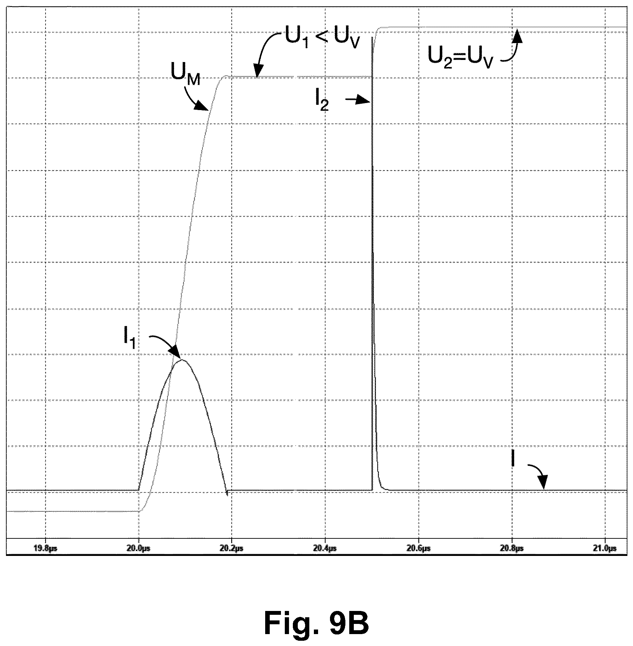

Anstelle der zweiten Versorgungsspannungsquelle 710 ist in der Schaltung 800 dagegen eine Induktivität $L_S$ ("Schwingkreisinduktivität") enthalten, die zusammen mit der MEMS-Kapazität $C_M$ (und R) und einer Schalteinrichtung 825 einen Schwingkreis bildet. _Die in Fig. 8 zusätzlich eingezeichnete Induktivität $L_{S2}$ ist in der Schaltung 800 nicht enthalten. Vielmehr soll durch $L_{S2}$ nur eine alternative Platzierung der Schwingkreisinduktivität $L_S$ aufgezeigt werden, auf die erst weiter unten unter Bezugnahme auf die Figur 9B eingegangen werden wird). Die Schalteinrichtung 825 kann in ihrem Aufbau insbesondere einer der vorausgehend beschriebenen Schalteinrichtungen 715 und 725 entsprechen. Der Schwingkreis ist an einem Ladeanschluss(punkt) A über eine Schalteinrichtung 815 mit dem von der Versorgungsspannungsquelle 805 gespeisten Einspeisepunkt $E_1$ elektrisch verbindbar, sodass bei geschlossener Schalteinrichtung 815 und zugleich geöffneter Schalteinrichtung 825 in einem dadurch definierten Nachladestromkreis 835 elektrische Energie von der Versorgungsspannungsquelle 805 in den Schwingkreis überführt werden kann. So kann die MEMS-Kapazität $C_M$ nachgeladen werden. Das auf das Nachladen folgende Schwingen des Schwingkreises, bei dem die MEMS-Kapazität $C_M$ wiederholt, insbesondere periodisch, umgeladen wird, erfolgt in einem dem Schwingkreis selbst entsprechenden Umlade-Stromkreis 840 der Schaltung 800 bei dann geschlossener Schalteinrichtung 825 und geöffneter Schalteinrichtung 815.

Die Anordnung der Schwingkreisinduktivität $L_S$ im Schwingkreis ist speziell so gewählt, dass sie sowohl beim o.g. Nachladen der MEMS-Kapazität $C_M$ über den Ladeanschluss A (bei geschlossener Schalteinrichtung 815 und geöffneter Schalteinrichtung 825) als auch beim wiederholten Umladen der MEMS-Kapazität $C_M$ beim elektrischen Schwingen des Schwingkreises (bei geöffneter Schalteinrichtung 815 und geschlossener Schalteinrichtung 825) vom jeweiligen durch die MEMS-Kapazität $C_M$ fließenden Strom durchflossen wird.

Während des Nachladens speichert die Schwingkreisinduktivität $L_S$ somit (magnetische) Energie, die sie bis zum Öffnen der Schalteinrichtung 815 zumindest anteilig (ein anderer Anteil wird im realen Fall im Widerstand R verbraucht) per temporärer Fortsetzung des Ladestroms (vgl. Lenz'sche Regel) zum noch weiteren Nachladen der MEMS-Kapazität $C_M$ (insbesondere auch über das Spannungsniveau der Energieversorgungsschaltung hinaus) zur Verfügung stellt. Die je Schwingungsperiode auftretende Dauer des geschlossenen Zustands der Schalteinrichtung 815 kann insbesondere derart optimiert sein, dass die Zuführung zusätzlicher Energie maximal effizient stattfindet.

Die Schalteinrichtung 815 ist dann derart gesteuert, dass sie die Versorgungsspannungsquelle 805 gerade dann mit dem Ladeanschluss A des Schwingkreises und somit (mittelbar) mit der MEMS-Kapazität $C_M$ verbindet, wenn die Spannung über der MEMS-Kapazität $C_M$ betragsmäßig ein erstes Maximum $U_1$ mit $U_1 < U_V$ aufweist und sie die gleiche Polarität wie die von der Versorgungsspannungsquelle 805 bereitgestellte Spannung $U_V$ aufweist.

Wenn die Schalteinrichtung 815 nachfolgend wieder geöffnet wird, wird der Stromfluss aus der Versorgungsspannungsquelle 805 in den Schwingkreis unterbrochen und der Ladestrom jn die MEMS-Kapazität $C_M$ wird als Folge ebenso unterbrochen oder jedenfalls, soweit noch ein zusätzlicher induktiv bedingter Stromfluss im Schwingkreis vorliegt, unkontrolliert. Die Schalteinrichtung 815 sollte daher vorteilhaft solange geschlossen bleiben, bis der Ladestrom (wieder) auf Null gesunken ist und genau dann geöffnet werden, sodass im Anschluss das im Vergleich zur Versorgungsspannung $U_V$ aus der Versorgungsspannungsquelle 805 nun höhere Spannungsniveau in der MEMS-Kapazität nicht zu einem ungewollten Stromfluss zurück zur Versorgungsspannungsquelle 805 führt.

Die Dauer des Nachladevorgangs ist damit vordefiniert. Sie sollte normalerweise nicht variiert werden, da sonst das Risiko besteht , dass der Strompfad unterbrochen wird und der Strom durch die Spule zu Spannungsspitzen führt. Als Einstellgröße für die resultierende MEMS-Spannung ist es daher stattdessen insbesondere möglich, eine variable Höhe der Versorgungsspannung $U_V$ aus der Versorgungsspannungsquelle 805 zu nutzen.

Wäre die Schalteinrichtung 825 nicht vorhanden oder dauerhaft geschlossen, dann wäre die Schwingungsfrequenz des Schwingkreises durch seine gemäß der Beziehung (1) (vgl. oben) durch die Werte von $C_M$ und $L_S$ bedingten Resonanzfrequenz $f_0$ gegeben.

Speziell im Fall von Mikroscannern, liegen typische Resonanzfrequenzen von Ablenkelementen (Spiegelplatten) im Bereich von bis zu maximal 100 kHz. Die Kapazität des piezoelektrischen Materials liegt typischerweise in einem Bereich bis zu ca. 150 pF. In erster Linie könnte man nun als Schwingkreisinduktivität $L_S$ eine Spule mit geeignetem Induktivitätswert wählen, sodass die Resonanzfrequenz $f_0$ des elektrischen Schwingkreises genau der Resonanzfrequenz des Ablenkelements entspricht.

Es zeigt sich jedoch, dass gemäß der Beziehung (1), nach L aufgelöst, unpraktikabel große Induktivitätswerte resultieren:

$$L_S = \frac{1}{(2\pi f_0)^2 \cdot C_M} = \frac{1}{(2\pi \cdot 100 kHz)^2 \cdot 150 pF} = 16,9 \, mH$$

Derart große Induktivitätswerte für $L_S$ in Verbindung mit kleinen Wicklungswiderständen wären jedoch sehr platzaufwändig und daher in Produkten, in denen es auf eine möglichst kleine Bauform des MEMS ankommt, wie etwa in einer AR/VR-Brille, ungünstig. Je kleiner die Resonanzfrequenz $f_0$ und/oder der Wert für $C_M$ spezifiziert wird, desto größer wird die notwendige Induktivität $L_S$. Bei $f_0$ = 30 kHz und $C_M$ = 100 pF würde sich für $L_S$ bereits ein Wert von fast 300 mH ergeben.

Sofern $L_S$, insbesondere aus Platzgründen, klein gehalten werden muss, ist eine Schaltungsimplementierung mit einem klassischen, dauerhaft geschlossenen Schwingkreis daher ungünstig bis unmöglich.

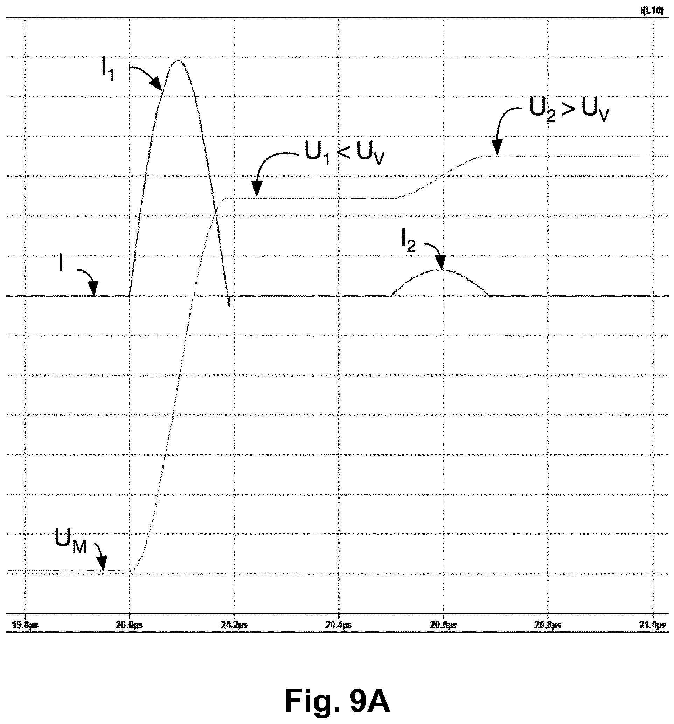

Wie in **Fig. 9** anhand der Strom- und Spannungsverläufe 900 an der MEMS-Kapazität $C_M$ illustriert, kann der Betrieb der Schaltung 800 daher insbesondere wie folgt erfolgen, wobei eine (nicht dargestellte) Steuerung, wie etwa ein computerprogrammgesteuerter Mikrocontroller oder eine festverdrahtete Steuerschaltung, zur Ansteuerung der Schalteinrichtungen zum Einsatz kommt: Zunächst wird bei geschlossener Schalteinrichtung 815 bei zugleich geöffneter Schalteinrichtung 825 ein Strompfad von der Versorgungsspannungsquelle 805 über den Ladeanschluss A und die Schwingkreis-Induktivität $L_S$ die zunächst ungeladene MEMS-Kapazität $C_M$ freigeschaltet, um die MEMS-Kapazität $C_M$ mittels eines Ladestroms $I_2$ aus der Versorgungsspannungsquelle 805 erstmals auf einen Spannungspegel +V zu laden. Bei ausreichender Ladezeit steigt dabei die Spannung über der MEMS-Kapazität $C_M$ bis über die Höhe der Versorgungsspannung +V = $U_V$ hinaus an (vgl. den in Fig 9A gezeigten vergrößerten Ausschnitt aus dem Spannungsverlauf). Die Ladezeit ist dabei im Wesentlichen durch die jeweiligen Werte von $L_s$ und $C_m$ bestimmt.

Der Schwingkreis ist nun mit Energie versorgt und beginnt nach dem Öffnen der Schalteinrichtung 815 und Schließen der Schalteinrichtung 825 im Sinne einer gedämpften Schwingung zu schwingen. Diese Schwingung wird jedoch dadurch moduliert und somit hin zu einer niedrigeren Schwingungsfrequenz verändert, dass in jeder Schwingungsperiode die Schalteinrichtung 825 für eine bestimmten zeitlichen Anteil der Schwingungsperiode geöffnet wird, wenn die Spannung $U_M$ an der MEMS-Kapazität $C_M$ während des Schwingvorgangs gerade ein Maximum erreicht und somit die im Schwingkreis vorhandene, zwischen $C_M$ und $L_S$ hin und her schwingende Energie momentan, zumindest weitgehend, als elektrische Energie in $C_M$ gespeichert ist. Der zeitliche Anteil an der Schwingungsperiode kann insbesondere etwa 50% sein, also etwa der halben Periodendauer entsprechen. Genauer wären es 50% abzüglich der Zeit, die der Schwingkreis zum Umladen zwischen zwei Spannungsniveaus braucht.

Zwischenzeitlich dem Schwingkreis, insbesondere am Widerstand R und den Leitungen durch, insbesondere Ohm'sche, Verluste verloren gegangene Energie (daher gedämpfte Schwingung), kann nun durch regelmäßiges temporäres Schließen der Schalteinrichtung 815 und Öffnen der Schalteinrichtung 825 durch erneutes Aufladen von $C_M$ mit einem temporären Ladestrom $I_2$ kompensiert werden. Dieses Nachladen erfolgt vorzugsweise dann, wenn die Spannung $U_M$ über der MEMS-Kapazität $C_M$ während des Schwingvorgangs gerade ihren in der aktuellen Schwingungsperiode maximalen Wert erreicht. Dies muss jedoch nicht zwingend in jeder Schwingungsperiode bzw. nach jedem Umladen erfolgen. Vielmehr ist es auch möglich, das Nachladen nur nach zwischenzeitlichem, mehrfachem Umladen bzw. erst nach mehreren Schwingungsperioden vorzunehmen, z.B. jedes m-te Mal, mit $m \in \mathbb{N}$, z.B. mit m = 2.

Das Nachladen kann allgemein sowohl mit einer positiv gepolten Hochvolt-Quelle zu Zeiten stattfinden, zu denen der Schwingkreis pausiert ist und die Spannung über dem MEMS gerade maximal ist, als auch mit einer negativ gepolten Hochvolt-Quelle zu Zeiten, zu denen der Schwingkreis pausiert ist und die Spannung über der MEMS-Kapazität $C_M$ gerade minimal ist. In diesem Fall ergibt sich ein etwas gleichmäßigeres Spannungssignal über der MEMS-Kapazität

$C_M$.

Der Schwingkreis wird somit regelmäßig pausiert, um einerseits seine Schwingungsfrequenz $f_S$, zu erhalten, die gegenüber der gemäß der Beziehung (1) (vgl. oben) durch die Werte von $C_M$ und $L_S$ bedingten Resonanzfrequenz $f_0$ des Schwingkreises (im dauerhaft geschlossenen Fall) herabgesetzt ist, und andererseits die bei der elektrischen Schwingung verlorene Energie nachzuladen.

Ein wesentlicher Vorteil dieser Schaltung ist dabei, dass die beim Umladen von $C_M$ fließenden Ladungen nicht mehr einfach gegen Masse abgeleitet werden, sondern sie stehen der fortgesetzten elektrischen Schwingung im Schwingkreis weiterhin zur Verfügung. Außerdem werden die negativen Effekte des Kondensator-Paradoxons beim Nachladen von $C_M$ reduziert, in dem der Nachladestrom über die Schwingkreis-Induktivität $L_s$ geführt wird und abrupte Spannungsänderungen über $C_M$ vermieden werden. So lässt sich ein höherer Wirkungsgrad und somit eine höhere Energieeffizienz als bei der Schaltung 700 aus Fig. 7 erreichen.

Zudem können die Werte von $C_M$ und $L_S$ kleiner gewählt werden, als es im Falle eines klassischen Schwingkreises zur Erreichung der gewünschten Schwingungsfrequenz $f_S$ erforderlich wäre. So können besonders platzsparende Schaltungsimplementierungen erreicht und auch die Abhängigkeiten von Bauteiltoleranzen eliminiert werden.

Das Funktionsprinzip der Schaltung 800 aus Fig. 8 beim Nachladen wird nun unter Bezugnahme auf **Fig. 9A** genauer beschrieben, die gemäß einem Ausführungsbeispiel den zeitlichen Verlauf des Stroms I und der Spannung $U_M$ an der MEMS-Kapazität $C_M$ während des Umladens beim Schwingen sowie eines nachfolgenden Nachladevorgangs detaillierter zeigt:

Beim Umladen der MEMS-Kapazität $C_M$ ist die Schalteinrichtung 815 geöffnet und die Schalteinrichtung 825 geschlossen, so dass auch der Umlade-Stromkreis 840 und somit der Schwingkreis geschlossen sind. Das Umladen tritt mit alternierendem Vorzeichen von Strom und Spannung während des Schwingens im Schwingkreis auf. In Fig. 9A ist mit der durch $I_1$ (Umladestrom) bezeichneten Welle im zeitlichen Verlauf des Stroms I ein Umladen der MEMS-Kapazität $C_M$ dargestellt, bei der sie gleichpolig zur Versorgungsspannung $U_V$ umgeladen wird. Durch diesen Umladevorgang wird die MEMS-Kapazität $C_M$ auf den Spannungswert $U_M = U_1$ aufgeladen, der noch unterhalb der Versorgungsspannung $U_V$ liegt ($U_1 < U_V$). Dies liegt daran, dass im realen Schwingkreis Verluste auftreten (hier durch den ohmschen parasitären Widerstand R repräsentiert).

Zeitlich nachgelagert erfolgt in derselben Schwingungsperiode ein Nachladevorgang, der dazu dient, die aufgetretenen Verluste durch Energiezufuhr aus der Versorgungsspannungsquelle 805 wieder zu kompensieren. Hierzu wird mittels Schließen der Schalteinrichtung 815 und Öffnen der Schalteinrichtung 825 der Nachlade-Stromkries 835 geschlossen und darin ein aus der Versorgungsspannungsquelle 805 gespeister Nachladestrom $I_2$ erzeugt, welcher einerseits die Schwingkreis-Induktivität $L_S$ und andererseits auch die MEMS-Kapazität $C_M$ mit Energie auflädt.

Erreicht die Spannung $U_M$ über der MEMS-Kapazität $C_M$ den gleichen Wert, wie von der Versorgungsspannungsquelle 805 am Ladeanschluss A zur Verfügung gestellt, so ist die in der Schwingkreis-Induktivität $L_S$ gespeicherte Energie gerade maximal groß. Diese in der Schwingkreis-Induktivität $L_S$ gespeicherte Energie führt im weiteren Verlauf des Nachladevorgangs dazu, dass die MEMS-Kapazität $C_M$ auf ein höheres Spannungsniveau $U_M = U_2$ aufgeladen wird, das sogar über dem von der Versorgungsspannungsquelle 805 bereitgestellten Spannungsniveau $U_V$ liegt ($U_2 > U_V$).

Die Schalteinrichtung 815 bleibt während dieser Zeit durchgehend geschlossen, doch sobald die Energie in der Schwingkreis-Induktivität aufgebraucht ist, wird sie durch die Steuerung geöffnet. Die Zeitspanne, in der die Schalteinrichtung 815 geschlossen ist, entspricht in etwa der halben Periodendauer der Resonanzfrequenz des Schwingkreises (die sich bei dauerhaft geschlossenem Schwingkreis ergäbe).

Auf diese Weise lassen sich die Ladeverluste, welche durch das "Kondensator-Paradoxon" beziehungsweise allgemein durch das direkte Nachladen (ohne zwischengeschaltete Induktivität) über eine Spannungsquelle hervorgerufen werden, minimieren oder sogar vollständig eliminieren. Dies ist möglich, weil sich durch die spezielle Anordnung der Schwingkreis-Induktivität $L_S$ im Schwingkreis (d.h. eine Lage, die sowohl im Umlade-Stromkreis 835 als auch im Nachlade-Stromkreis 840 liegt) die Schwingkreis-Induktivität $L_S$ in beiden Stromkreisen als induktiver temporärer "Stromlieferant" wirken kann, welcher abrupte Spannungsänderungen über $C_M$ und so die Grundlage für das Kondensator-Paradoxon vermeidet.

Ein weiterer Vorteil einer solchen Anordnung der Schwingkreis-Induktivität $L_S$ kann auch darin bestehen, dass sich ein gleichmäßigerer (gefilterter bzw. geglätteter) Stromverlauf während des Nachladevorgangs ergibt. Dies lässt sich aus einem Vergleich der beiden **Figuren 9A und 9B** entnehmen, wobei **Fig. 9B** zu den in Fig. 9A gezeigten Verläufen korrespondierende Strom- und Spannungsverläufe an der MEMS-Kapazität $C_M$ zeigt, die sich bei einer beispielhaften Abwandlung der Schaltung 800 aus Fig. 8 zeigen würde, wenn dort die Schwingkreis-Induktivität $L_S$ an die mit "$L_{S2}$" gekennzeichnete Stelle versetzt wäre. Bei dieser Abwandlung würde das Nachladen der MEMS-Kapazität $C_M$ über die Schalteinrichtung 815 direkt erfolgen, d.h. ohne zwischengeschaltete Schwingkreis-Induktivität $L_S$ im Nachlade-Stromkreis. Aufgrund des Wegfalls der induktiven Wirkung der Schwingkreis-Induktivität $L_S$ beim Nachladen, würde der Nachladestrom $I_2$ zu Beginn rapide ansteigen und dann exponentiell abflachen.

Bei der Schaltung 800 aus Fig. 8 baut sich dagegen, wie in Fig. 9A gegenüber Fig. 9B zu sehen ist, der Stromfluss $I_2$ beim Nachladen über die Schwingkreis-Induktivität $L_S$ zunächst langsamer auf und sinkt auch langsamer wieder ab.

Dazwischen folgt die Stromstärke $I_2$ einem für Sinuswellen im Bereich ihres Maximums typischen Verlauf.

Ferner orientiert sich die Nachladedauer an der halben Periodendauer, die sich ergäbe, wenn die Schalteinrichtung 825 dauerhaft geschlossen wäre (Resonanzfall). Die (halbe) Periodendauer wird vornehmlich durch die Schwingkreis-Induktivität $L_S$ und MEMS-Kapazität $C_M$ definiert. Zum Beispiel würde sich bei einer Schwingkreis-Induktivität $L_S = 47 \, \mu H$ und einer MEMS-Kapazität $C_M = 100 \, pF$ folgende halbe Periodendauer T/2 ergeben:

$$\frac{T}{2} = \pi \cdot \sqrt{LC} = \pi \cdot \sqrt{47 \mu H \cdot 100 \, pF} = 215 \, ns$$

Die resultierende Nachladedauer (im Falle der Figuren 8 und 9A) ist damit typischerweise deutlich länger als im Falle einer direkten Nachladung ohne Schwingkreis-Induktivität $L_S$ im Nachlade-Stromkreis 840 (Fall der Fig. 9B) (ausgehend von 5 RC-Zeitkonstanten $\tau$), welche nur durch den parasitären Widerstandswert R begrenzt wird:

$$5 \cdot \tau = 5 \cdot RC = 5 \cdot 50 \, \Omega \cdot 100 \, pF = 25 \, ns$$

Im Vergleich zum Fall der Fig. 9B, führt im Fall der Figuren 8 und 9A die längere Nachladedauer neben einem gleichmäßigeren Stromverlauf zusätzlich auch noch zu einem geringeren Spitzenwert des Nachladestroms. Die sowohl niederfrequenteren als auch schwächeren Anteile im Spektrum des Nachladestroms $I_2$ und der zusätzlich gleichmäßigere Verlauf sind damit insgesamt vorteilhaft, weil sie tendenziell weniger Störungen in benachbarten elektrischen Schaltungen hervorrufen.

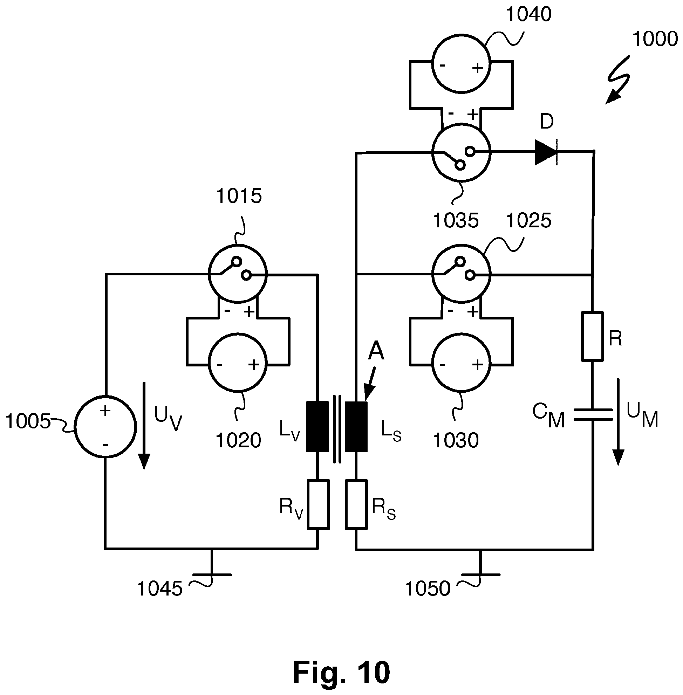

**Fig. 10** illustriert eine zweite beispielhafte Ausführungsform 1000 der zweiten Schaltung, mit einem pausierbaren Schwingkreis sowie mit einer über ein gekoppeltes Spulenpaar induktiv an den Schwingkreis gekoppelten Hochspannungsquelle 1005 zur Bereitstellung einer Versorgungsspannung $U_V$ für die Schaltung 1000. Die Spannungsquelle 1005 kann alternativ, je nach Windungsverhältnis des Spulenpaares, auch eine Niederspannungsquelle sein.

Konkret weist die Schaltung 1000 zwei galvanisch entkoppelte Schaltungsteile, vorzugsweise einschließlich entkoppelter erster und zweiter Massen 1045 und 1050, auf, die über ein aus einer ersten Kopplungsspule $L_V$ und einer zweiten Kopplungsspule $L_S$ bestehendes Spulenpaar induktiv gekoppelt sind. Die zweiten Kopplungsspule $L_S$ stellt zugleich die Schwingkreis-Induktivität des Schwingkreises und den Ladeanschluss A dar, über den die Energie zum Nachladen des Schwingkreises induktiv eingespeist werden kann. Die Kopplungsspulen weisen zudem jeweils einen Ohm'schen Widerstand $R_V$ bzw. $R_S$ auf, der hier jeweils im Sinne eines Ersatzschaltbilds dargestellt ist.

Der erste Schaltungsteil weist eine Schaltungsschleife auf, die neben der Hochspannungsquelle 1005 und der ersten Kopplungsspule $L_V$ (mit $R_V$) noch eine erste Schalteinrichtung 1015 mit einer zugeordneten Steuerspannungsquelle 1020 zu ihrer zeitlich variablen Ansteuerung enthält. In Abhängigkeit vom momentanen Schaltzustand der Schalteinrichtung 1015 ist die Schleife und somit der Strompfad durch die erste Kopplungsspule $L_V$ geschlossen oder unterbrochen, so dass sich über die Steuerspannungsquelle 1020 die induktive Wirkung der ersten Kopplungsspule $L_V$ und somit eine induktive Energieübertragung auf die zweite Kopplungsspule $L_S$ im Schwingkreis steuern lässt.

Der Schwingkreis weist wiederum neben der als Schwingkreisinduktivität vorgesehenen zweiten Kopplungsspule $L_S$ die anzusteuernde MEMS-Kapazität $C_M$ eines MEMS-Aktuators (nebst deren Ohm'schen Widerstand R) sowie eine zweite Schalteinrichtung 1025 mit einer zugeordneten Steuerspannungsquelle 1030 zu ihrer zeitlich variablen Ansteuerung auf. Entsprechend der Schalteinrichtung 825 aus Fig. 8, kann mit der zweiten Schalteinrichtung 1025 der Schwingkreis pausiert werden.

Zusätzlich weist der Schwingkreis noch einen parallel zur zweiten Schalteinrichtung 1025 geschalteten Schaltungsast mit einer Diode D und einer dritten Schalteinrichtung 1035 mit einer zugeordneten Steuerspannungsquelle 1040 zu ihrer zeitlich variablen Ansteuerung auf.

Sind die Schalteinrichtungen 1015 und 1035 geöffnet, so dass sie die durch sie verlaufenden Strompfade unterbrechen, während die Schalteinrichtung 1025 geschlossen ist, ist der Schwingkreis geschlossen und "schwingt". Wenn jedoch die dabei auftretenden Energieverluste wieder ausgeglichen werden sollen (vgl. Fig. 9), dann werden die Schalteinrichtungen 1015 und 1035 geschlossen und die Schalteinrichtung 1025 geöffnet.

Nun kann durch einen einmaligen Strompuls (oder durch mehrere aufeinanderfolgende Strompulse bei entsprechendem mehrfachem Schließen und Öffnen der Schalteinrichtung 1015, ein zeitlich variabler Strom, insbesondere Wechselstrom, durch die erste Kopplungsspule $L_V$ generiert werden, der durch induktive Energieübertragung über das Spulenpaar einen Induktionsstrom im zweiten Schaltungsteil bewirkt, der über die Schalteinrichtung 1035 verläuft und über die Diode D gleichgerichtet wird. So kann die MEMS-Kapazität $C_M$ mit Gleichstrom (der zeitlich variabel sein kann) nachgeladen werden. Dies erfolgt während einer Zeitspanne, in der die aus der vorangegangenen Schwingung im Schwingkreis resultierende Spannung $U_M$ über der MEMS-Kapazität $C_M$ maximal und gleichpolig ist, wie die in der zweiten Kopplungsspule $L_S$ generierte Induktionsspannung. Wird die Richtung der Diode umgedreht, so ergibt sich analog dazu die Möglichkeit, den Schwingkreis "nachzuladen", wenn die Spannung über der MEMS-Kapazität gerade minimal ist. Durch einen zusätzlichen Strompfad besteht darüber hinaus auch die Möglichkeit der bipolaren Nachladung.

Anstelle der Gleichspannungsquelle 1005 kann auch eine Wechselspannungsquelle eingesetzt werden, so dass das Erzeugen von Gleichstrompulsen zur Erzeugung eines zeitlich variierenden Stroms durch die erste Kopplungsspule $L_V$ entfallen kann.

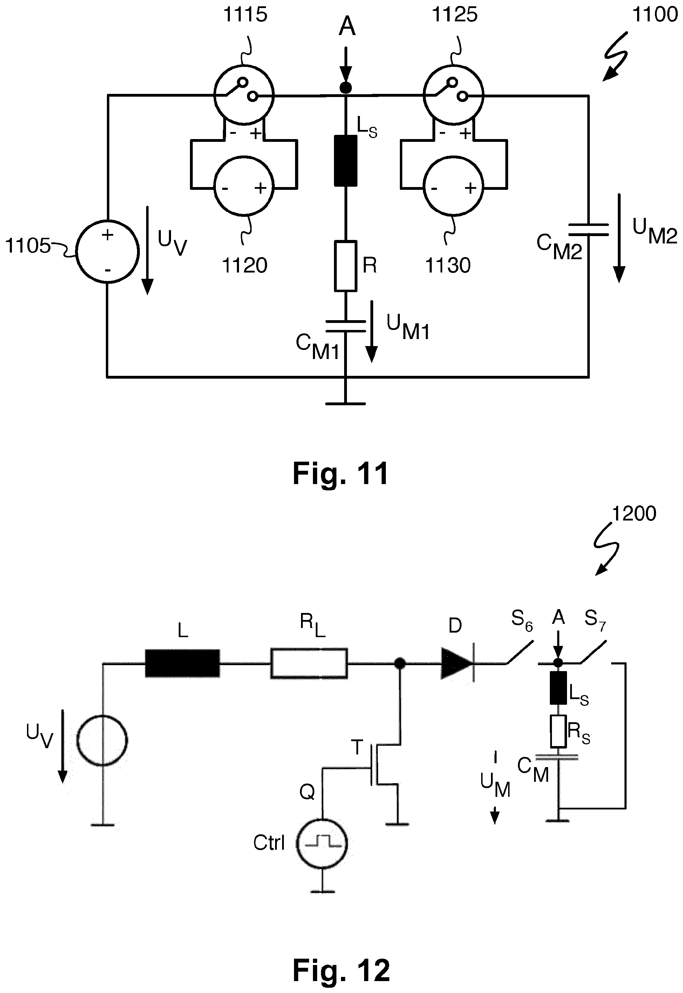

**Fig. 11** illustriert eine dritte beispielhafte Ausführungsform 1100 der zweiten Schaltung mit einem pausierbaren Schwingkreis, die aus der Schaltung 800 aus Fig. 8 hervorgeht, indem die dortige einzige Schwingkreis-Kapazität und zugleich MEMS-Kapazität $C_M$ auf zwei separate MEMS-Kapazitäten $C_{M1}$ und $C_{M2}$ aufgeteilt wird. In der Schaltung 1100 entsprechen im Hinblick auf einen Vergleich mit der Schaltung 800 die Versorgungsspannungsquelle 1105 der Versorgungsspannungsquelle 805, und die Schalteinrichtungen 1115 und 1125 (mit zugeordneten Steuerspannungsquellen 1120, 1130) den Schalteinrichtungen 815 bzw. 825 (mit zugeordneten Steuerspannungsquellen 820 bzw. 830).

Aufgrund der Aufteilung der Schwingkreis-Kapazität auf die zwei separaten MEMS-Kapazitäten $C_{M1}$ und $C_{M2}$ in der gezeigten Anordnung, bei der die Schwingkreis-Induktivität $L_S$ und die Schalteinrichtung 1125 zwischen die beiden MEMS-Kapazitäten $C_{M1}$ und $C_{M2}$ geschaltet sind, ergeben sich beim (pausierbaren) Schwingen des Schwingkreises Spannungen $U_{M1}$ bzw. $U_{M2}$ an den MEMS-Kapazitäten $C_{M1}$ und $C_{M2}$, die gegeneinander phasenverschoben sind und speziell bei gleichen Kapazitätswerten eine gleiche Amplitude aufweisen können. Die MEMS-Kapazitäten $C_{M1}$ und $C_{M2}$ können insbesondere Teil eines selben MEMS-Aktuators sein, sodass dessen ein differenzieller Antrieb ermöglicht ist. Beispielsweise können die MEMS-Kapazitäten $C_{M1}$ und $C_{M2}$ jeweils als Bestandteils eines Piezoaktuators derart konfiguriert sein, dass sie, um insbesondre 180°, phasenversetzt in entgegengesetzte Richtungen wirkende piezoelektrische Kräfte bewirken.

Beispielhafte Ausführungsformen für eine Kombination von erster Schaltung und zweiter Schaltung

Wie schon erwähnt, können die vorausgehend eingeführten Schaltungstypen "erste Schaltung" und "zweite Schaltung" auch vorteilhaft kombiniert werden. Während es dabei die erste Schaltung insbesondere erlaubt, für den Betrieb von Aktuatoren, insbesondere MEMS-Aktuatoren, erforderliche hohe Spannungen auch ohne Verwendung einer Hochspannungsquelle als solche bereitzustellen, und stattdessen eine Niederspannungsquelle, die insbesondere durch eine Primärbatterie oder Sekundärbatterie eines mobilen Geräts gegeben sein kann, zu verwenden, erlaubt die zweite Schaltung insbesondere eine platzsparende Bauform der Schaltung. Zudem dienen beide Schaltungen einer Steigerung der energetischen Effizienz.

**Fig. 12** illustriert eine erste beispielhafte Ausführungsform 1200 einer solchen kombinierten Schaltung zur Ansteuerung eines Aktuators, insbesondere eines MEMS-Aktuators, zum Antrieb einer Schwingungsbewegung in einem MEMS.

Die Schaltung 1200 kann als Fortentwicklung bzw. Variante der ersten Schaltung aus Fig. 2A betrachtet werden, so dass im Folgenden nur noch auf die Unterschiede dazu eingegangen wird.

Ein wesentlicher Unterschied besteht darin, dass in der Schaltung 1200 entsprechend dem Konzept der zweiten Schaltung ein pausierbarer Schwingkreis mit der MEMS-Kapazität $C_M$ als Schwingkreis-Kapazität enthalten ist. Der Schwingkreis enthält zudem eine Schwingkreis-Induktivität $L_S$ sowie eine Schalteinrichtung $S_7$ zum temporären Unter-brechen (pausieren) des Schwingkreises.

Zum Nachladen der MEMS-Kapazität $C_M$ wird, wenn sie ihren maximalen Spannungswert im Rahmen der aktuellen Schwingungsperiode erreicht hat, der Schwingkreis mittels der Schalteinrichtung $S_7$ unterbrochen (pausiert) und durch Schließen der weiteren Schalteinrichtung $S_6$ ein Strompfad zwischen der im linken Teil der Fig. 12 dargestellten Hochsetzstellerschaltung und dem Schwingkreis, insbesondere der MEMS-Kapazität $C_M$, geschlossen.

Das Versorgen des Schwingkreises mit Energie kann hier somit allein mittels einer Niederspannungsquelle zur Bereitstellung der Versorgungsspannung $U_V$ erfolgen, ohne dass eine Hochspannungsquelle erforderlich wäre.

Die Rückführungsschleife über die Schalteinrichtung $S_{2'}$ sowie die Pufferkapazität Cs aus der Schaltung 200 aus Fig. 2A können zudem entfallen, da die Energie im Schwingkreis bis auf die typischen, insbesondere Ohm'schen, Verluste im Wesentlichen erhalten wird, sodass eine Pufferung nicht mehr erforderlich ist.

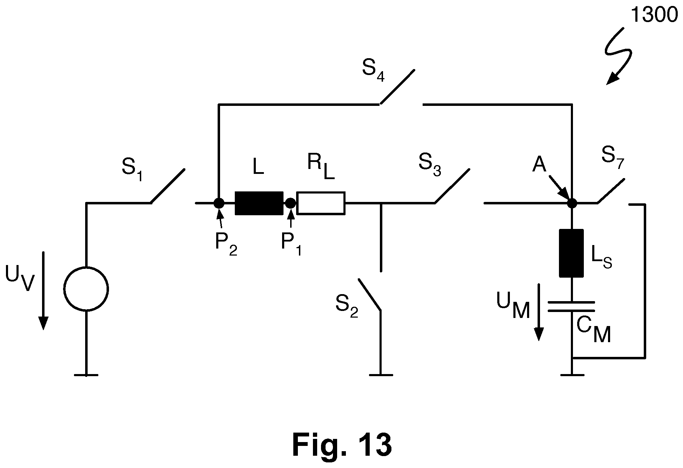

**Fig. 13** illustriert eine zweite beispielhafte Ausführungsform 1300 einer kombinierten Schaltung zur Ansteuerung eines Aktuators, insbesondere eines MEMS-Aktuators, zum Antrieb einer Schwingungsbewegung in einem MEMS.

Die Schaltung 1300 kann als Fortentwicklung bzw. Variante der ersten Schaltung aus Fig. 5 betrachtet werden, so dass im Folgenden nur noch auf die Unterschiede dazu eingegangen wird.

Ein wesentlicher Unterschied besteht darin, dass in der Schaltung 1300 wiederum ein pausierbarer Schwingkreis mit der MEMS-Kapazität $C_M$ als Schwingkreis-Kapazität und einer Schwingkreis-Induktivität $L_S$ sowie einer Schalteinrichtung $S_7$ zum temporären Unterbrechen (pausieren) des Schwingkreises enthalten ist.

Zum Nachladen der MEMS-Kapazität $C_M$ wird einerseits, wenn sie ihren maximalen positiven Spannungswert im Rahmen der aktuellen Schwingungsperiode erreicht hat, der Schwingkreis mittels der Schalteinrichtung $S_7$ unter-brochen (pausiert) und durch Schließen zumindest einer der Schalteinrichtungen $S_3$ und $S_4$ wird ein Strompfad zwischen der im linken Teil der Fig. 13 dargestellten Hochsetzstellerschaltung und dem Schwingkreis, insbesondere der MEMS-Kapazität $C_M$, geschlossen. Die Hochsetzstellerschaltung ist dabei so bezüglich ihrer Schalterstellungen konfiguriert (z.B.: $S_1$ und $S_3$ geschlossen, $S_2$ und $S_4$ offen, oder: $S_1$ und $S_4$ geschlossen, $S_2$ und $S_3$ offen), dass sie eine Versorgungsspannung an den Schwingkreis, bzw. genauer die MEMS-Kapazität $C_M$, liefert, die gleichpolig zur (positiven) Spannung $U_M$ über der MEMS-Kapazität $C_M$ ist.

Andererseits kann zum (zusätzlichen) Nachladen der MEMS-Kapazität $C_M$, wenn sie ihren maximalen negativen Spannungswert im Rahmen der aktuellen Schwingungsperiode erreicht hat, der Schwingkreis wieder mittels der Schalteinrichtung $S_7$ unterbrochen (pausiert) und durch Schließen zumindest einer der Schalteinrichtungen $S_3$ und $S_4$ wird ein Strompfad zwischen der Hochsetzstellerschaltung und dem Schwingkreis, insbesondere der MEMS-Kapazität $C_M$, geschlossen. Die Hochsetzstellerschaltung ist dabei so bezüglich ihrer Schalterstellungen konfiguriert (z. B: $S_2$ und $S_4$ geschlossen, $S_1$ und $S_3$ offen, oder: $S_2$ und $S_3$ geschlossen, $S_1$ und $S_4$ offen), dass sie eine Versorgungsspannung an den Schwingkreis, bzw. genauer die MEMS-Kapazität $C_M$, liefert, die gleichpolig zur (negativen) Spannung $U_M$ über der MEMS-Kapazität $C_M$ ist.

Auch bei der Schaltung 1300 kann das Versorgen des Schwingkreises mit Energie allein mittels einer Niederspannungsquelle zur Bereitstellung der Versorgungsspannung $U_V$ erfolgen, ohne dass eine Hochspannungsquelle erforderlich wäre. Zudem kann auch die Pufferkapazität $C_B$ aus der Schaltung 500 aus Fig. 5 wieder entfallen, da die Energie im Schwingkreis bis auf die typischen, insbesondere Ohm'schen, Verluste im Wesentlichen erhalten wird, sodass eine Pufferung nicht mehr erforderlich ist.

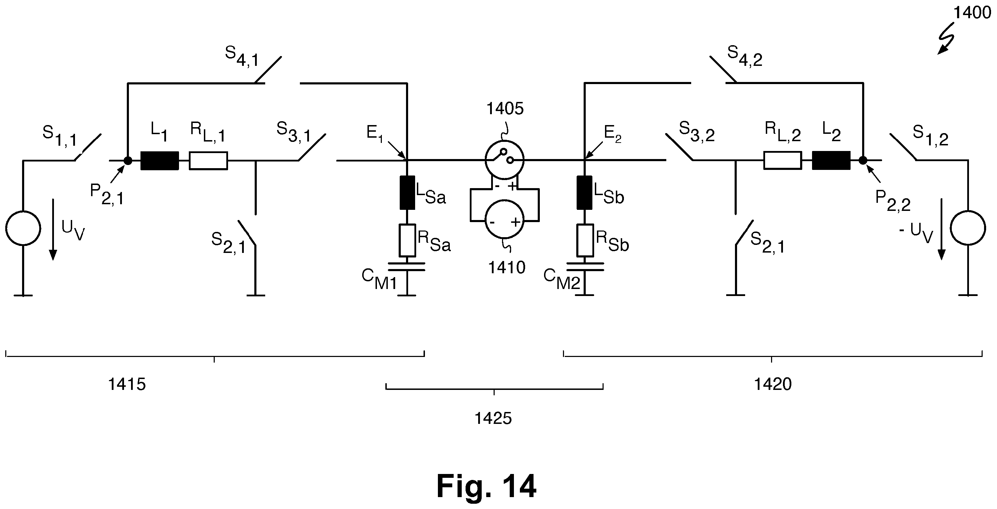

**Fig. 14** zeigt eine dritte beispielhafte Ausführungsform 1400 einer Schaltung, in der die Konzepte der ersten Schaltung und der zweiten Schaltung kombiniert sind, um eine Schaltung zur bipolaren und differentiellen Ansteuerung eines MEMS-Aktuators, insbesondere Mikroscanners, zu bilden.

Die Schaltung 1400 weist neben einem Schwingkreis 1425, der mittels einer Schalteinrichtung 1405 unterbrochen werden kann und somit pausierbar ist, zwei Hochsetzstellerschaltungen 1415 und 1420 auf, die hier beispielhaft jeweils dem Konzept der Schaltung aus Fig. 13 entsprechen und die dazu dienen, zwei verschiedenpolige, hochgesetzte Versorgungsspannungen $+U_V$ bzw. $-U_V$ für den pausierbaren Schwingkreis 1425, je eine an einem zugeordneten Einspeisungspunkt $E_1$ bzw. $E_2$ (hier jeweils gleichbedeutend mit einem jeweiligen Ladeanschluss A), bereitzustellen.

Das Nachladen der MEMS-Kapazitäten $C_{M1}$ bzw. $C_{M2}$ erfolgt wiederum vorzugsweise dann, wenn sie ihren jeweils zur zugeordneten Versorgungsspannung gleichpoligen, absolut betrachtet maximalen Spannungswert im Rahmen der aktuellen Schwingungsperiode erreicht haben. Dabei ist der Schwingkreis mittels einer Schalteinrichtung 1415 mit zugeordneter Steuerspannungsquelle 1420 temporär unterbrochen (pausiert). Die erste MEMS-Kapazität $C_{M1}$ wird somit in einer ersten Polung (+) geladen während zugleich die zweite MEMS-Kapazität $C_{M2}$ in einer zur ersten Polung entgegengesetzten Polung (-) geladen wird. Die Funktionsweise der Schaltung ist hinsichtlich jeder einzelnen der Polungen identisch zu der aus Fig. 13, wobei hier bei den Bezugszeichen ein weiterer Index 1 bzw. 2 eingeführt wird, um die Komponenten der beiden, insbesondere identisch ausführbaren, Hochsetzsteller 1415 und 1420 zu unterscheiden.

Die Ansteuerung der Schaltung 1400 ist so ausgebildet, dass während die Hochsetzsteller 1415 und 1420 arbeiten, die Schalteinrichtung 1405 geöffnet ist, sodass beide Hochsetzsteller 1415 und 1420, jeweils jeder für sich, separat arbeiten können, um insgesamt die MEMS-Kapazitäten $C_{M1}$ und $C_{M2}$ auf zueinander entgegengesetzte Spannungsniveaus aufzuladen. Wird danach im Anschluss der Schwingkreis aktiviert, werden beide Hochsetzsteller 1415 und 1420 in den "Idle"-Zustand versetzt, sodass sie die Funktion des dann schwingenden Schwingkreises 1425 nicht beeinträchtigen.

Die Schwingkreisinduktivität $L_S$ kann hierbei gemäß einer ersten Variante auf nur einer Seite der Schalteinrichtung 1405 vorgesehen sein (asymmetrischer Fall) und ist somit entweder durch $L_{Sa}$ oder $L_{Sb}$ gegeben, während die jeweils andere Induktivität $L_{Sb}$ bzw $L_{Sa}$ entfällt. Gemäß einer zweiten Variante weist die Schwingkreisinduktivität $L_S$ jedoch zugleich die beiden Induktivitäten $L_{Sa}$ und $L_{Sb}$ als Teilinduktivitäten auf (symmetrischer Fall). $L_{Sa}$ und $L_{Sb}$ können insbesondere eine gleich hohe Induktivität aufweisen und daher insbesondere baugleich sein.

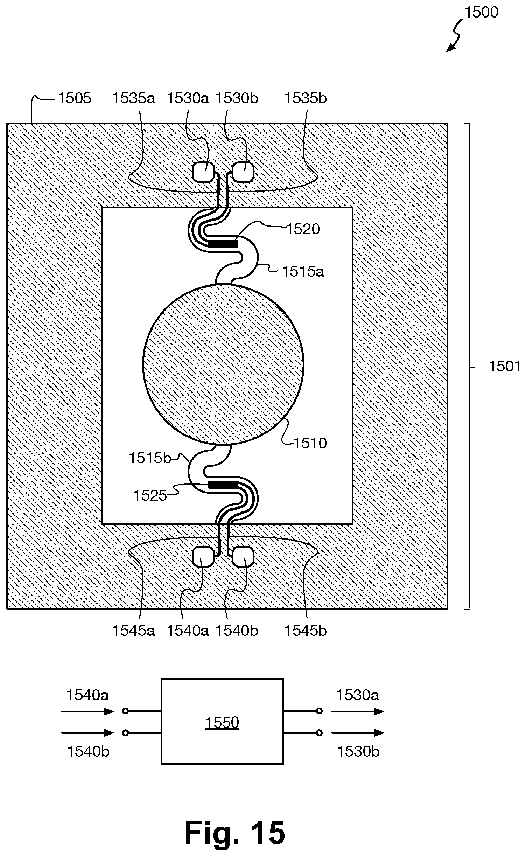

In Fig. 15 ist schematisch ein MEMS 1500 dargestellt, das ein Mikroscannersystem mit einem Mikroscanner 1501 aufweist. Der Mikroscanner 1501 weist der eine aus einem Halbleitersubstrat gefertigte Tragestruktur 1505 in Form eines Rahmens auf (Chiprahmen), der ein Ablenkelement (Spiegel) 1510 allseitig umgibt, dessen Basis aus demselben Halbleitersubstrat gefertigt ist wie die Tragestruktur 1505. Das Ablenkelement 1510 ist mittels einer oder mehrerer Federelemente, im vorliegenden Beispiel sind dies die beiden an gegenüberliegenden Seiten des Ablenkelements 1510 ansetzenden Federelemente 1515a und 1515b, an der Tragestruktur 1505 aufgehängt. Diese Aufhängung ist so ausgebildet, dass das Ablenkelement 1055 zumindest um eine Schwingungsachse rotatorisch oszillieren kann. Diese Schwingungsachse verläuft dabei entlang der (im Bild der Fig. 15 vertikal verlaufenden) Gerade durch die beiden Ansatzpunkte der Federelemente 1515a und 1515b am Ablenkelement 1510. Bei geeigneter Anregung ist es auch möglich, eine Schwingung um eine zweite, zur ersten Schwingungsachse orthogonale, im Bild der Fig. 15 also horizontale, Schwingungsachse anzuregen. Insbesondere zur Förderung einer solchen zweidimensionalen Oszillation können anstelle der hier dargestellten Aufhängung mit zwei gegenüberliegenden meanderförmigen Federelementen auch andersartig geformte und angeordnete Federelemente vorgesehen sein, insbesondere mehrere spiralförmige.

Auf jedem der Federelemente 1515a und 1515b befindet sich ein Piezoelement 1520 bzw. 1525, wobei sich diese Piezoelemente bezüglich ihres Piezomaterials und ihrer Aufgaben unterscheiden.

Das erste Piezoelement 1520 dient als Piezoaktuator zum Antrieb der Oszillationsbewegung des Ablenkelements 1510 und ist daher auf Basis eines ersten Piezomaterials, wie etwa PZT, als Dielektrikum ausgebildet, welches einen besonders starken Piezoeffekt aufweist. Die durch das Piezomaterial voneinander separierten Elektroden des Piezoelements 1520 bilden zugleich die Elektroden seiner MEMS-Kapazität $C_M$. Das erste Piezoelement 1520 ist somit bei geeigneter Wahl der Federstärken der Federelemente 1515a und 1515b geeignet, insbesondere auch große Auslenkungen und somit Scanwinkel des Mikroscanners 100, insbesondere bis hin zu $\pm$ 90° (optischer Scanwinkel) oder sogar mehr, zu ermöglichen.

Das zweite Piezoelement 1525 dient dagegen als Piezosensor zur Messung und somit Bestimmung der zeitabhängigen Lage, d. h. konkret der Orientierung bzw. Phasenlage der Oszillation, des Ablenkelements 1510.

In Fig. 15 sind zudem für beide Piezoelemente 1520 und 1525 die entsprechenden Anschlussleitungen 1535a,b bzw. 1545a,b sowie daran gekoppelte Anschlusspads (Bondpads) 1530a,b bzw. 1540a,b zur Herstellung einer jeweiligen elektrischen Verbindung mit einer externen Antriebs- bzw. Messelektronik, z.B. via Drahtbonds, eingezeichnet. Es ist auch denkbar, dass neben den beiden dargestellten weitere Piezoelemente als Piezoaktuatoren oder Piezosensoren vorgesehen sind.

Als Basis dient ein SOI (Silicon-on-Insulator) Substrat. Auf diesem Substrat wird ein $SiO_2$ oder eine anderweitige elektrische Passivierung erzeugt, auf welcher die piezoelektrischen Schichtstapel aufgebracht werden. Die piezoelektrischen Schichtstapel bestehen dabei aus einer Bodenelektrode, meist Metall, dem piezoelektrischen Material, und einer Topelektrode, meist Metall. Zusätzlich kommt eine weitere elektrische Passivierung zum Einsatz zwischen Top- und Bodenelektrode zum Einsatz, um ein elektrisches Kurzschließen zu verhindern.

Zur Ansteuerung des ersten Piezoelements 1520 (und optional zur Verarbeitung von Messignalen des zweite Piezoelements 1525) weist das MEMS 1500 zusätzlich eine Schaltung 1550 gemäß einem der vorgenannten schaltungsbezogenen Aspekte der vorliegenden Lösung, z.B. gemäß einer der Figuren 8 oder 10 bis 14. Je nach verwendeter Schaltung können die Piezoelemente nicht- differenziell oder differenziell ausgeführt sein.

BEZUGSZEICHENLISTE

| | |
|---|---|
| 100 | herkömmliche geregelte Hochsetzsteller-Schaltung |
| 200 | erste (unipolare) Ausführungsform einer lösungsgemäßen Schaltung |
| 205 | Vergleich der Schaltungen 100 und 200 |
| 300 | zeitlicher Verlauf des Stroms durch die Induktivität L während der ersten Schaltungskonfiguration |
| 400 | Ausführungsform einer Steuerungseinrichtung Ctrl |
| 405 | Verzögerungskette |
| 405-x | Verzögerungsglieder der Verzögerungskette 405 |
| 410 | Multiplexer |
| 415 | RS-Flip-Flop |
| 500 | zweite (bipolare) Ausführungsform einer lösungsgemäßen Schaltung |
| 600 | zeitlicher Verlauf der Konfiguration der Schalteinrichtung der Schaltung 500 |
| 700 | herkömmliche Halbbrücken-Schaltung |
| 705, 710 | Versorgungsspannungsquellen |
| 715, 725 | Schalteinrichtungen |
| 720, 730 | Steuerspannungsquellen |
| 800 | erste beispielhafte Ausführungsform der zweiten Schaltung |
| 805 | Versorgungsspannungsquelle |
| 815, 825 | Schalteinrichtungen |
| 820, 830 | Steuerspannungsquellen |
| 835 | Nachlade-Stromkreis |
| 840 | Umlade-Stromkreis, Schwingkreis |
| 900 | Strom- und Spannungsverläufe an der MEMS-Kapazität der Schaltung 800 |
| 1000 | zweite beispielhafte Ausführungsform der zweiten Schaltung |
| 1005 | Versorgungsspannungsquelle |
| 1015, 1025 | Schalteinrichtungen |
| 1020, 1030 | Steuerspannungsquellen |
| 1035 | weitere Schalteinrichtung |
| 1040 | Steuerspannungsquelle für Schalteinrichtung 1035 |

| 1045 | erste Masse |
|---|---|
| 1050 | zweite Masse |
| 1100 | dritte beispielhafte Ausführungsform der zweiten Schaltung |
| 1105 | Versorgungsspannungsquelle |
| 1115, 1125 | Schalteinrichtungen |
| 1120, 1130 | Steuerspannungsquellen |
| 1200 | erste beispielhafte Ausführungsform einer kombinierten Schaltung |
| 1300 | zweite beispielhafte Ausführungsform einer kombinierten Schaltung |
| 1400 | dritte beispielhafte Ausführungsform einer kombinierten Schaltung |
| 1405 | Schalteinrichtung |
| 1410 | Steuerspannungsquelle für Schalteinrichtung 1405 |
| 1415 | erster Hochsetzsteller |
| 1420 | zweiter Hochsetzsteller |
| 1425 | Schwingkreis |
| 1500 | MEMS |
| 1501 | Mikroscanner(system) |
| 1505 | Tragestruktur (Chiprahmen) |
| 1510 | Ablenkelement (Spiegel) |
| 1515a | erstes Federelement |
| 1515b | zweites Federelement |
| 1520 | erstes Piezoelement, Piezoaktuator |
| 1525 | zweites Piezoelement, Piezosensor |
| 15530a, b | Anschlusspads für das erste Piezoelement |
| 135a, b | Anschlussleitungen für das erste Piezoelement |
| 1540a, b | Anschlusspads für das zweite Piezoelement |
| 1545a, b | Anschlussleitungen für das zweite Piezoelement |
| 1550 | Schaltung |
| | |
| A | Ladeanschluss(punkt) |
| C | Pufferkapazität in herkömmlicher Schaltung |
| $C_B$ | Pufferkondensator für Versorgungsspannungsquelle |
| $C_M$ | MEMS-Kapazität |
| $C_{M1}$, $C_{M2}$ | separate MEMS-Kapazitäten |
| Clk | Taktsignal (Clock) |
| Ctrl | Steuerung bzw. Steuerungseinrichtung |
| D | Diode |
| $E_1$, $E_2$ | Einspeisungspunkte für elektrische Energie |
| I | Ladestrom |
| $I_0$ | Grenzstrom |
| $I_1$ | Umladestrom |
| $I_2$ | Nachladestrom |
| L | (zweite) Induktivität, insbesondere Booster-Induktivität |
| $L_S$ | Schwingkreisinduktivität, zweite Kopplungsinduktivität |
| $L_{S2}$ | Positionierung der Schwingkreisinduktivität im Falle der Fig. 9B |
| $L_{Sa}$ | Schwingkreisinduktivität oder erste Schwingkreisteilinduktivität in Fig. 14 |
| $L_{Sb}$ | Schwingkreisinduktivität oder zweite Schwingkreisteilinduktivität in Fig. 14 |
| $L_V$ | erste Kopplungsinduktivität |
| OP | Operationsverstärker |
| P | Periode bzw. Periodendauer |
| $P_1$ | erster Pol der Induktivität L |
| $P_2$ | zweiter Pol der Induktivität L |
| Q | Ausgangssignal von Ctrl |
| R, S | Eingänge des RS-Flip-Flops 415 |
| Reg | Regler |
| $R_1$, $R_2$ | Ohm'sche Widerstände, die Spannungsteiler bilden |
| $R_1$, $R_{L1}$, $R_{L2}$ | Ohm'scher Widerstand der zugeordneten Induktivität L, $L_1$ bzw. $L_2$ |
| $R_S$, $R_V$ | Ohm'sche Widerstände der Kopplungsinduktivitäten, insbesondere Ohm'scher Widerstand im Schwingkreis gemäß Ersatzschaltbild |

| $R_{Sa}$ | Ohm'scher Widerstand oder erster Teilwiderstand im Schwingkreis gemäß Ersatzschaltbild in Fig. 14 |
|---|---|
| $R_{Sb}$ | Ohm'scher Widerstand oder zweiter Teilwiderstand im Schwingkreis gemäß Ersatzschaltbild in Fig. 14 |

| $S_1$- $S_7$ | Schalteinrichtungen, insbesondere Schalttransistoren |
|---|---|
| SEL | Auswahlsignal |
| T | Transistor |
| t | Zeitvariable |
| $t_0,...,t_6$ | Zeitintervalle |
| $U_1$ | Spannung über Pufferkapazität C |
| $U_2$ | Spannung über Pufferkapazität C |
| $U_A$ | Spannung über Pufferkapazität C |
| $U_M$ | Spannung über MEMS-Kapazität |
| $U_V$ | Versorgungsspannung bzw. Versorgungsspannungsquelle |
| $V_{ref}$ | Referenzspannung |
| +V, -V | alternierende Spannungspegel von $U_M$ |

**Patentansprüche**

1. Schaltung (800; 1000; 1100; 1200; 1300; 1400) zur Ansteuerung eines Aktuators (1520) zum Antrieb einer Schwingungsbewegung eines Massenelements in einem MEMS, wobei die Schaltung (800; 1000; 1100; 1200; 1300; 1400) aufweist:

   einen elektrischen Schwingkreis (840; 1425), der aufweist:

   eine erste Induktivität (Ls),
   eine erste elektrische MEMS-Kapazität (CM);
   einen Ladeanschluss (A) zur temporären Zufuhr von elektrischer Energie von einer schwingkreisexternen Energieversorgung (805; 1005; 1105) in den Schwingkreis, um die MEMS-Kapazität (CM; CM1) temporär nachzuladen;
   eine ansteuerbare erste Schalteinrichtung (825) zum selektiven Unterbrechen bzw. Schließen des Schwingkreises (840; 1425) in Abhängigkeit von einer Ansteuerung der ersten Schalteinrichtung (825); und
   eine auf einen dauerhaft geschlossenen Zustand des Schwingkreises (840; 1425) bezogene Resonanzfrequenz; und

   eine Steuerung zur Ansteuerung der ersten Schalteinrichtung (825);
   wobei die erste Induktivität (Ls) derart im Schwingkreis (840; 1425) angeordnet ist, dass sie sowohl beim Umladen der ersten MEMS-Kapazität (CM; CM1) während eines elektrischen Schwingens des Schwingkreises (840; 1425) im geschlossenen Zustand der ersten Schalteinrichtung (825) als auch beim temporären Nachladen der ersten MEMS-Kapazität (CM; CM1) im unterbrochenen Zustand der ersten Schalteinrichtung (825) in einem dabei jeweils stromdurchflossenen und durch die erste MEMS-Kapazität (CM; CM1) verlaufenden Strompfads des Schwingkreises (840; 1425) liegt; und
   wobei die Steuerung konfiguriert ist, die erste Schalteinrichtung (825) während einer im geschlossenen Zustand der ersten Schalteinrichtung (825) ablaufenden jeweiligen Schwingungsperiode des Schwingkreises (840; 1425) durch eine entsprechende Ansteuerung temporär zu einem Zeitpunkt, an dem die Spannung über der ersten MEMS-Kapazität (CM; CM1) betragsmäßig ein Maximum innerhalb der jeweiligen Schwingungsperiode erreicht, in einen Zustand zu versetzen, in dem sie den Schwingkreis (840; 1425) unterbricht, sodass eine tatsächliche Schwingungsfrequenz des Schwingkreises (840; 1425) bewirkt wird, die kleiner ist als die Resonanzfrequenz.

2. Schaltung (800; 1000; 1100; 1200; 1300; 1400) nach Anspruch 1, wobei:

   die erste MEMS-Kapazität (CM; CM1) derart als Bestandteil des Aktuators (1520) ausgebildet ist, dass sie einen Bestandteil eines elektro-mechanischen Wandlers des Aktuators (1520) bildet; und
   der Wandler konfiguriert ist, in der ersten MEMS-Kapazität (CM; CM1) gespeicherte elektrische Energie in zumindest eine mechanische Größe zum Antrieb einer Bewegung des Aktuators (1520) zu wandeln.

3. Schaltung (800; 1000; 1100; 1200; 1300; 1400) nach einem der vorausgehenden Ansprüche, wobei die Steuerung konfiguriert ist, in einer jeweiligen Schwingungsperiode des Schwingkreises (840; 1425) die erste Schalteinrichtung (825) in einen Zustand zu versetzen, in dem sie den Schwingkreis (840; 1425) unterbricht, wenn die Spannung über der ersten MEMS-Kapazität (CM; CM1) innerhalb der Schwingungsperiode nach einer während der Schwingungsperiode erfolgenden Umladung der ersten MEMS-Kapazität (CM; CM1) betragsmäßig ein Maximum erreicht.

4. Schaltung (800; 1000; 1100; 1200; 1300; 1400) nach einem der vorausgehenden Ansprüche, wobei:

der Schwingkreis (840; 1425) zusätzlich zur ersten MEMS-Kapazität (CM; CM1) eine von der ersten MEMS-Kapazität (CM; CM1) separat ausgebildete zweite MEMS-Kapazität (CM2) aufweist; die erste und die zweite MEMS-Kapazität (CM; CM1) in dem Schwingkreis (840; 1425) so verschaltet sind, dass ein erster Pol der ersten MEMS-Kapazität (CM; CM1) mit einem ersten Pol der zweiten MEMS-Kapazität (CM2) über zumindest einen Schalter der ersten Schalteinrichtung (825) und die erste Induktivität (Ls) elektrisch verbunden ist und die jeweiligen zweiten Pole der beiden MEMS-Kapazitäten so miteinander elektrisch verbunden sind, dass sie bei Betrieb des Schwingkreises (840; 1425) auf einem selben elektrischen Potenzial gehalten werden.

5. Schaltung (800; 1000; 1100; 1200; 1300; 1400) nach einem der vorausgehenden Ansprüche, des Weiteren aufweisend eine Energieversorgungsschaltung zur temporären Zufuhr von elektrischer Energie in den Schwingkreis (840; 1425) über den Ladeanschluss (A).

6. Schaltung (800; 1000; 1100; 1200; 1300; 1400) nach Anspruch 5, wobei die Energieversorgungsschaltung eine zweite Schalteinrichtung (815) aufweist, die konfiguriert ist, in Abhängigkeit von einer Ansteuerung einen Einspeisungspunkt für elektrische Energie temporär mit dem Ladeanschluss (A) des Schwingkreises (840; 1425) zu verbinden, um den Schwingkreis (840; 1425) mit am Einspeisungspunkt zugeführter bzw. zuführbarer elektrischer Energie zu versorgen.

7. Schaltung (800; 1000; 1100; 1200; 1300; 1400) nach Anspruch 6, wobei die Schaltung (800; 1000; 1100; 1200; 1300; 1400) konfiguriert ist, in einer jeweiligen Schwingungsperiode des Schwingkreises (840; 1425) die zweite Schalteinrichtung (815):

dann temporär zu schließen, wenn die Spannung über der ersten MEMS-Kapazität (CM; CM1) betragsmäßig ein Maximum innerhalb der Schwingungsperiode erreicht und die gleiche Polung wie eine von der Energieversorgungsschaltung am Einspeisungspunkt zur Verfügung gestellte Spannung aufweist; und/oder zu öffnen, sobald während des temporären Nachladens der ersten MEMS-Kapazität (CM; CM1) im geschlossenen Zustand der zweiten Schalteinrichtung der Stromfluss durch die erste Induktivität (Ls) auf einen bestimmten Wert abgefallen ist, der höchstens 10% seines zuvor während des Nachladens erreichten Maximalwerts entspricht.

8. Schaltung (800; 1000; 1100; 1200; 1300; 1400) nach Anspruch 6 oder 7, wobei die Schaltung (800; 1000; 1100; 1200; 1300; 1400) konfiguriert ist, in der jeweiligen Schwingungsperiode mittels der zweiten Schalteinrichtung den Einspeisungspunkt temporär mit dem Ladeanschluss (A) des Schwingkreises (840; 1425) zu einem Zeitpunkt zu verbinden, vor dem in der Schwingungsperiode bereits zwei aufeinanderfolgende Umladevorgänge der ersten MEMS-Kapazität (CM; CM1) des Schwingkreises (840; 1425) erfolgt sind seit zuletzt mittels der zweiten Schalteinrichtung der Einspeisungspunkt temporär mit dem Schwingkreis (840; 1425) verbunden wurde.

9. Schaltung (800; 1000; 1100; 1200; 1300; 1400) nach einem der Ansprüche 5 bis 8, wobei die Schaltung (800; 1000; 1100; 1200; 1300; 1400) dahingehend konfigurierbar ist, dass die Menge der dem Schwingkreis (840; 1425) in zumindest einer Schwingungsperiode über den Ladeanschluss (A) von der Energieversorgungsschaltung zugeführten elektrische Energie einstellbar ist.

10. Schaltung (800; 1000; 1100; 1200; 1300; 1400) nach Anspruch 9, wobei die Schaltung (800; 1000; 1100; 1200; 1300; 1400) dahingehend konfigurierbar ist, dass die Menge der dem Schwingkreis (840; 1425) über den Ladeanschluss (A) von der Energieversorgungsschaltung zugeführten elektrischen Energie für jede Schwingungsperiode individuell oder global für alle m-ten Schwingungsperioden gleich einstellbar ist, wobei m > 0 eine natürliche Zahl ist.

11. Schaltung (800; 1000; 1100; 1200; 1300; 1400) nach einem der Ansprüche 5 bis 10, wobei die Energieversorgungsschaltung eine induktive Kopplungseinrichtung (LV, LS) zur temporären induktiven Einspeisung von elektrischer Energie in den Schwingkreis (840; 1425) aufweist.

**12.** Schaltung (800; 1000; 1100; 1200; 1300; 1400) nach einem der Ansprüche 5 bis 11, des Weiteren aufweisend einen Aufwärtswandler, der konfiguriert ist, eine am Einspeisungspunkt angelegte Eingangsspannung in eine demgegenüber betragsmäßig höhere Ausgangsspannung zu wandeln, um den Schwingkreis (840; 1425) anhand dieser Ausgangsspannung mit elektrischer Energie zu versorgen, wenn die zweite Schalteinrichtung (815) sich in einem Zustand befindet, in dem sie den Einspeisungspunkt temporär mit dem Schwingkreis (840; 1425) elektrisch verbindet.

**13.** Schaltung (800; 1000; 1100; 1200; 1300; 1400) nach Anspruch 12, wobei:

der Aufwärtswandler eine Hochsetzstellerschaltung mit einer zweiten Induktivität (L) und einer mittels der Steuerung ansteuerbaren dritten Schalteinrichtung (T) und einer dritten MEMS-Kapazität, die zumindest anteilig durch die erste und oder die zweite MEMS-Kapazität (CM; CM1; CM2) gebildet ist, aufweist;
wobei die dritte Schalteinrichtung (T) eingerichtet ist, in Abhängigkeit von der Steuerung eine erste Schaltungskonfiguration und sequenziell nachfolgend eine zweite Schaltungskonfiguration einzunehmen, sodass

in der ersten Schaltungskonfiguration ein erster Strompfad durch die zweite Induktivität (L) freigeschaltet ist, um einen von einer Versorgungsspannung (UV) gespeisten ansteigenden Stromfluss durch die zweite Induktivität (L) zu bewirken, und
in der zweiten Schaltungskonfiguration ein kapazitiv-ungepufferter zweiter Strompfad zwischen einem ersten Pol der zweiten Induktivität (L) und der dritten MEMS-Kapazität freigeschaltet ist, um die dritte MEMS-Kapazität mittels eines zumindest anteilig durch die zweite Induktivität (L) gespeisten Stromflusses auf eine erste Spannung aufzuladen, die betragsweise gleich oder höher ist als die Versorgungsspannung (UV).

**14.** MEMS (1500), aufweisend:

ein schwingungsfähig konfiguriertes Massenelement (1510);
einen Aktuator (1520) zum Antrieb einer Schwingungsbewegung des Massenelements; und
eine Schaltung (800; 1000; 1100; 1200; 1300; 1400) nach einem der vorausgehenden Ansprüche zur Ansteuerung des Aktuators (1520) derart, dass dieser dadurch veranlasst wird, das schwingungsfähige Massenelement (1510) in einer Schwingungsbewegung zu bewegen;
wobei die MEMS-Kapazität (CM) der Schaltung (800; 1000; 1100; 1200; 1300; 1400) derart als Bestandteil des Aktuators (1520) ausgebildet ist, dass sie selbst einen Bestandteil eines elektro-mechanischen Wandlers des Aktuators (1520) bildet, und der Wandler konfiguriert ist, in der MEMS-Kapazität (CM) gespeicherte elektrische Energie in zumindest eine mechanische Größe zum Antrieb einer Bewegung des Aktuators (1520) zu wandeln, um damit die Schwingungsbewegung des Massenelements (1510) anzutreiben.

**15.** MEMS (1500) nach Anspruch 14, wobei das MEMS (1500) ein Mikroscannersystem (1501) aufweist; und das Massenelement (1510) als schwingungsfähig konfiguriertes Ablenkelement des Mikroscannersystems (1501) zum Ablenken von auf das Ablenkelement einfallender elektromagnetischer Strahlung ausgebildet ist.

**Claims**

**1.** Circuit (800; 1000; 1100; 1200; 1300; 1400) for driving an actuator (1520) for driving an oscillatory motion of a mass element in a MEMS, the circuit (800; 1000; 1100; 1200; 1300; 1400) comprising:

an electrical resonant circuit (840; 1425) comprising:

a first inductance (Ls),
a first electrical MEMS capacitance (CM);
a charging connection (A) for temporarily supplying electrical energy from a resonant circuit-external energy supply (805; 1005; 1105) into the resonant circuit in order to temporarily recharge the MEMS capacitance (CM; CM1);
a drivable first switching device (825) for selectively interrupting or closing the resonant circuit (840; 1425) depending on a driving of the first switching device (825); and
a resonance frequency related to a permanently closed state of the resonant circuit (840; 1425); and

a controller for driving the first switching device (825);

wherein the first inductance (Ls) is arranged in the resonant circuit (840; 1425) in such a way that it is located both when the first MEMS capacitance (CM; CM1) is recharged during an electrical oscillation of the resonant circuit (840; 1425) in the closed state of the first switching device (825) and when the first MEMS capacitance (CM; CM1) is temporarily recharged in the interrupted state of the first switching device (825) in a current path of the resonant circuit (840; 1425) through which current flows in each case and which runs through the first MEMS capacitance (CM; CM1); and

wherein the controller is configured to temporarily set the first switching device (825), during a respective oscillation period of the resonant circuit (840; 1425) which runs in the closed state of the first switching device (825), by means of a corresponding driving at a point in time at which the voltage across the first MEMS capacitance (CM; CM1) reaches a maximum in terms of absolute value within the respective oscillation period, into a state in which it interrupts the resonant circuit (840; 1425), such that an actual oscillation frequency of the resonant circuit (840; 1425) is brought about which is lower than the resonance frequency.

2. Circuit (800; 1000; 1100; 1200; 1300; 1400) according to claim 1, wherein:

the first MEMS capacitance (CM; CM1) is formed as a constituent part of the actuator (1520) in such a way that it forms a constituent part of an electromechanical transducer of the actuator (1520); and
the transducer is configured to convert electrical energy stored in the first MEMS capacitance (CM; CM1) into at least one mechanical variable for driving a motion of the actuator (1520).

3. Circuit (800; 1000; 1100; 1200; 1300; 1400) according to either of the preceding claims, wherein the controller is configured to set the first switching device (825), in a respective oscillation period of the resonant circuit (840; 1425), into a state in which it interrupts the resonant circuit (840; 1425) when the voltage across the first MEMS capacitance (CM; CM1) reaches a maximum in terms of absolute value within the oscillation period after a recharging of the first MEMS capacitance (CM; CM1) which takes place during the oscillation period.

4. Circuit (800; 1000; 1100; 1200; 1300; 1400) according to one of the preceding claims, wherein:

the resonant circuit (840; 1425) comprises, in addition to the first MEMS capacitance (CM; CM1), a second MEMS capacitance (CM2) formed separately from the first MEMS capacitance (CM; CM1);
the first and the second MEMS capacitance (CM; CM1) are interconnected in the resonant circuit (840; 1425) in such a way that a first pole of the first MEMS capacitance (CM; CM1) is electrically connected to a first pole of the second MEMS capacitance (CM2) via at least one switch of the first switching device (825) and the first inductance (Ls), and the respective second poles of the two MEMS capacitances are electrically connected to one another in such a way that they are kept at the same electrical potential during operation of the resonant circuit (840; 1425).

5. Circuit (800; 1000; 1100; 1200; 1300; 1400) according to one of the preceding claims, furthermore comprising an energy supply circuit for temporarily supplying electrical energy into the resonant circuit (840; 1425) via the charging connection (A).

6. Circuit (800; 1000; 1100; 1200; 1300; 1400) according to claim 5, wherein the energy supply circuit comprises a second switching device (815) which is configured to temporarily connect a feed-in point for electrical energy to the charging connection (A) of the resonant circuit (840; 1425) depending on a driving in order to supply the resonant circuit (840; 1425) with electrical energy which is supplied or can be supplied at the feed-in point.

7. Circuit (800; 1000; 1100; 1200; 1300; 1400) according to claim 6, wherein the circuit (800; 1000; 1100; 1200; 1300; 1400) is configured, in a respective oscillation period of the resonant circuit (840; 1425), to:

temporarily close the second switching device (815) when the voltage across the first MEMS capacitance (CM; CM1) reaches a maximum in terms of absolute value within the oscillation period and has the same polarity as a voltage provided by the energy supply circuit at the feed-in point; and/or
open the second switching device (815) as soon as, during the temporary recharging of the first MEMS capacitance (CM; CM1) in the closed state of the second switching device, the current flow through the first inductance (Ls) has dropped to a specific value which corresponds to at most 10% of its maximum value previously reached during the recharging.

8. Circuit (800; 1000; 1100; 1200; 1300; 1400) according to claim 6 or 7, wherein the circuit (800; 1000; 1100; 1200; 1300; 1400) is configured, in the respective oscillation period, to temporarily connect the feed-in point to the charging connection (A) of the resonant circuit (840; 1425) by means of the second switching device at a point in time before which, in the oscillation period, two successive recharging processes of the first MEMS capacitance (CM; CM1) of the resonant circuit (840; 1425) have already taken place since the feed-in point was most recently temporarily connected to the resonant circuit (840; 1425) by means of the second switching device.

9. Circuit (800; 1000; 1100; 1200; 1300; 1400) according to one of claims 5 to 8, wherein the circuit (800; 1000; 1100; 1200; 1300; 1400) can be configured to the effect that the amount of electrical energy supplied to the resonant circuit (840; 1425) in at least one oscillation period can be set by the energy supply circuit via the charging connection (A).

10. Circuit (800; 1000; 1100; 1200; 1300; 1400) according to claim 9, wherein the circuit (800; 1000; 1100; 1200; 1300; 1400) can be configured to the effect that the amount of electrical energy supplied to the resonant circuit (840; 1425) via the charging connection (A) by the energy supply circuit can be set equally for each oscillation period individually or globally for all $m$-th oscillation periods, wherein $m > 0$ is a natural number.

11. Circuit (800; 1000; 1100; 1200; 1300; 1400) according to one of claims 5 to 10, wherein the energy supply circuit comprises an inductive coupling device (LV, LS) for temporarily inductively feeding electrical energy into the resonant circuit (840; 1425).

12. Circuit (800; 1000; 1100; 1200; 1300; 1400) according to one of claims 5 to 11, furthermore comprising a step-up converter which is configured to convert an input voltage applied at the feed-in point into an output voltage which is higher in terms of magnitude in relation thereto in order to supply the resonant circuit (840; 1425) with electrical energy on the basis of this output voltage when the second switching device (815) is in a state in which it temporarily electrically connects the feed-in point to the resonant circuit (840; 1425).

13. Circuit (800; 1000; 1100; 1200; 1300; 1400) according to claim 12, wherein:

   the step-up converter comprises a step-up converter circuit with a second inductance (L) and a third switching device (T) which can be driven by means of the controller, and a third MEMS capacitance which is formed at least in part by the first and/or the second MEMS capacitance (CM; CM1; CM2);
   wherein the third switching device (T) is set up to assume a first circuit configuration depending on the controller and to sequentially subsequently assume a second circuit configuration, such that

   in the first circuit configuration, a first current path through the second inductance (L) is enabled in order to bring about an increasing current flow through the second inductance (L) which is fed by a supply voltage (UV), and
   in the second circuit configuration, a capacitively unbuffered second current path between a first pole of the second inductance (L) and the third MEMS capacitance is enabled in order to charge the third MEMS capacitance by means of a current flow which is fed at least in part by the second inductance (L) to a first voltage which is equal in absolute value to or higher than the supply voltage (UV).

14. MEMS (1500), comprising:

   a mass element (1510) which is configured to be capable of oscillation;
   an actuator (1520) for driving an oscillatory motion of the mass element; and
   a circuit (800; 1000; 1100; 1200; 1300; 1400) according to one of the preceding claims for driving the actuator (1520) in such a way that it is thereby caused to move the mass element (1510) capable of oscillation in an oscillatory motion;
   wherein the MEMS capacitance (CM) of the circuit (800; 1000; 1100; 1200; 1300; 1400) is formed as a constituent part of the actuator (1520) in such a way that it itself forms a constituent part of an electromechanical transducer of the actuator (1520), and the transducer is configured to convert electrical energy stored in the MEMS capacitance (CM) into at least one mechanical variable for driving a motion of the actuator (1520) in order to thereby drive the oscillatory motion of the mass element (1510).

15. MEMS (1500) according to Claim 14, wherein the MEMS (1500) comprises a microscanner system (1501); and the mass element (1510) is formed as a deflection element, which is configured to be capable of oscillation, of the microscanner system (1501) for deflecting electromagnetic radiation incident on the deflection element.

**Revendications**

1. Circuit (800 ; 1000 ; 1100 ; 1200 ; 1300 ; 1400) pour commander un actionneur (1520) pour entraîner un mouvement de vibration d'un élément de masse dans un MEMS, le circuit (800 ; 1000 ; 1100 ; 1200 ; 1300 ; 1400) comprenant :

   un circuit oscillant électrique (840 ; 1425) comprenant :

      une première inductance (Ls),
      une première capacité MEMS électrique (CM) ;
      une borne de charge (A) pour fournir temporairement de l'énergie électrique à partir d'une alimentation en énergie externe au circuit oscillant (805 ; 1005 ; 1105) dans le circuit oscillant pour recharger temporairement la capacité MEMS (CM ; CM1) ;
      un premier dispositif de commutation commandable (825) pour interrompre ou fermer sélectivement le circuit oscillant (840 ; 1425) en fonction d'une commande du premier dispositif de commutation (825) ; et
      une fréquence de résonance liée à un état fermé en permanence du circuit oscillant (840 ; 1425) ; et

   une commande pour commander le premier dispositif de commutation (825) ;
   dans lequel la première inductance (Ls) est disposée dans le circuit oscillant (840 ; 1425) de telle sorte qu'elle se trouve à la fois lors de la recharge de la première capacité MEMS (CM ; CM1) pendant une oscillation électrique du circuit oscillant (840 ; 1425) dans l'état fermé du premier dispositif de commutation (825) et lors de la recharge temporaire de la première capacité MEMS (CM ; CM1) dans l'état interrompu du premier dispositif de commutation (825) dans un trajet de courant du circuit oscillant (840 ; 1425) traversé par le courant et s'étendant à travers la première capacité MEMS (CM ; CM1) ; et
   dans lequel la commande est configurée pour amener temporairement le premier dispositif de commutation (825) pendant une période d'oscillation respective du circuit oscillant (840 ; 1425) se déroulant dans l'état fermé du premier dispositif de commutation (825) par une commande correspondante à un moment auquel la tension aux bornes de la première capacité MEMS (CM ; CM1) atteint en valeur absolue un maximum dans la période d'oscillation respective, dans un état dans lequel il interrompt le circuit oscillant (840 ; 1425) de sorte qu'une fréquence d'oscillation réelle du circuit oscillant (840 ; 1425) est provoquée, qui est inférieure à la fréquence de résonance.

2. Circuit (800 ; 1000 ; 1100 ; 1200 ; 1300 ; 1400) selon la revendication 1, dans lequel :

   la première capacité MEMS (CM ; CM1) est réalisée en tant que partie constitutive de l'actionneur (1520) de telle sorte qu'elle forme une partie constitutive d'un convertisseur électromécanique de l'actionneur (1520) ; et
   le convertisseur est configuré pour convertir l'énergie électrique accumulée dans la première capacité MEMS (CM ; CM1) en au moins une grandeur mécanique pour entraîner un mouvement de l'actionneur (1520).

3. Circuit (800 ; 1000 ; 1100 ; 1200 ; 1300 ; 1400) selon l'une quelconque des revendications précédentes, dans lequel la commande est configurée pour amener le premier dispositif de commutation (825) dans une période d'oscillation respective du circuit oscillant (840 ; 1425) dans un état dans lequel il interrompt le circuit oscillant (840 ; 1425) lorsque la tension aux bornes de la première capacité MEMS (CM ; CM1) atteint en valeur absolue un maximum dans la période d'oscillation après une recharge de la première capacité MEMS (CM ; CM1) se produisant pendant la période d'oscillation.

4. Circuit (800 ; 1000 ; 1100 ; 1200 ; 1300 ; 1400) selon l'une quelconque des revendications précédentes, dans lequel :

   le circuit oscillant (840 ; 1425) comprend, en plus de la première capacité MEMS (CM ; CM1), une deuxième capacité MEMS (CM2) réalisée séparément de la première capacité MEMS (CM ; CM1) ;
   la première et la deuxième capacité MEMS (CM ; CM1) sont connectées dans le circuit oscillant (840 ; 1425) de telle sorte qu'un premier pôle de la première capacité MEMS (CM ; CM1) est connecté électriquement à un premier pôle de la deuxième capacité MEMS (CM2) par le biais d'au moins un commutateur du premier dispositif de commutation (825) et de la première inductance (Ls) et les deuxièmes pôles respectifs des deux capacités MEMS sont connectés électriquement l'un à l'autre de telle sorte qu'ils sont maintenus à un même potentiel électrique lors du fonctionnement du circuit oscillant (840 ; 1425).

5. Circuit (800 ; 1000 ; 1100 ; 1200 ; 1300 ; 1400) selon l'une quelconque des revendications précédentes, comprenant en outre un circuit d'alimentation en énergie pour fournir temporairement de l'énergie électrique dans le circuit oscillant (840 ; 1425) par le biais de la borne de charge (A).

6. Circuit (800 ; 1000 ; 1100 ; 1200 ; 1300 ; 1400) selon la revendication 5, dans lequel le circuit d'alimentation en énergie comprend un deuxième dispositif de commutation (815) qui est configuré pour connecter temporairement, en fonction d'une commande, un point d'injection d'énergie électrique à la borne de charge (A) du circuit oscillant (840 ; 1425) pour alimenter le circuit oscillant (840 ; 1425) en énergie électrique fournie ou pouvant être fournie au point d'injection.

7. Circuit (800 ; 1000 ; 1100 ; 1200 ; 1300 ; 1400) selon la revendication 6, dans lequel le circuit (800 ; 1000 ; 1100 ; 1200 ; 1300 ; 1400) est configuré pour, dans une période d'oscillation respective du circuit oscillant (840 ; 1425), fermer le deuxième dispositif de commutation (815) :

lorsque la tension aux bornes de la première capacité MEMS (CM ; CM1) atteint en valeur absolue un maximum dans la période d'oscillation et présente la même polarité qu'une tension fournie par le circuit d'alimentation en énergie au point d'injection ; et/ou

dès que, pendant la recharge temporaire de la première capacité MEMS (CM ; CM1), dans l'état fermé du deuxième dispositif de commutation, le flux de courant à travers la première inductance (Ls) a chuté à une valeur déterminée qui correspond au maximum à 10 % de sa valeur maximale atteinte précédemment pendant la recharge.

8. Circuit (800 ; 1000 ; 1100 ; 1200 ; 1300 ; 1400) selon la revendication 6 ou 7, dans lequel le circuit (800 ; 1000 ; 1100 ; 1200 ; 1300 ; 1400) est configuré pour, dans la période d'oscillation respective, connecter temporairement, au moyen du deuxième dispositif de commutation, le point d'injection à la borne de charge (A) du circuit oscillant (840 ; 1425) à un moment avant que, dans la période d'oscillation, deux processus de recharge successifs de la première capacité MEMS (CM ; CM1) du circuit oscillant (840 ; 1425) ne se soient déjà produits depuis que, en dernier lieu, le point d'injection a été connecté temporairement au circuit oscillant (840 ; 1425) au moyen du deuxième dispositif de commutation.

9. Circuit (800 ; 1000 ; 1100 ; 1200 ; 1300 ; 1400) selon l'une quelconque des revendications 5 à 8, dans lequel le circuit (800 ; 1000 ; 1100 ; 1200 ; 1300 ; 1400) peut être configuré de telle sorte que la quantité d'énergie électrique fournie au circuit oscillant (840 ; 1425) dans au moins une période d'oscillation par le biais de la borne de charge (A) par le circuit d'alimentation en énergie puisse être ajustée.

10. Circuit (800 ; 1000 ; 1100 ; 1200 ; 1300 ; 1400) selon la revendication 9, dans lequel le circuit (800 ; 1000 ; 1100 ; 1200 ; 1300 ; 1400) peut être configuré de telle sorte que la quantité d'énergie électrique fournie au circuit oscillant (840 ; 1425) par le biais de la borne de charge (A) par le circuit d'alimentation en énergie puisse être ajustée de manière identique pour chaque période d'oscillation individuellement ou globalement pour toutes les m-ièmes périodes d'oscillation, où m > 0 est un nombre naturel.

11. Circuit (800 ; 1000 ; 1100 ; 1200 ; 1300 ; 1400) selon l'une quelconque des revendications 5 à 10, dans lequel le circuit d'alimentation en énergie comprend un dispositif de couplage inductif (LV, LS) pour l'injection inductive temporaire d'énergie électrique dans le circuit oscillant (840 ; 1425).

12. Circuit (800 ; 1000 ; 1100 ; 1200 ; 1300 ; 1400) selon l'une quelconque des revendications 5 à 11, comprenant en outre un convertisseur élévateur qui est configuré pour convertir une tension d'entrée appliquée au point d'injection en une tension de sortie plus élevée en valeur par rapport à celle-ci pour alimenter le circuit oscillant (840 ; 1425) en énergie électrique sur la base de cette tension de sortie lorsque le deuxième dispositif de commutation (815) se trouve dans un état dans lequel il connecte temporairement électriquement le point d'injection au circuit oscillant (840 ; 1425).

13. Circuit (800 ; 1000 ; 1100 ; 1200 ; 1300 ; 1400) selon la revendication 12, dans lequel :

le convertisseur élévateur comprend un circuit convertisseur élévateur avec une deuxième inductance (L) et un troisième dispositif de commutation (T) pouvant être commandé au moyen de la commande et une troisième capacité MEMS qui est formée au moins en partie par la première et/ou la deuxième capacité MEMS (CM ; CM1 ; CM2) ;

dans lequel le troisième dispositif de commutation (T) est conçu pour adopter, en fonction de la commande, une première configuration de circuit et ensuite séquentiellement une deuxième configuration de circuit de sorte que

dans la première configuration de circuit, un premier trajet de courant à travers la deuxième inductance (L) est libéré pour provoquer un flux de courant croissant alimenté par une tension d'alimentation (UV) à travers la deuxième inductance (L), et

dans la deuxième configuration de circuit, un deuxième trajet de courant non tamponné capacitivement entre un premier pôle de la deuxième inductance (L) et la troisième capacité MEMS est libéré pour charger la troisième capacité MEMS au moyen d'un flux de courant alimenté au moins en partie par la deuxième inductance (L) à une première tension qui est en valeur égale ou supérieure à la tension d'alimentation (UV).

14. MEMS (1500), comprenant :

un élément de masse (1510) configuré de manière à pouvoir osciller ;
un actionneur (1520) pour entraîner un mouvement de vibration de l'élément de masse ; et
un circuit (800 ; 1000 ; 1100 ; 1200 ; 1300 ; 1400) selon l'une quelconque des revendications précédentes pour commander l'actionneur (1520) de telle sorte qu'il soit ainsi amené à déplacer l'élément de masse (1510) pouvant osciller dans un mouvement de vibration ;
dans lequel la capacité MEMS (CM) du circuit (800 ; 1000 ; 1100 ; 1200 ; 1300 ; 1400) est réalisée en tant que partie constitutive de l'actionneur (1520) de telle sorte qu'elle forme elle-même une partie constitutive d'un convertisseur électromécanique de l'actionneur (1520), et le convertisseur est configuré pour convertir l'énergie électrique accumulée dans la capacité MEMS (CM) en au moins une grandeur mécanique pour entraîner un mouvement de l'actionneur (1520) afin d'entraîner ainsi le mouvement de vibration de l'élément de masse (1510).

15. MEMS (1500) selon la revendication 14, dans lequel le MEMS (1500) comprend un système de micro-balayage (1501) ; et
l'élément de masse (1510) est réalisé en tant qu'élément de déviation configuré de manière à pouvoir osciller du système de micro-balayage (1501) pour dévier un rayonnement électromagnétique incident sur l'élément de déviation.

(Stand der Technik)

# Fig. 1

# Fig. 2A

**Fig. 2B**

**Fig. 3**

400

Q

415

S        R

8/ SEL

410

1    2    3        254    255

Clk

8ns    8ns    8ns    • • •    8ns    8ns

405-1  405-2  405-3        405-254  405-255

405

# Fig. 4

500

S₄

S₁

L    R_L    S₃

P₂    P₁

U_V

C_B    S₅    S₂    C_M    U_M

# Fig. 5

**Fig. 6**

(Stand der Technik)

# Fig. 7

# Fig. 8

**Fig. 9**

Fig. 9A

**Fig. 9B**

**Fig. 10**

**Fig. 11**

**Fig. 12**

Fig. 13

**Fig. 14**

EP 4 585 556 B1

Fig. 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2514211 B1
- FR 2829314 A1
- US 20050029905 A
- WO 03038918 A2
- DE 19854789 A1
- DE 10102286 A1
- DE 102013208870 A1
- US 20210099105 A1

**In der Beschreibung aufgeführte Nicht-Patentliteratur**

- Resonant drive: sense and high voltage electrostatic drive using single mems capacitor and low voltage electronics. **CAGDASER B et al.** IEEE INTERNATIONAL CONFERENCE ON MICRO ELECTRO MECHANICAL SYSTEMS. IEEE, 30 January 2005, 142-146